(19) Europäisches Patentamt / European Patent Office / Office européen des brevets

(11) **EP 4 787 618 A1**

(12) # EUROPEAN PATENT APPLICATION
published in accordance with Art. 153(4) EPC

(43) Date of publication:
**05.08.2026 Bulletin 2026/32**

(21) Application number: **24910864.8**

(22) Date of filing: **18.12.2024**

(51) International Patent Classification (IPC):
*H01Q 1/24* (2006.01)

(52) Cooperative Patent Classification (CPC):
**H01Q 1/24; H01Q 1/27; H01Q 1/50; H04M 1/02; H05K 5/02**

(86) International application number:
**PCT/CN2024/140186**

(87) International publication number:
**WO 2025/139933 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.12.2023 CN 202311868099**
**18.11.2024 CN 202411648910**

(71) Applicant: HUAWEI TECHNOLOGIES CO., LTD.
**Shenzhen, Guangdong 518129 (CN)**

(72) Inventors:
• **TANG, Rundong**
**Shenzhen, Guangdong 518129 (CN)**

• **SUN, Libin**
**Shenzhen, Guangdong 518129 (CN)**
• **WANG, Jikang**
**Shenzhen, Guangdong 518129 (CN)**
• **XUE, Liang**
**Shenzhen, Guangdong 518129 (CN)**
• **WANG, Hanyang**
**Shenzhen, Guangdong 518129 (CN)**
• **CHEN, Wenjun**
**Shenzhen, Guangdong 518129 (CN)**

(74) Representative: **Maiwald GmbH**
**Engineering**
**Elisenhof**
**Elisenstrasse 3**
**80335 München (DE)**

(54) **FOLDABLE ELECTRONIC DEVICE**

(57) This application provides a foldable electronic device. The foldable electronic device includes an antenna. An operating frequency band of the antenna includes a satellite communication frequency band. The antenna includes a radiator and a parasitic stub. Parts of a conductive side frame of a housing are used as the radiator and the parasitic stub. When the foldable electronic device is in an unfolded state, the radiator and the parasitic stub may generate radiation beams facing two sides of the top of the foldable electronic device, so that the antenna has a wide beam characteristic. When the foldable electronic device is in the unfolded state, a user does not need to change a posture of holding the foldable electronic device during satellite communication, so that user experience during satellite communication can be improved.

FIG. 9

## Description

This application claims priorities to Chinese Patent Application No. 202311868099.2, filed with the China National Intellectual Property Administration on December 29, 2023 and entitled "FOLDABLE ELECTRONIC DEVICE", and to Chinese Patent Application No. 202411648910.0, filed with the China National Intellectual Property Administration on November 18, 2024 and entitled "FOLDABLE ELECTRONIC DEVICE", both of which are incorporated herein by reference in their entireties.

## TECHNICAL FIELD

This application relates to the field of wireless communication, and in particular, to a foldable electronic device.

## BACKGROUND

Currently, a side frame is used as an antenna radiator in an existing terminal electronic device. For example, in a satellite communication system, a side frame radiator is mainly used to form a linearly polarized antenna. When performing satellite communication, a user needs to point an electronic device at the sky in a specific orientation, to complete a communication connection to a satellite.

However, for a foldable electronic device in an unfolded state, a radiation direction of an antenna may deflect. This increases difficulty in establishing a communication connection to the satellite, and greatly affects communication experience of the user.

## SUMMARY

This application provides a foldable electronic device. The foldable electronic device includes an antenna. Conductive parts of a side frame of the foldable electronic device are used as a main radiator and a parasitic stub of the antenna, so that user experience of satellite communication when the foldable electronic device is in an unfolded state can be improved.

According to a first aspect, a foldable electronic device is provided, including: a first housing and a ground, where the first housing includes a first side frame, the first side frame includes a first edge and a second edge that intersect at a corner, the first side frame includes a first position, a second position, a third position, and a fourth position that are sequentially provided, the first position and the second position are located on the first edge, the third position and the fourth position are located on the second edge, the first side frame respectively has a first insulation gap, a second insulation gap, and a third insulation gap at the first position, the second position, and the fourth position, and the first side frame is coupled to the ground at the third position; a second housing and a first hinge, where the first hinge is located between the first housing and the second housing, and the first hinge is rotatably connected to the first housing and the second housing; and a first antenna, where the first antenna includes: a first radiator and a first parasitic stub, where the first radiator is a conductive part of the first side frame between the first position and the second position, the first parasitic stub is a conductive part of the first side frame between the third position and the fourth position, at least a part of the first radiator is spaced from the ground, and at least a part of the first parasitic stub is spaced from the ground; and a first feed circuit and a first electronic element, where the first radiator includes a first feed point and a first connection point, the first feed circuit is coupled to the first feed point, the first electronic element is coupled between the ground and the first connection point, the first feed point and the first connection point are respectively located on two sides of a virtual axis of the first radiator, and first radiator has a same length on the two sides of the virtual axis, where the first radiator is configured to generate a first resonance based on the foldable electronic device being in an unfolded state, a resonance frequency band of the first resonance includes a satellite communication frequency band, and the first radiator, the first parasitic stub, and the first electronic element are configured to generate a radiation pattern of the antenna.

According to embodiments of this application, when the foldable electronic device is in the unfolded state, because the first parasitic stub is disposed on the second edge, a direction of radiation generated by the first parasitic stub deviates toward a left side of a first direction (a side that is of the first direction and that faces the first parasitic stub). The first electronic element may enhance the radiation generated by the first parasitic stub. The first direction is a direction pointing from the bottom of the foldable electronic device to the top of the foldable electronic device, for example, a z direction. When the foldable electronic device is in the unfolded state, because a direction of radiation generated by the first radiator deviates toward a right side of the first direction (a side that is of the first direction and that faces the hinge), the first radiator and the first parasitic stub may respectively generate strong radiation on two sides of the top (the first direction) of the foldable electronic device, so that the antenna can have a wide beam characteristic.

With reference to the first aspect, in some implementations of the first aspect, when the foldable electronic device is in the unfolded state, and the first antenna operates in the satellite communication frequency band, a current on the ground on a first side of the virtual axis is greater than a current on the ground on a second side of the virtual axis, where the first parasitic stub is located on the first side, and the first hinge is located on the second side.

According to embodiments of this application, there is a relatively strong current on the ground facing a side of the first parasitic stub, so that the first parasitic stub can be better excited to generate a first parasitic resonance, thereby improving a radiation characteristic of radiation generated by the first parasitic resonance, and enhancing a radiation characteristic of the antenna on the left side of the first direction (the side that is of the first direction and that faces the first parasitic stub).

With reference to the first aspect, in some implementations of the first aspect, a beam width of the first antenna is related to the first parasitic stub based on the foldable electronic device being in the unfolded state.

According to embodiments of this application, the first radiator and the first parasitic stub may respectively generate strong radiation beams on the two sides of the top (the first direction) of the foldable electronic device 100. When the two beams approach each other, the two beams may be combined into one radiation beam. Alternatively, when the two beams deviate toward the two sides of the first direction, bandwidth of the radiation beam may be increased.

With reference to the first aspect, in some implementations of the first aspect, the first electronic element has an open-circuit characteristic based on the first feed point being located on the first side of the virtual axis and the first connection point being located on the second side of the virtual axis; an equivalent inductance of the first electronic element is greater than or equal to 20 nH based on a resonance point frequency of the first resonance being greater than or equal to 3 GHz; an equivalent inductance of the first electronic element is greater than or equal to 10 nH based on a resonance point frequency of the first resonance being greater than or equal to 2 GHz and less than 3 GHz; or an equivalent inductance of the first electronic element is greater than or equal to 5 nH based on a resonance point frequency of the first resonance being greater than or equal to 1 GHz and less than 2 GHz.

With reference to the first aspect, in some implementations of the first aspect, the first electronic element has a short-circuit characteristic based on the first connection point being located on the first side of the virtual axis and the first feed point being located on the second side of the virtual axis; an equivalent capacitance of the first electronic element is greater than or equal to 0.5 pF based on a resonance point frequency of the first resonance being greater than or equal to 3 GHz; an equivalent capacitance of the first electronic element is greater than or equal to 2 pF based on a resonance point frequency of the first resonance being greater than or equal to 2 GHz and less than 3 GHz; or an equivalent capacitance of the first electronic element is greater than or equal to 3 pF based on a resonance point frequency of the first resonance being greater than or equal to 1 GHz and less than 2 GHz.

According to embodiments of this application, the first electronic element may be determined based on positions of the first feed point and the first connection point, so that there is a relatively strong current on the ground facing a side of the first parasitic stub, and the first parasitic stub can be better excited to generate a first parasitic resonance, thereby improving a radiation characteristic of radiation generated by the first parasitic resonance, and enhancing a radiation characteristic of the antenna on the left side of the first direction (the side that is of the first direction and that faces the first parasitic stub).

With reference to the first aspect, in some implementations of the first aspect, a distance between the first feed point and the first position or the second position is less than or equal to one third of a length of the first radiator; and/or a distance between the first connection point and the first position or the second position is less than or equal to one third of the length of the first radiator.

According to embodiments of this application, as the first feed point moves toward one end of the first radiator, miniaturization of the first radiator is facilitated.

With reference to the first aspect, in some implementations of the first aspect, the first radiator is configured to generate a main resonance, and the first parasitic stub is configured to generate a first parasitic resonance, where the first parasitic resonance is in a resonance frequency band of the main resonance, and the main resonance and the first parasitic resonance jointly form the first resonance.

According to embodiments of this application, as the first connection point moves toward one end of the first radiator, adjustment of current distribution on the ground is facilitated, and there may be a larger current adjustment range.

With reference to the first aspect, in some implementations of the first aspect, the antenna generates an efficiency dip at a first frequency point, where a frequency difference between the resonance point frequency of the first resonance and a frequency of the first frequency point is less than or equal to 50 MHz.

According to embodiments of this application, coupling between the first radiator and the first parasitic stub is relatively weak, and the first parasitic resonance cannot be well excited. Therefore, a dip corresponding to the first parasitic resonance cannot appear clearly in an S parameter diagram. Because the first parasitic resonance is partially excited by a current, a clear dip appears in an efficiency curve (for example, radiation efficiency or total efficiency). For example, if the efficiency dip appears at the first frequency point, the first frequency point may be considered as a resonance point corresponding to the first parasitic resonance. In an embodiment, a reduction of efficiency (for example, radiation efficiency or total efficiency) resulting from the dip does not exceed 1.5 dB. In an embodiment, a reduction of efficiency (for example, radiation efficiency or total efficiency) resulting from the dip does not exceed 1 dB.

With reference to the first aspect, in some implementations of the first aspect, a gain, of a radiation pattern generated by the first antenna, in a range in which an angle formed with a first direction is within 60° is greater than or equal to -6 dBic based on the foldable electronic device performing satellite communication through the first antenna, and the first direction is a direction pointing from the bottom of the foldable electronic device to the top of the foldable electronic device.

According to embodiments of this application, the antenna has a relatively large beam width, so that the foldable electronic device has a good communication characteristic in a range of a first angle (for example, 60°) from the first direction. For example, when a user performs satellite communication, the antenna has a wide beam characteristic, a radiation pattern generated by the antenna has a good characteristic within the first angle, a communication satellite may move within the first angle without affecting satellite communication quality, and the user does not need to frequently change a posture of holding the foldable electronic device, thereby effectively improving user experience.

With reference to the first aspect, in some implementations of the first aspect, the first antenna further includes a second parasitic stub, the second parasitic stub is a conductive part of the first side frame between the second position and the third position, and at least a part of the second parasitic stub is spaced from the ground.

According to embodiments of this application, when the foldable electronic device is in the unfolded state, the second parasitic stub may be configured to pull a current flowing to the first parasitic stub, to enhance a radiation characteristic of the first parasitic stub, and adjust strength of radiation generated by the first parasitic stub that deviates toward the left side of the first direction, so as to adjust a wide beam characteristic of the antenna.

With reference to the first aspect, in some implementations of the first aspect, a first end of the second parasitic stub and a first end of the first radiator are opposite to each other through the second insulation gap and are not in contact with each other; and the first antenna further includes a second electronic element, the first end of the second parasitic stub includes a second connection point, and the second electronic element is coupled between the ground and the second connection point.

According to embodiments of this application, the second electronic element may be configured to adjust a coupling amount between the second parasitic stub and the first radiator, and adjust a current flowing to the first parasitic stub, so as to adjust strength of radiation generated by the first parasitic stub that deviates toward the left side of the first direction (the side that is of the first direction and that faces the first parasitic stub).

With reference to the first aspect, in some implementations of the first aspect, the first side frame further includes a fifth position, the first position is located between the fifth position and the second position, and the first side frame is coupled to the ground at the fifth position; and the first antenna further includes a third parasitic stub, the third parasitic stub is a conductive part of the first side frame between the first position and the fifth position, at least a part of the third parasitic stub is spaced from the ground, the third parasitic stub is configured to generate a second parasitic resonance, and the first resonance and the second parasitic resonance jointly support the satellite communication frequency band.

According to embodiments of this application, the conductive part of the first side frame between the first position and the fifth position is used as the third parasitic stub. The third parasitic stub may be configured to generate the third parasitic resonance, to expand an operating frequency band of the antenna.

With reference to the first aspect, in some implementations of the first aspect, the second housing includes a second side frame, a third edge of the second side frame includes a sixth position and a seventh position, the second side frame is coupled to the ground at the sixth position, and the second side frame is provided with a fourth insulation gap at the seventh position; the first antenna further includes a fourth parasitic stub, the fourth parasitic stub is a conductive part of the second side frame between the sixth position and the seventh position, and at least a part of the fourth parasitic stub is spaced from the ground; and the first edge and the third edge are a top edge or a bottom edge of the foldable electronic device based on the foldable electronic device being in the unfolded state.

According to embodiments of this application, one end of the fourth parasitic stub is a grounding end, the other end is an open end, and a structure similar to an IFA may be formed. In an embodiment, the fourth parasitic stub may operate in a quarter wavelength mode.

With reference to the first aspect, in some implementations of the first aspect, the antenna further includes a second tuning circuit, and the first antenna further includes a third electronic element; and the fourth parasitic stub includes a third connection point and a fourth connection point, the fourth parasitic stub is provided with a fifth insulation gap between the third connection point and the fourth connection point, and the third electronic element is coupled between the third connection point and the fourth connection point.

According to embodiments of this application, the fourth parasitic stub is provided with the fifth insulation gap. The fifth insulation gap may be considered as an equivalent capacitor (for example, a distributed capacitor) disposed on the fourth parasitic stub. The equivalent capacitor may enable the fourth parasitic stub to form a metamaterial structure. A radiation aperture of the fourth parasitic stub having the metamaterial structure may be increased, and after the fifth insulation gap is provided, an electric field is more dispersive, and a dielectric loss near a conductor is reduced. Therefore, total efficiency and radiation efficiency of the antenna can be effectively improved. Through the second tuning circuit that is coupled between the third connection point and the fourth connection point, an equivalent capacitance of the fifth insulation gap can be adjusted, to adjust a radiation characteristic (for example, a resonance point frequency) of the antenna.

With reference to the first aspect, in some implementations of the first aspect, a distance between the third connection point and the fifth insulation gap is less than or equal to 5 mm; and/or a distance between the fourth connection point and the fifth insulation gap is less than or equal to 5 mm.

According to embodiments of this application, the distance between the third connection point and the fifth insulation gap and/or the distance between the fourth connection point and the fifth insulation gap may be understood as a minimum distance between the third connection point and conductors on two sides of the fifth insulation gap and/or a minimum distance between the fourth connection point and the conductors on the two sides of the fifth insulation gap (a length of the fourth parasitic stub between the third connection point and the fifth insulation gap and/or a length of the fourth parasitic stub between the fourth connection point and the fifth insulation gap). When the third electronic element is electrically connected to the third connection point and/or the fourth connection point through a connection member (for example, a metal spring), the distance to the fifth insulation gap may be understood as a minimum distance between a center of a part that is of the connection member and that is in contact with the connection point and the conductors on the two sides of the fifth insulation gap.

With reference to the first aspect, in some implementations of the first aspect, the second housing includes a second side frame, a third edge of the second side frame includes a sixth position and a seventh position, and the second side frame is provided with a fourth insulation gap and a fifth insulation gap at the sixth position and the seventh position; the first antenna further includes a fourth parasitic stub, the fourth parasitic stub is a conductive part of the second side frame between the sixth position and the seventh position, and at least a part of the fourth parasitic stub is spaced from the ground; and the first edge and the third edge are a top edge or a bottom edge of the foldable electronic device based on the foldable electronic device being in the unfolded state.

According to embodiments of this application, two ends of the fourth parasitic stub are open ends, and a structure similar to a dipole (dipole) antenna may be formed. In an embodiment, the fourth parasitic stub may operate in a half wavelength mode.

With reference to the first aspect, in some implementations of the first aspect, the sixth position is located between the first position and the seventh position based on the foldable electronic device being in the unfolded state.

According to embodiments of this application, the grounding end of the fourth parasitic stub is close to the hinge, to facilitate implementation in actual production.

With reference to the first aspect, in some implementations of the first aspect, the second housing includes a second side frame, the second side frame includes a third edge and a fourth edge that intersect at a corner, the second side frame includes a sixth position, a seventh position, an eighth position, and a ninth position that are sequentially provided, the sixth position and the seventh position are located on the third edge, the eighth position and the ninth position are located on the fourth edge, the second side frame respectively has a fourth insulation gap, a fifth insulation gap, and a sixth insulation gap at the sixth position, the seventh position, and the ninth position, and the second side frame is coupled to the ground at the eighth position; and the foldable electronic device may further include a second antenna, and the second antenna includes: a second radiator and a fifth parasitic stub, where the second radiator is a conductive part of the second side frame between the sixth position and the seventh position, the fifth parasitic stub is a conductive part of the second side frame between the eighth position and the ninth position, at least a part of the second radiator is spaced from the ground, and at least a part of the fifth parasitic stub is spaced from the ground; and a second feed circuit and a fourth electronic element, where the second radiator includes a second feed point and a fifth connection point, the second feed circuit is coupled to the second feed point, and the fourth electronic element is coupled between the ground and the fifth connection point, where the first edge and the third edge are a top edge or a bottom edge of the foldable electronic device based on the foldable electronic device being in the unfolded state; and the second radiator and the fourth parasitic stub are configured to generate a second resonance based on the foldable electronic device being in the unfolded state, and a resonance frequency band of the second resonance includes the satellite communication frequency band.

According to embodiments of this application, both the first antenna and the second antenna may operate in the satellite communication frequency band. According to the foregoing embodiments, both the first antenna and the second antenna have a wide beam characteristic, and therefore, radiation patterns generated by the first antenna and the second antenna may be superimposed, so that the foldable electronic device has better satellite communication performance.

With reference to the first aspect, in some implementations of the first aspect, based on the foldable electronic device being in a folded state, the first radiator and the second radiator at least partially overlap in a second direction, and/or the first parasitic stub and the fifth parasitic stub at least partially overlap in the second direction, where the second direction is a thickness direction of the foldable electronic device.

With reference to the first aspect, in some implementations of the first aspect, based on the foldable electronic device being in the folded state, the first insulation gap is aligned with the fourth insulation gap, and/or the second insulation gap is aligned with the fifth gap, and/or the third insulation gap is aligned with the sixth insulation gap.

According to embodiments of this application, overlapping of radiators/parasitic stubs and alignment of gaps can improve aesthetic appeal of the foldable electronic device.

With reference to the first aspect, in some implementations of the first aspect, a ratio of a dimension of the ground in an extension direction of the first edge when the foldable electronic device is in the unfolded state to a dimension of the ground in the extension direction of the first edge when the foldable electronic device is in the folded state is greater than or equal to 1.8 and less than or equal to 2.2.

With reference to the first aspect, in some implementations of the first aspect, the foldable electronic device performs at least one of the following services in the satellite communication frequency band: receiving and/or sending an SMS message through a satellite, making and/or answering a call through a satellite, or satellite data.

## BRIEF DESCRIPTION OF DRAWINGS

FIG. 1 is a diagram of a structure of a foldable electronic device 100 according to an embodiment of this application;

FIG. 2 is a diagram of a structure of a foldable electronic device 100 in an outward folded state;

FIG. 3 is a diagram of a structure of a foldable electronic device 100 in a possible unfolded state;

FIG. 4 is a diagram of a structure of a foldable electronic device 100 in a possible folded state;

FIG. 5 is a diagram of a structure of a foldable electronic device 100 in a possible partially unfolded state;

FIG. 6 is a diagram of a common-mode structure of an antenna and corresponding current and electric field distribution according to this application;

FIG. 7 is a diagram of a differential-mode structure of another antenna and corresponding current and electric field distribution according to this application;

FIG. 8 is a diagram of a maximum radiation direction of a radiation pattern generated by an antenna 200 in a foldable electronic device 100 according to an embodiment of this application;

FIG. 9 is a diagram of a foldable electronic device 100 according to an embodiment of this application;

FIG. 10 is a diagram of current distribution of an antenna 200 according to an embodiment of this application;

FIG. 11 is a diagram of a foldable electronic device 100 according to an embodiment of this application;

FIG. 12 shows a simulation result of an S parameter of the antenna 200 in the foldable electronic device 100 shown in FIG. 9;

FIG. 13 shows a simulation result of total efficiency of the antenna 200 in the foldable electronic device 100 shown in FIG. 9;

FIG. 14 is a radiation pattern of an antenna 200 when no first parasitic stub is disposed and a foldable electronic device 100 is in an unfolded state;

FIG. 15 is a radiation pattern of an antenna 200 when a first parasitic stub is disposed and a foldable electronic device 100 is in an unfolded state;

FIG. 16 is a diagram of a foldable electronic device 100 according to an embodiment of this application;

FIG. 17 is a radiation pattern of an antenna 200 in the foldable electronic device 100 shown in FIG. 16 at 2 GHz;

FIG. 18 is a diagram of a foldable electronic device 100 according to an embodiment of this application;

FIG. 19 shows a simulation result of an S parameter of an antenna 200 when the foldable electronic device 100 shown in FIG. 18 is in an unfolded state;

FIG. 20 is a radiation pattern of an antenna 200 in the foldable electronic device 100 shown in FIG. 18 at 2 GHz;

FIG. 21 is a radiation pattern of an antenna 200 in the foldable electronic device 100 shown in FIG. 18 at 2.1 GHz;

FIG. 22 is a radiation pattern of an antenna 200 in the foldable electronic device 100 shown in FIG. 18 at 2.2 GHz;

FIG. 23 is a diagram of a foldable electronic device 100 according to an embodiment of this application;

FIG. 24 is a radiation pattern of an antenna 200 in the foldable electronic device 100 shown in FIG. 23 at 2 GHz;

FIG. 25 is a diagram of a foldable electronic device 100 according to an embodiment of this application;

FIG. 26 is a radiation pattern of an antenna 200 in the foldable electronic device 100 shown in FIG. 25 at 2 GHz;

FIG. 27 is a diagram of a foldable electronic device 100 according to an embodiment of this application;

FIG. 28 is a diagram of a foldable electronic device 100 according to an embodiment of this application;

FIG. 29 is a diagram of an electronic device 100 according to an embodiment of this application;

FIG. 30 is a diagram of current distribution of an antenna 200 in the electronic device 100 shown in FIG. 29;

FIG. 31 is a diagram of current distribution of an antenna 200 in the electronic device 100 shown in FIG. 29;

FIG. 32 is a diagram of an electronic device 100 according to an embodiment of this application;

FIG. 33 is a diagram of an electronic device 100 according to an embodiment of this application;

FIG. 34 is a diagram of current distribution of an antenna 200 in the electronic device 100 shown in FIG. 32; and

FIG. 35 is a diagram of current distribution of an antenna 200 in the electronic device 100 shown in FIG. 32.

## DESCRIPTION OF EMBODIMENTS

The following describes terms that may appear in embodiments of this application.

It should be understood that the term "and/or" in this specification is merely a same field for describing associated objects and represents that three relationships may exist. For example, A and/or B may represent the following three cases: Only A exists, both A and B exist, and only B exists. In addition, the character "/" in this specification usually indicates an "or" relationship between the associated objects.

In this application, "in a range of..." includes end values at both ends of the range by default except that it is separately indicated that an end value is not included. For example, a range of 1 to 5 includes the two values 1 and 5.

Coupling: may be understood as direct coupling and/or indirect coupling. A "coupling connection" may be understood as a direct coupling connection and/or an indirect coupling connection. The direct coupling may also be referred to as an "electrical connection", which may be understood as physical contact and electrical conductivity of components; or may be understood as a form in which different components in a line structure are connected by using a physical line that can transmit an electrical signal, like printed circuit board (printed circuit board, PCB) copper foil or a conducting wire. The "indirect coupling" may be understood as electrical conductivity of two conductors through space or in a non-touch manner. In an embodiment, the indirect coupling may also be referred to as capacitive coupling. For example, signal transmission is implemented by forming an equivalent capacitor through coupling of a gap between two conductive components.

Element/Component: includes at least one of a lumped element/component and a distributed element/-component.

Lumped element/component: is a general term for all elements when a size of the element is far less than a wavelength corresponding to an operating frequency of a circuit. For signals, a characteristic of the element is always fixed at any moment, and is irrelevant to a frequency.

Distributed element/component: Different from the lumped element, if a size of an element is close to or greater than a wavelength corresponding to an operating frequency of a circuit, when a signal passes through the element, a characteristic of each point of the element varies with the signal. In this case, the element cannot be considered as a single entity with a fixed characteristic, but should be referred to as a distributed element.

Capacitor: may be understood as a lumped capacitor and/or a distributed capacitor. The lumped capacitor is a capacitive component, for example, a capacitive element, and the distributed capacitor (or distributed capacitor) is an equivalent capacitor formed due to a gap between two conductive components.

Inductor: may be understood as a lumped inductor and/or a distributed inductor. The lumped inductor is an inductive component, for example, an inductive element, and the distributed inductor (or distributed inductor) is an equivalent inductor formed by using a conductive component with a specific length.

Radiator: is an apparatus configured to receive/send electromagnetic wave radiation in an antenna. In some cases, an "antenna" is a radiator in a narrow sense. The radiator converts guided wave energy from a transmitter into a radio wave, or converts a radio wave into guided wave energy, to radiate and receive a radio wave. Modulated high-frequency current energy (or guided wave energy) generated by the transmitter is transmitted to a transmit radiator through a feeder. The radiator converts the energy into specific polarized electromagnetic wave energy and radiates the energy in a required direction. A receive radiator converts specific polarized electromagnetic wave energy from a specific direction in space into modulated high-frequency current energy, and transmits the energy to an input end of a receiver through the feeder.

The radiator may include a conductor having a specific shape and size, for example, a linear conductor or a sheet-like conductor. A specific shape is not limited in this application. In an embodiment, the linear radiator may be referred to as a wire antenna for short. In an embodiment, the linear radiator may be implemented by a conductive side frame, and may also be referred to as a side frame antenna. In an embodiment, the linear radiator may be implemented by a bracket conductor, and may also be referred to as a bracket antenna. In an embodiment, a diameter (for example, including a thickness and a width) of a linear radiator or a radiator of a wire antenna is far less than a wavelength (for example, a medium wavelength) (for example, less than 1/16 of the wavelength), and a length may be compared with the wavelength (for example, the medium wavelength) (for example, the length is near 1/8 of the wavelength, or 1/8 to 1/4, or 1/4 to 1/2, or longer). Main forms of the wire antenna include a dipole antenna, a half-wave dipole antenna, a monopole antenna, a loop antenna, and an inverted F antenna (also referred to as IFA, Inverted F Antenna). For example, for the dipole antenna, each dipole antenna usually includes two radiation branches, and each branch is fed by a feeding part from a feeding end of the radiation branch. For example, the inverted F antenna (Inverted-F Antenna, IFA) may be considered as being obtained by adding a grounding path to the monopole antenna. The IFA antenna has a feed point and a grounding point. Because a side view of the IFA antenna is an inverted F shaped, the IFA antenna is referred to as an inverted F antenna. In an embodiment, the sheet-like radiator may include a microstrip antenna, or a patch (patch) antenna, for example, a planar inverted F antenna (also referred to as PIFA, Planar Inverted F Antenna). In an embodiment, the sheet-like radiator may be implemented by a planar conductor (for example, a conductive sheet or a conductive coating). In an embodiment, the sheet-like radiator may include a conductive sheet, for example, a copper sheet. In an embodiment, the sheet-like radiator may include a conductive coating, for example, silver paste. A shape of the sheet-like radiator includes a circle, a rectangle, a ring, or the like. A specific shape is not limited in this application. A structure of the microstrip antenna usually includes a dielectric substrate, a radiator, and a ground, where the dielectric substrate is disposed between the radiator and the ground.

The radiator may include a slot or a slit formed on a conductor, for example, a closed or semi-closed slot or slit formed on a surface of a grounded conductor. In an embodiment, a radiator with a slot or a slit may be referred to as a slotted antenna or a slot antenna for short. In an embodiment, a radial size (for example, including a width) of the slot or slit of the slotted antenna/slot antenna is far less than a wavelength (for example, a medium wavelength) (for example, less than 1/16 of the wavelength), and a length may be compared with the wavelength (for example, the medium wavelength) (for example, the length is near 1/8 of the wavelength, or 1/8 to 1/4, or 1/4 to 1/2, or longer). In an embodiment, a radiator with a closed slot or slit may be referred to as a closed slot antenna for short. In an embodiment, a radiator with a semi-closed slot or slit (for example, an opening is provided on a closed slot or slit) may be referred to as an open slot antenna for short. In some embodiments, a shape of the slot is a long strip. In some embodiments, a length of the slot is about half a wavelength (for example, a medium wavelength). In some embodiments, a length of the slot is about an integer multiple of a wavelength (for example, one time a medium wavelength). In some embodiments, the slot may be fed by a transmission line that is connected to one side or two sides of the slot. In this way, a radio frequency electromagnetic field is excited on the slot, and an electromagnetic wave is radiated to space. In an embodiment, a radiator of the slotted antenna or the slot antenna may be implemented by a conductive side frame that is grounded at two ends, and may also be referred to as a side frame antenna. In this embodiment, it may be considered that the slotted antenna or the slot antenna includes a linear radiator, and the linear radiator is spaced from the ground and is grounded at two ends of the radiator, to form a closed or semi-closed slot or slit. In an embodiment, a radiator of the slotted antenna or the slot antenna may be implemented by a bracket conductor that is grounded at two ends, and may also be referred to as a bracket antenna.

A feed circuit is a combination of all circuits for receiving and transmitting radio frequency signals. The feed circuit may include a transceiver (transceiver) and a radio frequency front end (RF front end) circuit. In some cases, in a narrow sense, the "feed circuit" is a radio frequency integrated circuit (RFIC, Radio Frequency Integrated Circuit), and the RFIC may be considered as including a radio frequency front end chip and the transceiver. The feed circuit has a function of converting a radio wave (for example, a radio frequency signal) and an electrical signal (for example, a digital signal). Usually, the feed circuit is considered as a part of radio frequency.

In some embodiments, an electronic device may further include a test base (or referred to as a radio frequency base or a radio frequency test base). A coaxial cable may be inserted into the test base, to test a characteristic of the radio frequency front end circuit or a radiator of an antenna through the cable. The radio frequency front end circuit may be considered as a circuit part coupled between the test base and the transceiver.

In some embodiments, the radio frequency front end circuit may be integrated into the radio frequency front end chip in the electronic device, or the radio frequency front end circuit and the transceiver may be integrated into a radio frequency chip in the electronic device.

It should be understood that any two of a first feed circuit, a second feed circuit, ..., and an $N^{th}$ feed circuit in this application may share a same transceiver, for example, transmit a signal through one radio frequency channel in one transceiver (for example, a port (pin) of the radio frequency chip); and may further share one radio frequency front end circuit, for example, process the signal via a tuning circuit or an amplifier in one radio frequency front end.

It should be further understood that two of the first feed circuit, the second feed circuit, ..., and the $N^{th}$ feed circuit in this application usually correspond to two radio frequency test bases in the electronic device.

A matching circuit is a circuit for adjusting a radiation characteristic of the antenna. In an embodiment, the matching circuit is coupled between a feed circuit and a corresponding radiator. In an embodiment, the matching circuit is coupled between a test base and a radiator. Usually, the matching circuit is a combination of circuits coupled between the radiator and the ground. In an embodiment, the matching circuit may include a tuning circuit and/or an electronic element. The tuning circuit may be an electronic element configured to switch a coupling connection of the radiator. The matching circuit has a function of impedance matching and/or frequency tuning. Usually, the matching circuit is considered as a part of the antenna.

Grounding structure/Feed structure:   The grounding structure/feed structure may include a connection member, for example, a metal spring. The radiator is coupled to the ground through the grounding structure/coupled to the feed circuit through the feed structure. In some embodiments, the feed structure may include a transmission line/feeder, and the grounding structure may include a grounding line.

End/Point: "End/Point" in a first end/second end/feeding end/grounding end/feed point/grounding point/connection point of an antenna radiator cannot be understood in a narrow sense as an endpoint or an end part that is definitely physically disconnected from another radiator, but may be further considered as a point or a segment on a continuous radiator. In an embodiment, the "end/point" may include a connection/coupling area that is on an antenna radiator and that is coupled to another conductive structure. For example, a feeding end/feed point may be a coupling area that is on the antenna radiator and that is coupled to a feed structure or a feed circuit (for example, an area facing a part of the feed circuit). For another example, a grounding end/grounding point may be an open end or a closed end of a connection/coupling area that is on the antenna radiator and that is coupled to a grounding structure or a grounding circuit. In some embodiments, the open end and the closed end are, for example, defined relative to whether the end is grounded. The closed end is grounded, and the open end is not grounded. In some embodiments, the open end and the closed end are, for example, defined relative to another conductor. The closed end is electrically connected to the another conductor, and the open end is not electrically connected to the another conductor. In an embodiment, the open end may also be referred to as a floating end, a free end, an opening end, or an open-circuit end. In an embodiment, the closed end may also be referred to as a grounding end or a short-circuited end. It should be understood that, in some embodiments, the open end may be coupled to another conductor, to transfer coupling energy (which may be understood as transferring a current).

In some embodiments, the "closed end" may also be understood from a perspective of current distribution. The closed end, the grounding end, or the like may be understood as a current strong point on a radiator, or may be understood as an electric field weak point on a radiator. In an embodiment, the closed end is coupled to an electronic component (for example, a capacitor or an inductor), so that a current distribution characteristic of the current strong point/the electric field weak point on the radiator may not be changed. In an embodiment, a slit (for example, a slot filled with an insulation material) is provided at or near the closed end, so that a current distribution characteristic of the current strong point/the electric field weak point on the radiator may not be changed.

In some embodiments, the "open end" may also be understood from a perspective of current distribution. The open end, the floating end, or the like may be understood as a current weak point on a radiator, or may be understood as an electric field strong point on a radiator. In an embodiment, the open end is coupled to an electronic component (for example, a capacitor or an inductor), so that a current distribution characteristic of the current weak point/the electric field strong point on the radiator may not be changed.

It should be understood that a radiator end (similar to a radiator at an opening of the open end or the floating end from a perspective of a radiator structure) in a slot is coupled to an electronic component (for example, a capacitor or an inductor), so that the radiator end is a current strong point/an electric field weak point. In this case, it should be understood that the radiator end in the slot is actually a closed end, a grounding end, or the like.

A "floating radiator" in embodiments of this application means that the radiator is not directly connected to a feeder/feeding stub and/or a grounding line/grounding stub, but is fed and/or grounded in an indirect coupling manner.

It should be understood that "floating" in the "floating end" and the "floating radiator" does not mean that there is no structure around the radiator to support the radiator. In an embodiment, the floating radiator may be, for example, a radiator provided on an inner surface of an insulating rear cover.

That currents are in a same direction/in opposite directions in embodiments of this application should be understood as that directions of main currents on conductors on a same side are in a same direction/in opposite directions. For example, when co-directionally distributed currents are excited on a bent conductor or an annular conductor (for example, a current path is also bent or annular), it should be understood that, for example, although directions of main currents excited on conductors on two sides of the annular conductor (for example, on conductors on two sides of a slot surrounded by a conductor) are opposite, the main currents still fall within a definition of co-directionally distributed currents in embodiments of this application. In an embodiment, that currents on a conductor are in a same direction may mean that the currents on the conductor have no reverse point. In an embodiment, that currents on a conductor are in opposite directions may mean that the currents on the conductor have at least one reverse point. In an embodiment, that currents on two conductors are in a same direction may mean that none of the currents on the two conductors has a reverse point and the currents flow in the same direction. In an embodiment, that currents on two conductors are in opposite directions may mean that none of the currents on the two conductors has a reverse point and the currents flow in opposite directions. It may be correspondingly understood that currents on a plurality of conductors are in a same direction/in opposite directions.

Resonance/Resonance frequency: The resonance frequency is also referred to as a resonant frequency. The resonance frequency may have a frequency range, that is, a frequency range in which a resonance occurs. A frequency corresponding to a strongest resonance point is a frequency of a center frequency point. A return loss characteristic of the center frequency may be less than -20 dB. It should be understood that, unless otherwise specified, an antenna/a radiator generates a "first/second ... resonance" in this application, where the first resonance should be a fundamental-mode resonance generated by the antenna/radiator, or a lowest-frequency resonance generated by the antenna/radiator. It should be understood that the antenna/radiator may generate one or more antenna modes based on a specific design, and one fundamental mode resonance may be correspondingly generated in each antenna mode.

Resonance frequency band: A range of a resonance frequency is the resonance frequency band, and a return loss characteristic of any frequency in the resonance frequency band may be less than -6 dB or -5 dB.

Communication frequency band/Operating frequency band: Regardless of a type of an antenna, the antenna constantly operates in a specific frequency range (frequency bandwidth). For example, an operating frequency band of an antenna supporting a B40 frequency band includes a frequency in a range of 2300 MHz to 2400 MHz. In other words, the operating frequency band of the antenna includes the B40 frequency band. A frequency range that satisfies a requirement of an indicator may be considered as an operating frequency band of an antenna.

The resonance frequency band and the operating frequency band may be the same, or may partially overlap. In an embodiment, one or more resonance frequency bands of an antenna may cover one or more operating frequency bands of the antenna.

Electrical length: may be a ratio of a physical length (that is, a mechanical length or a geometric length) to a wavelength of a transmitted electromagnetic wave. The electrical length may satisfy the following formula:

$$\overline{L} = \frac{L}{\lambda}.$$

L is the physical length, and $\lambda$ is the wavelength of the electromagnetic wave.

Wavelength: or operating wavelength, may be a wavelength corresponding to a center frequency of a resonance frequency or a center frequency of an operating frequency band supported by an antenna. For example, it is assumed that a center frequency of a B1 uplink frequency band (with a resonance frequency ranging from 1920 MHz to 1980 MHz) is 1955 MHz, the operating wavelength may be a wavelength calculated by using the frequency of 1955 MHz. The "operating wavelength" is not limited to the center frequency, and may alternatively be a wavelength corresponding to a non-center frequency of the resonance frequency or the operating frequency band.

It should be understood that a wavelength of a radiation signal in the air may be calculated as follows: (air wavelength or vacuum wavelength)=speed of light/-frequency, where the frequency is a frequency (MHz) of the radiation signal, and the speed of light may be $3 \times 10^8$ m/s. A wavelength of a radiation signal in a medium may be calculated as follows: medium

$$\text{wavelength} = (\text{speed of light}/\sqrt{\varepsilon})/\text{frequency},$$

where ε is a relative dielectric constant of the medium. The wavelength in embodiments of this application is usually a medium wavelength, and may be a medium wavelength corresponding to a center frequency of a resonance frequency, or a medium wavelength corresponding to a center frequency of an operating frequency band supported by an antenna. For example, it is assumed that a center frequency of a B1 uplink band (with a resonance frequency ranging from 1920 MHz to 1980 MHz) is 1955 MHz, the wavelength may be a medium wavelength calculated by using the frequency of 1955 MHz. The "medium wavelength" is not limited to the center frequency, and may alternatively be a medium wavelength corresponding to a non-center frequency of the resonance frequency or the operating frequency band. For ease of understanding, the medium wavelength mentioned in embodiments of this application may be simply calculated by using a relative dielectric constant of a medium filled on one or more sides of a radiator.

Total efficiency (total efficiency) of an antenna: is a ratio of input power to output power at an antenna port.

Radiation efficiency (radiation efficiency) of an antenna: is a ratio of power radiated by the antenna to space (that is, power for effectively converting an electromagnetic wave) to active power input to the antenna. Active power input to the antenna = input power of the antenna - loss power. The loss power mainly includes return loss power and metal ohmic loss power and/or dielectric loss power. The radiation efficiency is a value for measuring a radiation capability of an antenna. The metal loss and dielectric loss are both factors that affect the radiation efficiency.

A person skilled in the art may understand that the efficiency is usually represented by a percentage, and there is a corresponding conversion relationship between the efficiency and dB. Efficiency closer to 0 dB indicates better antenna efficiency.

Antenna return loss: may be understood as a ratio of power of a signal reflected back to an antenna port through an antenna circuit to transmit power of the antenna port. A weaker reflected signal indicates a stronger signal radiated by the antenna to space and higher radiation efficiency of the antenna. A stronger reflected signal indicates a weaker signal radiated by the antenna to space and lower radiation efficiency of the antenna.

The antenna return loss may be represented by an S11 parameter, and S11 is one of S parameters. S11 indicates a reflection coefficient, and this parameter can represent transmit efficiency of the antenna. The S11 parameter is usually a negative number. A smaller value of the S11 parameter indicates a smaller return loss of the antenna and less energy reflected back by the antenna. In other words, more energy actually enters the antenna and total efficiency of the antenna is higher. A larger value of the S11 parameter indicates a larger return loss of the antenna and lower total efficiency of the antenna.

It should be noted that, -6 dB is usually used as a standard value of S11 in engineering. When the value of S11 of the antenna is less than -6 dB, it may be considered that the antenna can operate normally, or it may be considered that transmit efficiency of the antenna is good.

Antenna pattern: is also referred to as a radiation pattern, is a pattern in which relative field strength (a normalized modulus value) of a radiation field of an antenna changes with a direction at a specific distance from the antenna (a far field), and is usually represented by two planar patterns that are perpendicular to each other in a maximum radiation direction of the antenna.

The antenna pattern usually includes a plurality of radiation beams. A radiation beam with highest radiation strength is referred to as a main lobe, and another radiation beam is referred to as a minor lobe or side lobe. In minor lobes, a minor lobe in a direction opposite to that of the main lobe is also referred to as a back lobe.

Directivity (directivity): is also referred to as directionality of an antenna. The directivity is a ratio of maximum power density to an average value in an antenna pattern at a specific distance from the antenna (a far field), is a dimensionless ratio greater than or equal to 1, and may indicate an energy radiation characteristic of the antenna. Higher directivity indicates a larger proportion of energy radiated by the antenna in a direction, and more concentrated energy radiation.

Antenna gain: represents a degree to which an antenna intensively radiates input power. Usually, a narrower main lobe of an antenna pattern indicates a smaller minor lobe, and a higher antenna gain.

Polarization direction of an antenna: At a given point in space, electric field strength E (vector) is a function of time t. As time goes on, a vector endpoint periodically depicts a trajectory in space. That the trajectory is a straight line and perpendicular to the ground is referred to as vertical polarization. That the trajectory is horizontal to the ground is referred to as horizontal polarization. That the trajectory is an ellipse or a circle and rotates right-handed or clockwise with the time when viewed in a propagation direction is referred to as right-hand circular polarization (right-hand circular polarization, RHCP). That the trajectory is an ellipse or a circle and rotates left-handed or counter-clockwise with the time when viewed in a propagation direction is referred to as left-hand circular polarization (light-hand circular polarization, LHCP).

Ground (ground plate) (ground, GND): may generally mean at least a part of any ground plane, grounding plate, grounding metal layer, or the like in an electronic device (such as a mobile phone), or at least a part of any combination of the foregoing ground plane, grounding plate, grounding component, or the like. The "ground" may be used to ground a component in the electronic device. In an embodiment, the "ground" may be a ground plane of a circuit board of the electronic device, or may be a grounding plate formed by a middle frame of the electronic device or a grounding metal layer formed by a metal film below a screen. In an embodiment, the circuit board may be a printed circuit board (printed circuit board, PCB), for example, an 8-layer board, a 10-layer board, a 12-layer board, ..., or a 14-layer board having 8, 10, 12, 13, or 14 layers of conductive materials, or an element that is separated and electrically insulated by a dielectric layer or an insulation layer, for example, glass fiber or a polymer. In an embodiment, the circuit board includes a dielectric substrate, a ground plane, and a trace layer. The trace layer and the ground plane are electrically connected through a via. In an embodiment, components such as a display, a touchscreen, an input button, a transmitter, a processor, a memory, a battery, a charging circuit, and a system on chip (system on chip, SoC) structure may be mounted on or connected to the circuit board, or electrically connected to the trace layer and/or the ground plane in the circuit board. For example, a radio frequency source is disposed on the trace layer.

Any of the foregoing ground plane, grounding plate, or grounding metal layer is made of a conductive material. In an embodiment, the conductive material may be any one of the following materials: copper, aluminum, stainless steel, brass and alloys thereof, copper foil on insulation laminates, aluminum foil on insulation laminates, gold foil on insulation laminates, silver-plated copper, silver-plated copper foil on insulation laminates, silver foil on insulation laminates and tin-plated copper, cloth impregnated with graphite powder, graphite-coated laminates, copper-plated laminates, brass-plated laminates, and aluminum-plated laminates. A person skilled in the art may understand that the ground plane/grounding plate/grounding metal layer may be alternatively made of other conductive materials.

Grounding: means coupling with the ground/ground plate in any manner. In an embodiment, grounding may be grounding via an entity. For example, grounding via an entity (or referred to as entity grounding) at a specific position on a side frame is implemented through some mechanical parts of a middle frame. In an embodiment, grounding may be grounding via a component, for example, grounding via a component (or referred to as component grounding) like a capacitor/inductor/resistor connected in series or in parallel.

The following describes technical solutions in embodiments of this application with reference to accompanying drawings.

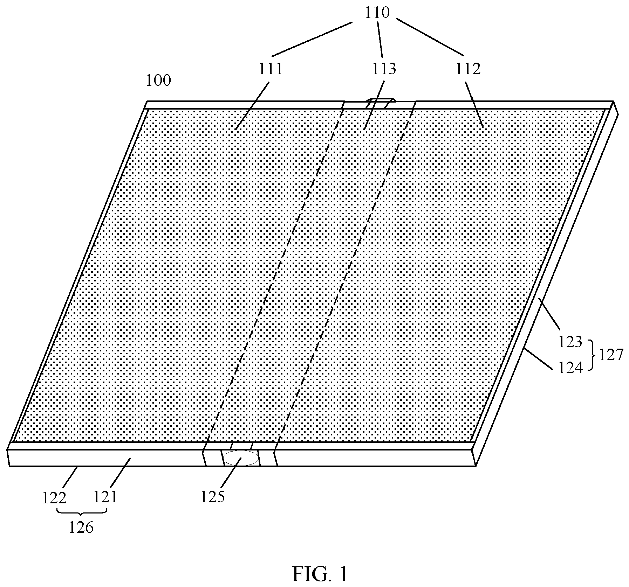

FIG. 1 is a diagram of a structure of a foldable electronic device 100 according to an embodiment of this application. The foldable electronic device 100 may be an electronic device with a folding function, for example, a mobile phone, a tablet computer, an electronic reader, a notebook computer, or a wearable device such as a watch. The embodiment shown in FIG. 1 is described by using a foldable mobile phone as an example.

Refer to FIG. 1. The foldable electronic device 100 may include a flexible display 110, a first side frame 121, a first cover body 122, a second side frame 123, a second cover body 124, and a hinge 125. In some embodiments, the first side frame 121, the first cover body 122, the second side frame 123, and the second cover body 124 may form a first housing 126 and a second housing 127 that support the flexible display 110. In some other embodiments, at least one of the first cover body 122 and the second cover body 124 may include a display.

A lattice-filled pattern in FIG. 1 may schematically represent the flexible display 110. The flexible display 110 may feature strong flexibility and bendability, and may provide a user with a new bendability-based interaction mode. For example, a display panel of the flexible display 110 may be any one of a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), or a quantum dot light-emitting diode (quantum dot light-emitting diode, QLED). This is not limited in embodiments of this application.

The flexible display 110 may include a first display part 111 corresponding to the first housing 126, a second display part 112 corresponding to the second housing 127, and a foldable display part 113 corresponding to the hinge 125. The foldable display part 113 may be connected between the first display part 111 and the second display part 112.

The first side frame 121 may surround a periphery of the first cover body 122, and at least a part of the first side frame 121 may further surround a periphery of the first display part 111. The first display part 111 and the first cover body 122 may be spaced apart in parallel, and the first display part 111 and the first cover body 122 may be located on two sides of the first side frame 121. Space between the first display part 111 and the first cover body 122 may be used to dispose a component of the foldable electronic device 100, such as an antenna or a circuit board component.

The second side frame 123 may surround a periphery of the second cover body 124, and at least a part of the second side frame 123 may further surround a periphery of the second display part 112. The second display part 112 and the second cover body 124 may be spaced apart in parallel, and the second display part 112 and the second cover body 124 may be located on two sides of the second side frame 123. Space between the second display part 112 and the second cover body 124 may be used to dispose a component of the foldable electronic device 100, such as an antenna or a circuit board component.

In an embodiment provided in this application, the cover body and the side frame may be two parts of the housing of the foldable electronic device 100. The cover body and the side frame may be connected, and a form of the connection may not belong to an assembly manner such as clamping, bonding, welding, riveting, or clearance fit. A connection relationship between the cover body and the side frame is usually difficult to split. In another embodiment provided in this application, the cover body and the side frame may be two different components. The housing of the foldable electronic device 100 may be formed by assembling the cover body and the side frame.

At least a part of the side frame may serve as a radiator of an antenna to transmit/receive a radio frequency signal, and there may be a gap between the part of the side frame that serves as the radiator and another part of the cover body, to ensure that the radiator of the antenna has a good radiation environment. In an embodiment, the cover body may be provided with a gap at the part of the side frame that serves as the radiator, to facilitate radiation of the antenna.

The antenna of the electronic device 100 may be alternatively provided in the side frame. When the side frame of the electronic device 100 is made of a non-conductive material, the radiator of the antenna may be located in the electronic device 100 and provided along the side frame. For example, the radiator of the antenna is attached to the side frame, to reduce a volume occupied by the radiator of the antenna as much as possible, and be closer to the outside of the electronic device 100, so as to achieve better signal transmission effect. It should be noted that, that the radiator of the antenna is attached to the side frame means that the radiator of the antenna may be tightly attached to the side frame, or may be provided close to the side frame. For example, there may be a specific small slot between the radiator of the antenna and the side frame.

The antenna of the electronic device 100 may be alternatively provided in the housing, for example, a bracket antenna or a millimeter wave antenna (not shown in FIG. 1). Clearance of the antenna provided in the housing may be obtained through a slit/hole in any one of the cover body, and/or the side frame, and/or the display, or through a non-conductive slot/aperture formed between any several of the cover body, and/or the side frame, and/or the display. Providing the clearance of the antenna can ensure radiation performance of the antenna. It should be understood that, the clearance of the antenna may be a non-conductive area including any conductive component in the electronic device 100, and the antenna radiates a signal to external space through the non-conductive area. In an embodiment, a form of the antenna may be an antenna form based on a flexible printed circuit (flexible printed circuit, FPC), an antenna form based on laser direct structuring (laser direct structuring, LDS), an antenna form based on a microstrip disk antenna (microstrip disk antenna, MDA), or the like. In an embodiment, the antenna may alternatively use a transparent structure embedded in the display of the electronic device 100, so that the antenna is a transparent antenna element embedded in the display of the electronic device 100.

The foldable electronic device 100 may further include a printed circuit board PCB (not shown in the figure). The PCB is disposed in a cavity formed by the cover body. The PCB may be a flame-resistant material (FR-4) dielectric board, or may be a Rogers (Rogers) dielectric board, or may be a hybrid dielectric board of Rogers and FR-4, or the like. Herein, FR-4 is a grade code name of a flame-resistant material, and the Rogers dielectric board is a high frequency board. An electronic element, for example, a radio frequency chip, is carried on the PCB 17. In an embodiment, a metal layer may be disposed on the printed circuit board PCB. The metal layer may be configured to ground the electronic element carried on the printed circuit board PCB, or may be configured to ground another element, for example, a bracket antenna or a side frame antenna. The metal layer may be referred to as a ground, a grounding plate, or a ground plane. In an embodiment, the metal layer may be formed by etching metal on a surface of any dielectric board in the PCB. In an embodiment, the metal layer configured for grounding may be disposed on a side that is of the printed circuit board PCB that is close to the flexible display 110. In an embodiment, an edge of the PCB may be considered as an edge of a ground plane of the PCB. The electronic device 100 may further have another ground/grounding plate/ground plane, as described above. Details are not described herein again.

The hinge 125 may be connected between the first housing 126 and the second housing 127. Under the action of the hinge 125, the first housing 126 and the second housing 127 may move close to or away from each other. Correspondingly, the first display part 111 of the flexible display 110 and the second display part 112 of the flexible display 110 may move close to or away from each other, so that the flexible display 110 can be folded or unfolded.

In an example, the hinge 125 may include, for example, a main shaft, a first connection component, and a second connection component. The first connection component may be fastened to the first cover body 122, the second connection component may be fastened to the second cover body 124, and the first connection component and the second connection component may rotate relative to the main shaft. Mutual movement between the first connection component and the second connection component may drive mutual movement between the first housing 126 and the second housing 127, to implement folding and unfolding functions of the foldable electronic device 100.

The foldable electronic device 100 shown in FIG. 1 is currently in an unfolded state. In the unfolded state, an angle between the first housing 126 and the second housing 127 may be approximately 180°. The flexible display 110 may be in the unfolded state shown in FIG. 1.

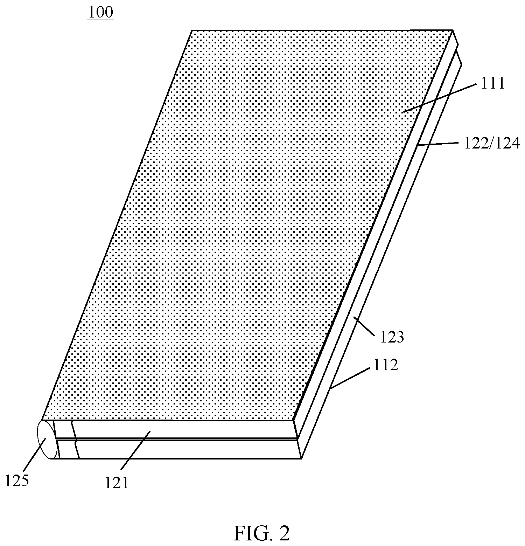

FIG. 2 shows a possible folded state of the foldable electronic device 100. FIG. 2 shows an outward folded state (the outward folded state may be referred to as an outward-folded state for short) of the foldable electronic device 100. The outward folded state shown in FIG. 2 may be, for example, a left-right outward folded state or a top-down outward folded state. With reference to FIG. 1 and FIG. 2, the following describes a possible folded state of the foldable electronic device 100.

In this embodiment of this application, that the foldable electronic device 100 is in a folded state may mean that the foldable electronic device 100 is currently bent, and a bending degree of the foldable electronic device 100 reaches a maximum. In this case, the first cover body 122 and the second cover body 124 may be approximately parallel, spaced from each other, and face-to-face disposed, a spacing distance between the first cover body 122 and the second cover body 124 is minimum, and the first housing 126 and the second housing 127 are at least partially accommodated in space enclosed by the flexible display 110. The first display part 111, the first housing 126, the second housing 127, and the second display part 112 are sequentially stacked. Similarly, the first display part 111 and the second display part 112 may be approximately parallel and spaced from each other, and the spacing distance between the first cover body 122 and the second cover body 124 is less than a spacing distance between the first display part 111 and the second display part 112. In this case, the first display part 111 and the second display part 112 may be considered to be located on different planes.

With reference to FIG. 1 and FIG. 2, when the foldable electronic device 100 is in the outward folded state, the first cover body 122 and the second cover body 124 may be close to each other, and the first display part 111 and the second display part 112 may be close to each other. The first display part 111, the second display part 112, and the foldable display part 113 may form a housing area used to accommodate the first cover body 122, the second cover body 124, and the hinge 125. That is, the first cover body 122, the second cover body 124, and the hinge 125 may be accommodated in space between the first display part 111 and the second display part 112.

It should be understood that the foldable electronic device 100 may be folded inward (an inward folded state may be referred to as an inward-folded state for short). When the foldable electronic device 100 is in the inward folded state, the first cover body 122 and the second cover body 124 may be close to each other, and the first display part 111 and the second display part 112 may be close to each other. The first cover body 122, the second cover body 124, and the hinge 125 may form a housing area used to accommodate the first display part 111, the second display part 112, and the foldable display part 113. That is, the first display part 111, the second display part 112, and the foldable display part 113 may be accommodated in space between the first cover body 122 and the second cover body 124.

The foldable electronic device 100 may be switched between a folded state and an unfolded state. When the foldable electronic device 100 is in a folded state, space occupied by the foldable electronic device 100 is small. When the foldable electronic device 100 is in an unfolded state, the foldable electronic device 100 may display a large screen, to increase a viewing range of a user.

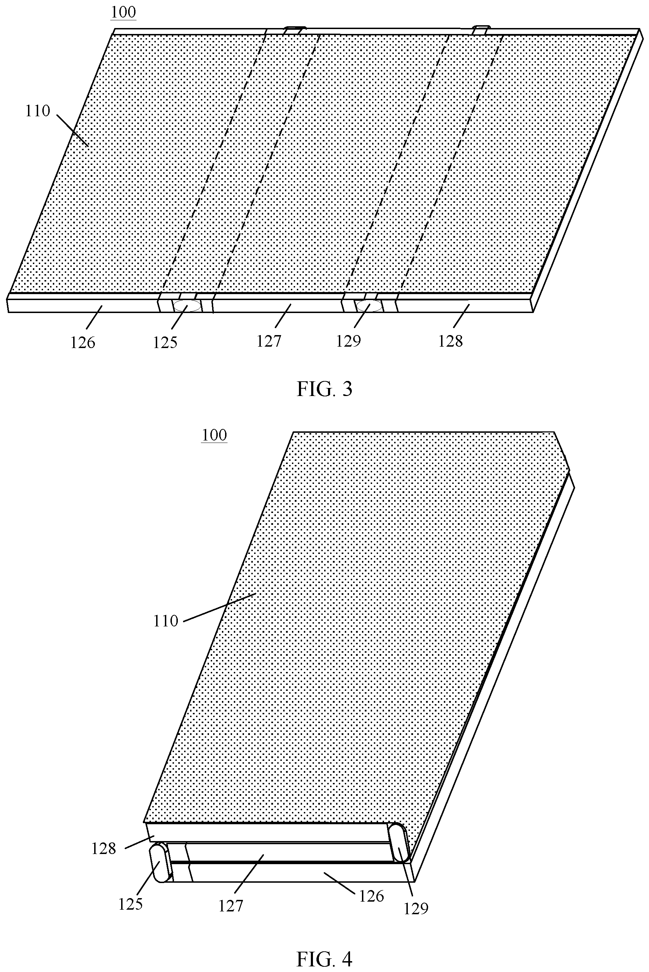

The foldable electronic device 100 may further include a third housing 128 and a hinge 129, as shown in FIG. 3. The hinge 129 may be connected between the third housing 128 and the second housing 127. The third housing 128 and the second housing 127 may move close to or away from each other. As a quantity of foldable parts of the foldable electronic device 100 increases, in a case in which a same screen size is maintained in an unfolded state, space occupied by the foldable electronic device 100 may be further reduced in a folded state.

In the foldable electronic device 100 shown in FIG. 3, because there are three foldable parts (the first housing 126, the second housing 127, and the third housing 128), the foldable electronic device 100 has three forms: 1. unfolded state; 2. folded state; and 3. partially unfolded state.

1. FIG. 3 shows a possible unfolded state of the foldable electronic device 100. In the unfolded state, angles between the first housing 126, the second housing 127, and the third housing 128 may be approximately 180°. The flexible display 110 may be in an unfolded state.

2. FIG. 4 shows a possible folded state (a triple-folded state) of the foldable electronic device 100. In the folded state, the first housing 126 and the second housing 127 rotate along the hinge 125, and the second housing 127 and the third housing 128 rotate along the hinge 129, so that a bending degree of the foldable electronic device 100 reaches a maximum. In this case, the first housing 126, the second housing 127, and the third housing 128 may be considered to be located on different planes.

It should be understood that, for brief description, in the structure shown in FIG. 4, the foldable electronic device 100 is in an S-folded state (a side surface of the foldable electronic device 100 is S-shaped, and the second housing 127 is located between the first housing 126 and the third housing 128). In an embodiment, the foldable electronic device 100 may alternatively be in a G-folded state (a side surface of the foldable electronic device 100 is G-shaped, and the third housing 128 is located between the first housing 126 and the second housing 127). The folded state of the foldable electronic device 100 is not limited in embodiments of this application.

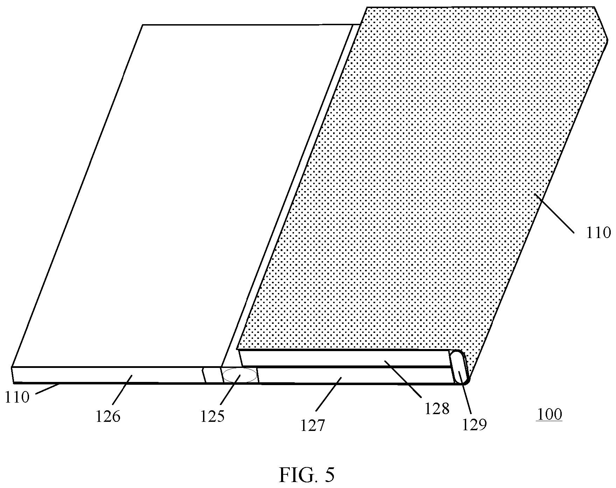

3. FIG. 5 shows a possible partially unfolded state (a double-folded state) of the foldable electronic device 100. In the partially unfolded state, an angle between the first housing 126 and the second housing 127 may be approximately 180°, and the second housing 127 and the third housing 128 rotate along the hinge 129, so that the third housing 128 approaches the second housing 127. In this case, the first housing 126 and the second housing 127 are considered to be located on a same plane, and the second housing 127 and the third housing 128 may be considered to be located on different planes. In another possible partially unfolded state, an angle between the third housing 128 and the second housing 127 may be approximately 180°, and the first housing 126 and the second housing 127 rotate along the hinge 125, so that the first housing 126 approaches the second housing 127.

FIG. 1 shows only an example of some components included in the electronic device 100. Actual shapes, actual sizes, and actual structures of these components are not limited to those in FIG. 1.

It should be understood that, in embodiments of this application, it may be considered that a surface on which the display of the electronic device is located is a front surface, a surface on which the rear cover is located is a rear surface, and a surface on which the side frame is located is a side surface.

It should be understood that, in embodiments of this application, it is considered that when a user holds the electronic device (usually holding the electronic device vertically and facing the screen), an orientation of the electronic device includes top, bottom, left, and right. It should be understood that, in embodiments of this application, it is considered that when a user holds the electronic device (usually holding the electronic device vertically and facing the screen), an orientation of the electronic device includes top, bottom, left, and right.

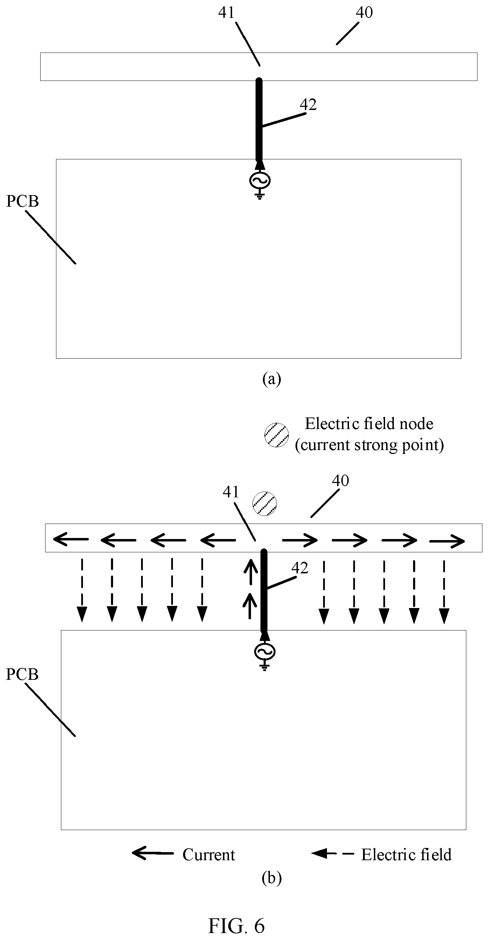

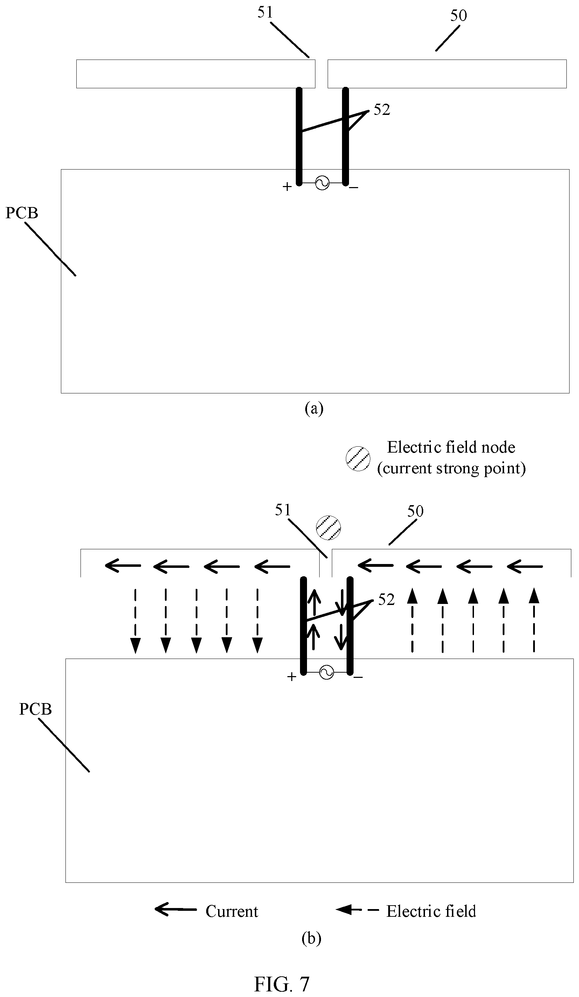

First, two antenna modes in this application are described with reference to FIG. 6 and FIG. 7. FIG. 6 is a diagram of a common-mode structure of an antenna and corresponding current and electric field distribution according to this application. FIG. 7 is a diagram of a differential-mode structure of another antenna and corresponding current and electric field distribution according to this application. Two ends of a radiator of an antenna in FIG. 6 and FIG. 7 are open, and a common mode and a differential mode of the antenna may be respectively referred to as a wire common mode and a wire differential mode.

It should be understood that a "common-differential mode" or a "CM-DM mode" in this application is a wire common mode and a wire differential mode that are generated on a same radiator.

1. Wire (Wire) common mode (common mode, CM)

(a) in FIG. 6 shows that two ends of a radiator of an antenna 40 are open, and a feed circuit (not shown in the figure) is connected at a middle position 41. In an embodiment, the antenna 40 adopts a symmetrical feed (symmetrical feed) form. The feed circuit may be connected at the middle position 41 of the antenna 40 through a feeder 42. It should be understood that the symmetrical feed may be understood as that one end of the feed circuit is connected to the radiator and the other end is coupled to a ground for grounding. A joint (feed point) between the feed circuit and the radiator is located in a center of the radiator. The center of the radiator may be, for example, a midpoint of a geometric structure, or a midpoint of an electrical length (or an area within a specific range near the midpoint).

The middle position 41 of the antenna 40 may be, for example, a geometric center of the antenna, or the midpoint of the electrical length of the radiator. For example, a joint between the feeder 42 and the antenna 40 covers the middle position 41.

(b) in FIG. 6 shows current and electric field distribution of the antenna 40. As shown in (b) in FIG. 6, currents are reversely distributed on two sides of the middle position 41, for example, symmetrically distributed; and electric fields are co-directionally distributed on the two sides of the middle position 41. As shown in (b) in FIG. 6, currents are co-directionally distributed at the feeder 42. Based on the currents being co-directionally distributed at the feeder 42, such feed shown in (a) in FIG. 6 may be referred to as wire CM feed. Based on currents being reversely distributed on two sides of a joint between the radiator and the feeder 42, such an antenna mode shown in (b) in FIG. 6 may be referred to as a wire CM mode (which may also be referred to as a CM mode for short). For example, for a wire antenna, a CM mode is a wire CM mode. The current and the electric field shown in (b) in FIG. 6 may be respectively referred to as a current and an electric field in the wire CM mode.

The currents are stronger at the middle position 41 of the antenna 40 (a current strong point is located near the middle position 41 of the antenna 40), and are weaker at two ends of the antenna 40, as shown in (b) in FIG. 6. The electric fields are weaker at the middle position 41 of the antenna 40, and are stronger at the two ends of the antenna 40.

2. Wire differential mode (differential mode, DM)

As shown in (a) in FIG. 7, a left end and a right end of each of two radiators of an antenna 50 are open ends, and a feed circuit is connected at a middle position 51. In an embodiment, the antenna 50 adopts an anti-symmetrical feed (anti-symmetrical feed) form. One end of the feed circuit is connected to one of the radiators through a feeder 52, and the other end of the feed circuit is connected to the other radiator through the feeder 52. The middle position 51 may be a geometric center of the antenna 50, or a slot formed between the radiators.

It should be understood that, "central anti-symmetrical feed" mentioned in this application may be understood as that a positive electrode and a negative electrode of a feed unit are respectively connected to two connection points near a midpoint of the radiator. In an embodiment, signals output from the positive and negative electrodes of the feed unit have a same amplitude but opposite phases. For example, a phase difference is $180° \pm 10°$.

(b) in FIG. 7 shows current and electric field distribution of the antenna 50. As shown in (b) in FIG. 7, currents are co-directionally distributed on two sides of the middle position 51 of the antenna 50, for example, anti-symmetrically distributed; and electric fields are reversely distributed on the two sides of the middle position 51. As shown in (b) in FIG. 7, currents are reversely distributed at the feeder 52. Based on the currents being reversely distributed at the feeder 52, such feed shown in (a) in FIG. 7 may be referred to as wire DM feed. Based on currents being co-directionally distributed on two sides of a joint between the radiator and the feeder 52, such an antenna mode shown in (b) in FIG. 7 may be referred to as a wire DM mode (which may also be referred to as a DM mode for short). For example, for a wire antenna, a DM mode is a wire DM mode. The current and the electric field shown in (b) in FIG. 7 may be respectively referred to as a current and an electric field in the line DM mode. It should be understood that, based on the currents being co-directionally distributed on the two sides of the joint between the radiator and the feeder 52, such an antenna mode shown in (b) in FIG. 7 may also be referred to as a one-half antenna mode or a one-half-wavelength mode, or may be referred to as a one-half mode for short.

In an embodiment, in the wire DM mode or the one-half mode, the currents are stronger at the middle position 51 of the antenna 50 (a current strong point is located near the middle position 51 of the antenna 50), and are weaker at two ends of the antenna 50, as shown in (b) in FIG. 7. The electric fields are weaker at the middle position 51 of the antenna 50, and are stronger at the two ends of the linear antenna 50.

It should be understood that the radiator of the antenna may be understood as a metal mechanical part that generates radiation, there may be one radiator of the antenna, as shown in FIG. 6, or there may be two radiators of the antenna, as shown in FIG. 7, and a quantity of radiators of the antenna may be adjusted based on an actual design or production requirement. For example, for the wire CM mode, two radiators may be alternatively used, as shown in FIG. 7. Two ends of the two radiators are oppositely disposed and are spaced apart by a slot. A symmetrical feed manner is used at two ends that are close to each other. For example, a same feed source signal is separately fed into the two ends that are of the two radiators and that are close to each other, so that effect similar to that of the antenna structure shown in FIG. 6 can also be achieved. Correspondingly, for the wire DM mode, one radiator may be alternatively used, as shown in FIG. 6. Two feed points are disposed at a middle position of the radiator, and an anti-symmetrical feed manner is used. For example, if signals with a same amplitude and opposite phases are respectively fed into the two symmetrical feed points on the radiator, effect similar to that of the antenna structure shown in FIG. 7 can also be achieved.

3. Wire CM-DM mode

FIG. 6 and FIG. 7 respectively show a wire CM mode and a wire DM mode that are respectively generated in different feed manners when two ends of a radiator are open.

When an antenna adopts an asymmetric feed form (including a side feed form or an offset feed form, where a feed point deviates from a middle position of the radiator), or a grounding point (a position coupled to a ground) of the radiator is asymmetric (the grounding point deviates from a middle position of the radiator), the antenna may generate both a first resonance and a second resonance, which respectively correspond to the wire CM mode and the wire DM mode. For example, the first resonance corresponds to the wire CM mode, and current and electric field distribution is shown in (b) in FIG. 6. The second resonance corresponds to the wire DM mode, and current and electric field distribution is shown in (b) in FIG. 7.

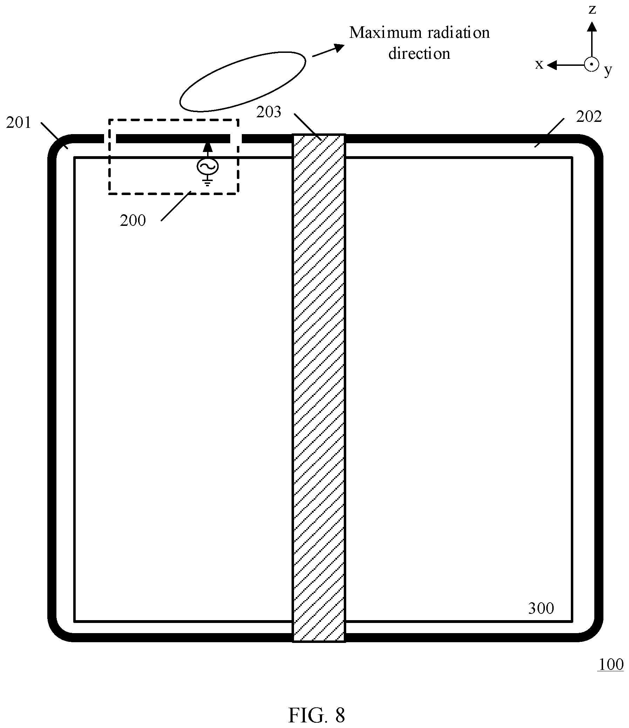

FIG. 8 is a diagram of a maximum radiation direction of a radiation pattern generated by an antenna 200 in a foldable electronic device 100 according to an embodiment of this application.

It should be understood that, for brevity of description, only an example in which the foldable device 100 includes only a first housing 201 and a second housing 202 is used for description. The first housing 201 and the second housing 202 may be rotatably connected to a hinge 203.

As shown in FIG. 8, in an unfolded state of the foldable electronic device 100, because a dimension of a ground 300 in an x direction increases, a current on the ground 300 affects the maximum radiation direction of the radiation pattern generated by the antenna 200, causing the maximum radiation direction to deviate from a top direction (for example, a z direction) (for example, deflect toward the x direction).

When a user performs satellite communication, the maximum radiation direction of the antenna needs to be pointed at a satellite, to implement satellite alignment (to establish a communication connection to the satellite). When the foldable electronic device 100 is in the unfolded state, the maximum radiation direction of the radiation pattern generated by the antenna 200 deviates from the top direction (for example, the z direction) of the foldable electronic device 100. In addition, generally, a beam of the antenna 200 is narrow, for example, can have good communication performance in only a range of 30° from the top direction (for example, the z direction).

A beam width may be understood as follows: If a gain of the radiation pattern generated by the antenna 200 is greater than or equal to a threshold in a range in which an angle formed with the top direction (for example, the z direction) of the foldable electronic device 100 is within a first angle, the first angle is the beam width.

When the beam width of the antenna 200 is relatively narrow, because the maximum radiation direction of the radiation pattern generated by the antenna 200 deviates from the top direction (for example, the z direction) of the foldable electronic device 100, the user needs to frequently change a posture of holding the foldable electronic device 100, so that the maximum radiation direction of the radiation pattern generated by the antenna 200 points to the top direction (for example, the z direction) of the foldable electronic device 100, to maintain a satellite-aligned state with the satellite. Otherwise, communication quality deteriorates, causing great inconvenience in use.

If the beam width of the antenna 200 is relatively wide, the antenna 200 has a wide beam characteristic, and the antenna 200 has good communication performance at a relatively large angle formed with the top direction (for example, the z direction). In this case, during satellite communication, the user does not need to change a posture of holding the foldable electronic device 100. This helps improve user experience.

Embodiments of this application provide a foldable electronic device. The foldable electronic device includes an antenna. Conductive parts of a side frame of the foldable electronic device are used as a main radiator and a parasitic stub of the antenna, so that user experience of satellite communication when the foldable electronic device is in an unfolded state can be improved.

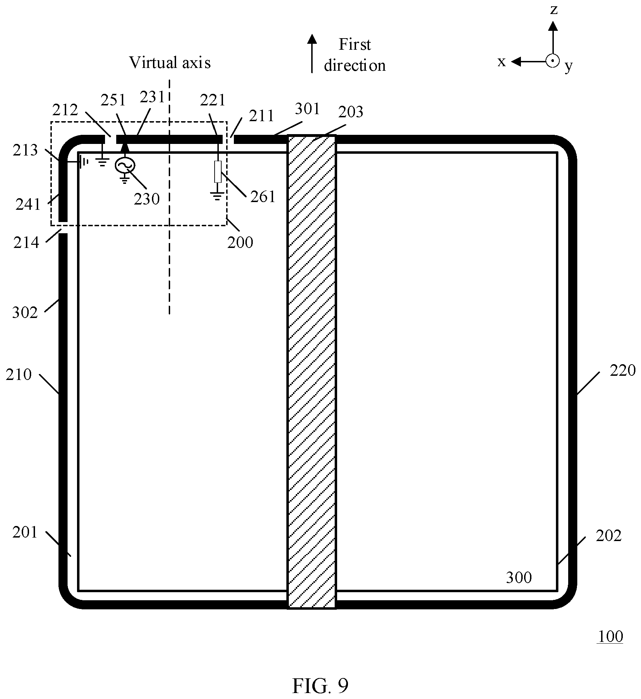

FIG. 9 is a diagram of a foldable electronic device 100 according to an embodiment of this application.

As shown in FIG. 9, the foldable electronic device 100 may include a first housing 201, a second housing 202, a hinge 203, and a ground 300.

It should be understood that the ground 300 in this embodiment of this application has different sizes in different states of the foldable electronic device 100. In an embodiment, when the foldable electronic device 100 is in a folded state, a ratio of a length to a width of the ground 300 is greater than or equal to 1.6 and less than or equal to 2.5. The width may be understood as a dimension of the ground 300 in an extension direction of a top edge (top side) or a bottom edge (bottom side) of the foldable electronic device 100. In an embodiment, when the foldable electronic device 100 is in an unfolded state, a length of the foldable electronic device 100 remains unchanged, a width of the foldable electronic device 100 increases, and a ratio of the length to the width of the ground 300 is greater than or equal to 0.8 and less than or equal to 1.5.

The width and the length of the ground 300 may be understood as dimensions, of an equivalent ground formed by all metal layers or metal pieces (for example, a middle plate, a metal layer in a PCB, or a metal layer in a display) that can be equivalent to the ground, in an extension direction of the length and an extension direction of the width.

The first housing 201 includes a first side frame 210, and at least a part of the first side frame 210 is spaced from the ground 300. The second housing 202 includes a second side frame 220, and at least a part of the second side frame 220 is spaced from the ground 300.

The hinge 203 is located between the first housing 201 and the second housing 202, and the hinge 203 is rotatably connected to the first housing 201 and the second housing 202, so that the first housing 201 and the second housing 202 can rotate relative to each other. In an embodiment, the ground 300 may include a first part and a second part. The first part may be located in the first housing 201, the second part may be located in the second housing 202, and the first part and the second part may be connected through the hinge 203.

It should be understood that, in the foldable electronic device 100 shown in FIG. 9, the hinge 203 is directly connected to the first housing 201 and the second housing 202, so that the first housing 201 and the second housing 202 can rotate relative to each other. In addition, "the hinge 203 is rotatably connected to the first housing 201 and the second housing 202" includes a case in which the hinge 203 may be rotatably connected to the first housing or the second housing through one or more second hinges and one or more intermediate housings. For example, in an embodiment, the foldable electronic device 100 may further include a first hinge and a second hinge, and one or more intermediate housings located between the first hinge and the second hinge. The first hinge is located between the first housing 201 and the intermediate housing, and the first hinge is rotatably connected to the first housing 201 and the intermediate housing, so that the first housing 201 and the intermediate housing can rotate relative to each other. The second hinge is located between the intermediate housing and the second housing 202, and the hinge 203 is rotatably connected to the intermediate housing and the second housing 202, so that the intermediate housing and the second housing 202 can rotate relative to each other.

The first side frame 210 includes a first position 211, a second position 212, a third position 213, and a fourth position 214 that are sequentially provided. The first side frame 210 is provided with a first insulation gap, a second insulation gap, and a third insulation gap at the first position 211, the second position 212, and the fourth position 214 respectively. The first side frame 210 is coupled to the ground 300 at the third position 213.

The first position 211 and the second position 212 are located on a first edge 301 of the first side frame 210, and the third position 213 and the fourth position 214 are located on a second edge 302. The first edge 301 and the second edge 302 intersect at a corner. In an embodiment, a length of the first edge 301 is less than a length of the second edge 302. In an embodiment, the first edge 301 is a top edge or a bottom edge of the foldable electronic device 100. For brevity of description, in this embodiment of this application, only an example in which the first edge 301 is the top edge of the foldable electronic device 100 is used for description.

It should be understood that an insulation gap may be provided on the side frame, and a conductor part of the side frame between two insulation gaps or between the insulation gap and a grounding point is used as a radiator, to form a side frame antenna. When the side frame is made of a conductive material such as metal, the insulation gap may be understood as that the gap provided on the side frame is filled with a non-metal material (an insulating material). In addition, the gap is visible on an appearance surface. When an outer surface of the side frame is made of a non-conductive material, the insulation gap may be understood as a gap between conductor parts in the side frame. The gap may be filled with a non-metal material (an insulating material), or may be filled with air instead of being filled with a non-metal material. In addition, the gap is invisible on an appearance surface.

In an embodiment, a width of the first insulation gap/second insulation gap/third insulation gap is greater than or equal to 0.2 mm and less than or equal to 2 mm. It should be understood that, in this embodiment of this application, widths of all gaps provided on the side frame may fall within the foregoing range.

In an embodiment, a ratio of a dimension of the ground 300 in an extension direction of the first edge (a width of the foldable electronic device 100) when the foldable electronic device 100 is in the unfolded state to a dimension of the ground 300 in the extension direction of the first edge when the foldable electronic device 100 is in the folded state is greater than or equal to 1.8 and less than or equal to 2.2.

The foldable electronic device 100 may further include an antenna 200. The antenna 200 includes a first radiator 231, a first parasitic stub 241, a first feed circuit 230, and a first electronic element 261.

The first radiator 231 is a conductive part of the first side frame 210 between the first position 211 and the second position 212. The first parasitic stub 241 is a conductive part of the first side frame 210 between the third position 213 and the fourth position 214. In an embodiment, a first end and a second end of the first radiator 231 are open ends. A first end of the first parasitic stub 241 is a grounding end, and a second end is an open end.

The first radiator 231 includes a first feed point 251 and a first connection point 221. The first feed circuit 230 is coupled to the first feed point 251. The first electronic element 261 is coupled between the first connection point 221 and the ground 300. The first feed point 251 and the first connection point 221 are respectively located on two sides of a virtual axis of the first radiator 231, and the first radiator 231 has a same length on the two sides of the virtual axis.

It should be understood that the two sides of the virtual axis in embodiments of this application may be understood as two sides of a plane including the virtual axis and a thickness direction of the foldable electronic device 100 (for example, a direction perpendicular to a display in the unfolded state) (for example, a y direction). The first parasitic stub 241 is located on a first side of the virtual axis, and the hinge 203 is located on a second side of the virtual axis.

In addition, due to a production and design requirement, an edge that is of the first side frame 210 and that faces the ground 300 (faces the inside of the foldable electronic device 100) is not flat. Therefore, in embodiments of this application, the virtual axis of the first radiator 231 may be understood as a straight line perpendicular to a center of the first radiator 231.

An operating frequency band of the antenna 200 may include a satellite communication frequency band. When the foldable electronic device 100 is in the unfolded state, the first radiator 231 is configured to generate a first resonance. A resonance frequency band of the first resonance includes the satellite communication frequency band. Satellite communication includes at least one communication service of receiving and/or sending a short message (or referred to as a short packet) through a satellite, making and/or answering a call through a satellite, and satellite data (for example, internet access).

In an embodiment, the satellite communication frequency band may include a part of frequency bands in a Tiantong satellite system, and may include a transmit frequency band (1980 MHz to 2010 MHz) and a receive frequency band (2170 MHz to 2200 MHz) in the Tiantong satellite system. In an embodiment, the satellite communication frequency band may include a part of frequency bands in a BeiDou satellite system, and may include a transmit frequency band (1610 MHz to 1626.5 MHz) and a receive frequency band (2483.5 MHz to 2500 MHz) in the BeiDou satellite system. In an embodiment, the satellite communication frequency band may include a part of frequency bands in a low-earth-orbit satellite system, and may include a transmit frequency band (2500 MHz to 2520 MHz) and a receive frequency band (2670 MHz to 2690 MHz) in the low-earth-orbit satellite system. Alternatively, the satellite communication frequency band may be applied to another satellite communication system. This is not limited in embodiments of this application.

In an embodiment, the foldable electronic device 100 may perform voice communication through the antenna 200 when the antenna 200 operates in the Tiantong satellite system (the operating frequency band of the antenna 200 includes at least a part of frequency bands in the Tiantong satellite system). In an embodiment, the foldable electronic device 100 may send or receive a short packet or a picture through the antenna 200 when the antenna 200 operates in the BeiDou satellite system (the operating frequency band of the antenna 200 includes at least a part of frequency bands in the BeiDou satellite system).

The first radiator 231, the first parasitic stub 241, and the first electronic element 261 are configured to generate a radiation pattern of the antenna. In an embodiment, when the foldable electronic device 100 is in the unfolded state, a beam width of the antenna 200 is related to the first parasitic stub 241.

According to embodiments of this application, when the foldable electronic device 100 is in the unfolded state, because the first parasitic stub 241 is disposed on the second edge 302, a direction of radiation generated by the first parasitic stub 241 deviates toward a left side of a first direction (a side that is of the first direction and that faces the first parasitic stub 241). The first electronic element 261 may enhance the radiation generated by the first parasitic stub 241. The first direction is a direction pointing from the bottom of the foldable electronic device 100 to the top of the foldable electronic device 100, for example, a z direction. When the foldable electronic device 100 is in the unfolded state, because a direction of radiation generated by the first radiator 231 deviates toward a right side of the first direction (a side that is of the first direction and that faces the hinge 203), the first radiator 231 and the first parasitic stub 241 may respectively generate strong radiation on two sides of the top (the first direction) of the foldable electronic device 100, so that the antenna 200 can have a wide beam characteristic.

It should be understood that, when the foldable electronic device 100 is in the unfolded state, the first feed circuit 230 feeds an electrical signal, the first radiator 231 is configured to generate a main resonance, the first parasitic stub 241 is configured to generate a first parasitic resonance, and the main resonance and the first parasitic resonance jointly form the first resonance (because a frequency difference between a resonance point of the first parasitic resonance and a resonance point of the main resonance is relatively small, in an S parameter diagram, the main resonance and the first parasitic resonance are merged into one resonance). In an embodiment, the resonance point of the first parasitic resonance is in a resonance frequency band of the main resonance. In an embodiment, a frequency difference between a resonance point frequency of the first parasitic resonance and a resonance point frequency of the main resonance is less than or equal to 100 MHz. In an embodiment, a frequency difference between a resonance point frequency of the first parasitic resonance and a resonance point frequency of the main resonance is less than or equal to 50 MHz. The resonance point frequency of the first parasitic resonance may be greater than, equal to, or less than the resonance point frequency of the main resonance.

In addition, in embodiments of this application, coupling between the first radiator 231 and the first parasitic stub 241 is relatively weak, and the first parasitic resonance cannot be well excited. Therefore, a dip corresponding to the first parasitic resonance cannot appear clearly in an S parameter diagram. Because the first parasitic resonance is partially excited by a current, a clear dip appears in an efficiency curve (for example, radiation efficiency or total efficiency). For example, if the efficiency dip appears at the first frequency point, the first frequency point may be considered as a resonance point corresponding to the first parasitic resonance. In an embodiment, a reduction of efficiency (for example, radiation efficiency or total efficiency) resulting from the dip does not exceed 1.5 dB. In an embodiment, a reduction of efficiency (for example, radiation efficiency or total efficiency) resulting from the dip does not exceed 1 dB.

When the foldable electronic device 100 is in the unfolded state, because the first parasitic stub 241 is disposed on the second edge 302, a maximum radiation direction of a radiation pattern generated by the first parasitic resonance deviates toward the first side (the first side is a side that is of the virtual axis of the first radiator 231 and that is close to the first parasitic stub 241). When the foldable electronic device 100 is in the unfolded state, because the main resonance is affected by a current on the ground 300, a maximum radiation direction of a radiation pattern generated by the main resonance deviates toward the second side (the second side is a side that is of the virtual axis of the first radiator 231 and that is away from the first parasitic stub 241). Because the first parasitic resonance and the main resonance may respectively generate radiation on two sides of the top of the foldable electronic device 100, the antenna 200 can have a wide beam characteristic. In an embodiment, the first parasitic resonance and the main resonance may respectively generate strong radiation beams on the two sides of the top (the first direction) of the foldable electronic device 100. When the two beams approach each other, the two beams may be combined into one radiation beam. Alternatively, when the two beams deviate toward the two sides of the first direction, bandwidth of the radiation beam may be increased.

The wide beam characteristic may be understood as that the antenna 200 has a relatively large beam width, so that the foldable electronic device 100 has a good communication characteristic in a range of a first angle (for example, 50°) from the first direction. For example, when a user performs satellite communication, the antenna 200 has a wide beam characteristic, a radiation pattern generated by the antenna 200 has a good characteristic within the first angle, a communication satellite may move within the first angle without affecting satellite communication quality, and the user does not need to frequently change a posture of holding the foldable electronic device 100, thereby effectively improving user experience.

In an embodiment, a gain is greater than or equal to -6 dBic in a range in which an angle formed with the first direction (for example, the z direction) is within 50°. In an embodiment, a gain is greater than or equal to -6 dBic in a range in which an angle formed with the top direction (for example, the z direction) of the foldable electronic device 100 is within 60°.

In addition, the main resonance is generated in the wire DM mode described in the foregoing embodiments. Because a current generated in the wire DM mode is mainly generated by the first radiator 231, the current is mainly concentrated on the first radiator 231, a plurality of current modes are not generated on the ground 300, and it is easy to determine the maximum radiation direction of the radiation pattern generated by the antenna 200.

In addition, for the wire CM mode, a transverse mode of the ground may be excited (a proportion is greater than that of a longitudinal mode), but currents corresponding to the transverse mode on the ground are mutually offset. Therefore, total efficiency and radiation efficiency in the wire CM mode are relatively low. For the wire DM mode, radiation of the antenna in the wire DM mode is mainly generated by the radiator, and total efficiency and radiation efficiency in the wire DM mode are better than those in the wire CM mode.

In an embodiment, when the foldable electronic device 100 is in the unfolded state, and the antenna 200 operates in the satellite communication frequency band, a current (for example, current intensity or current density) on the first side (a side that is of the virtual axis of the first radiator 231 and that faces the first parasitic stub 241) on the ground 300 is greater than a current on the second side (a side that is of the virtual axis of the first radiator 231 and that is away from the first parasitic stub 241) on the ground 300.

When the foldable electronic device 100 is in the unfolded state, and the antenna 200 operates in the satellite communication frequency band, a current (for example, current intensity or current density) on the first side (the side that is of the virtual axis of the first radiator 231 and that faces the first parasitic stub 241) on the first radiator 231 is greater than a current on the second side (the side that is of the virtual axis of the first radiator 231 and that is away from the first parasitic stub 241) on the first radiator 231.

It should be understood that, there is a relatively strong current on the ground facing a side of the first parasitic stub 241, so that the first parasitic stub 241 can be better excited to generate a first parasitic resonance, thereby improving a radiation characteristic of radiation generated by the first parasitic resonance, and enhancing a radiation characteristic of the antenna 200 on the left side of the first direction (the side that is of the first direction and that faces the first parasitic stub 241).

In addition, the current on the ground 300 in embodiments of this application may be understood as a current near an edge that is of the ground 300 and that is close to the radiator/parasitic stub, for example, a current within a distance of 30 mm from the edge.

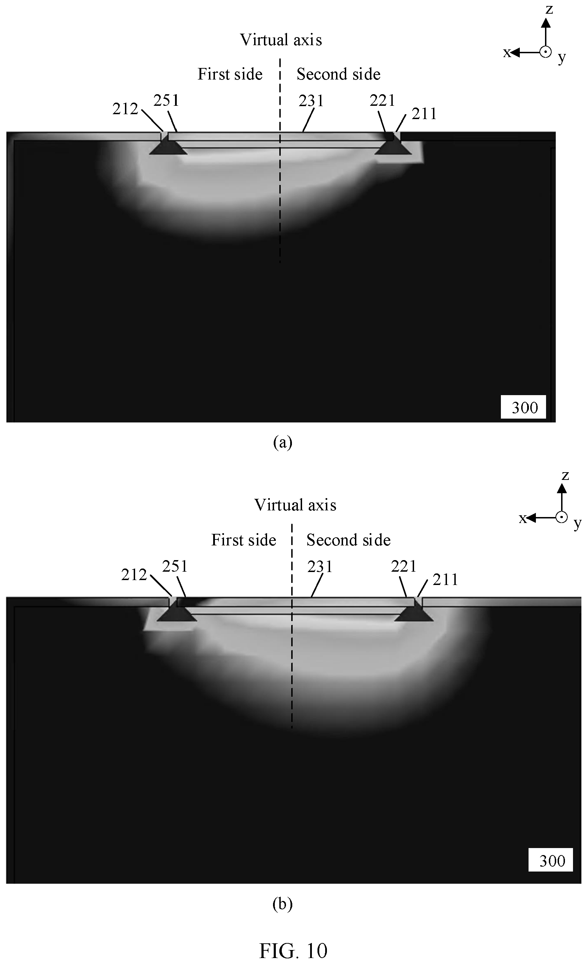

In an embodiment, the first feed point 251 is located on the first side of the virtual axis of the first radiator 231, and the first connection point 221 is located on the second side of the virtual axis of the first radiator 231. When the first electronic element has an open-circuit characteristic or an equivalent inductance is greater than or equal to 5 nH, the current on the first side on the ground 300 is greater than the current on the second side on the ground 300, as shown in (a) in FIG. 10.

In an embodiment, the equivalent inductance of the first electronic element may be determined based on a frequency of the first resonance. When a resonance point frequency of the first resonance is greater than or equal to 3 GHz, the equivalent inductance of the first electronic element is greater than or equal to 20 nH. When a resonance point frequency of the first resonance is greater than or equal to 2 GHz and less than 3 GHz, the equivalent inductance of the first electronic element is greater than or equal to 10 nH. When a resonance point frequency of the first resonance is greater than or equal to 1 GHz and less than 2 GHz, the equivalent inductance of the first electronic element is greater than or equal to 5 nH.

In an embodiment, the first feed point 251 is located on the first side of the virtual axis of the first radiator 231, and the first connection point 221 is located on the second side of the virtual axis of the first radiator 231. When the first electronic element has a short-circuit characteristic or an equivalent capacitance is greater than or equal to 0.5 pF, the current on the first side on the ground 300 is less than the current on the second side on the ground 300, as shown in (b) in FIG. 10.

In an embodiment, the equivalent capacitance of the first electronic element may be determined based on a frequency of the first resonance. When a resonance point frequency of the first resonance is greater than or equal to 3 GHz, the equivalent capacitance of the first electronic element is greater than or equal to 0.5 pF. When a resonance point frequency of the first resonance is greater than or equal to 2 GHz and less than 3 GHz, the equivalent capacitance of the first electronic element is greater than or equal to 2 pF. When a resonance point frequency of the first resonance is greater than or equal to 1 GHz and less than 2 GHz, the equivalent capacitance of the first electronic element is greater than or equal to 3 pF.

That the first electronic element has the open-circuit/short-circuit characteristic may be understood as that there is an open circuit/a short circuit between the first connection point 221 and the ground 300. For example, the first electronic element is a switch, a common port of the switch is coupled to the first connection point 221, and a connection port is coupled to the ground 300. When the common port of the switch is not electrically connected to the connection port, there is the open-circuit characteristic. When the common port of the switch is electrically connected to the connection port, there is the short-circuit characteristic.

In addition, the first electronic element may include a switch and a plurality of electronic elements. The first electronic element may be electrically connected to different connection ports through a common port of the switch, so that the first electronic element has different capacitance/inductance characteristics. This is not limited in embodiments of this application.

In an embodiment, when the first feed point 251 is located on the first side of the virtual axis of the first radiator 231, and the first connection point 221 is located on the second side of the virtual axis of the first radiator 231, the first electronic element has the open-circuit characteristic or the equivalent inductance is greater than or equal to 5 nH. In an embodiment, when the first connection point 221 is located on the first side of the virtual axis of the first radiator 231, and the first feed point 251 is located on the second side of the virtual axis of the first radiator 231, the first electronic element has the short-circuit characteristic or the equivalent capacitance is greater than or equal to 0.5 pF.

It should be understood that, with reference to the foregoing setting, when the antenna 200 generates the first resonance (the foldable electronic device 100 performs satellite communication), there can be a strong current on the ground facing the side of the first parasitic stub 241, so that the first parasitic stub 241 is better excited to generate the first parasitic resonance, thereby improving a radiation characteristic of radiation generated by the first parasitic resonance, and enhancing a radiation characteristic of the antenna 200 on the first side.

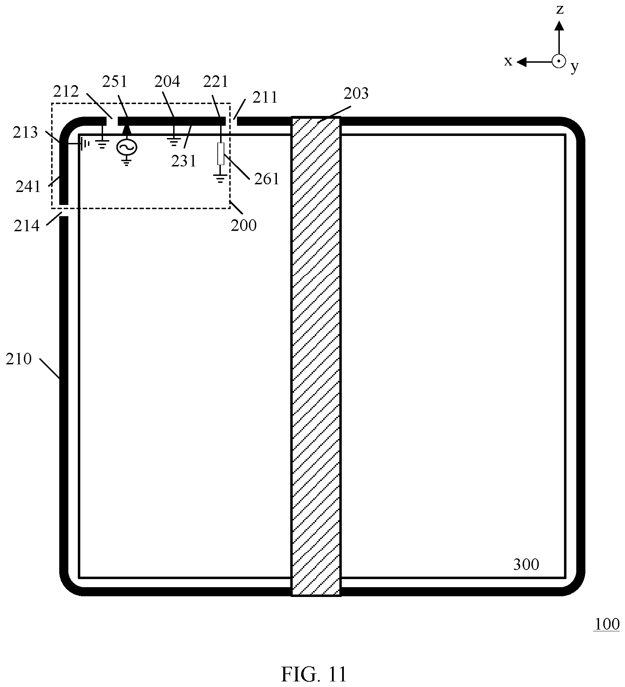

In an embodiment, the first side frame 210 further includes a grounding point 204 between the first position 211 and the second position 212, and the first side frame 210 is coupled to the ground 300 at the grounding point 204, as shown in FIG. 11. The grounding point 204 is located between the first feed point 251 and the first connection point 221. In an embodiment, the grounding point 204 is located in a central area of the first radiator 231. The central area includes the center of the first radiator 231, and the first radiator 231 has a same length on two sides of the center. The central area of the first radiator 231 may be understood as an area whose distance from the center of the first radiator 231 is within 5 mm.

It should be understood that the grounding point 204 may facilitate reuse of the conductive part of the first side frame 210 between the first position 211 and the second position 212. For example, when the foldable electronic device 100 does not operate in the satellite communication frequency band, a conductive part of the first side frame 210 between the first position 211 and the grounding point 204 and a conductive part of the first side frame 210 between the second position 212 and the grounding point 204 may be respectively used as radiators of different antennas, to expand an operating frequency band of the foldable electronic device 100.

In an embodiment, grounding may be implemented at the grounding point 204 by using a grounding member. A width of a connection between the grounding member and the first side frame 210 is greater than or equal to 1 mm and less than or equal to 8 mm.

It should be understood that the grounding point and/or the connection point may be implemented by using a metal spring or a connection rib structure with a middle plate of a middle frame. This is not limited in embodiments of this application.

In an embodiment, when the grounding point 204 is provided between the first position 211 and the second position 212, to achieve the same technical effect in the foregoing embodiment, a characteristic of the first electronic element 261 needs to be adjusted. In an embodiment, when the first feed point 251 is located on the first side of the virtual axis of the first radiator 231 (between the second position 212 and the grounding point 204), and the first connection point 221 is located on the second side of the virtual axis of the first radiator 231 (between the first position 211 and the grounding point 204), the equivalent capacitance of the first electronic element is greater than or equal to 0.5 pF and less than or equal to 1.2 pF, so that there is a strong current on the ground facing the side of the first parasitic stub 241, and the first parasitic stub 241 is better excited to generate the first parasitic resonance, thereby improving a radiation characteristic of radiation generated by the first parasitic resonance, and enhancing a radiation characteristic of the antenna 200 on the first side.

In an embodiment, a distance (a length of the first radiator 231) between the first feed point 251 and an adjacent end (for example, the second position 212) of the first radiator 231 is less than or equal to one third of the length of the first radiator 231. In an embodiment, the distance between the first feed point 251 and the adjacent end of the first radiator 231 is less than or equal to 5 mm.

In an embodiment, a distance (a length of the first radiator 231) between the first connection point 221 and an adjacent end (for example, the first position 211) of the first radiator 231 is less than or equal to one third of the length of the first radiator 231. In an embodiment, the distance between the first connection point 221 and the adjacent end of the first radiator 231 is less than or equal to 5 mm.

It should be understood that, as the first feed point 251 moves toward one end of the first radiator 231, miniaturization of the first radiator 231 is facilitated. As the first connection point 221 moves toward one end of the first radiator 231, adjustment of current distribution on the ground 300 is facilitated, and there may be a larger current adjustment range.

In an embodiment, a distance between the first radiator 231 and the first parasitic stub 241 may be greater than or equal to two tenths of a first wavelength and less than or equal to one half of the first wavelength, and the first wavelength is a vacuum wavelength corresponding to the first resonance (for example, a resonance point or a center frequency of a resonance frequency band).

Correspondingly, the first radiator 231 may operate in a half wavelength mode, and the distance between the first radiator 231 and the first parasitic stub 241 may be greater than or equal to four tenths of a length of the first side frame 210 between the first position 211 and the second position 212 and less than or equal to the length L1 of the first side frame 210 between the first position 211 and the second position 212.

It should be understood that when the distance between the first radiator 231 and the first parasitic stub 241 falls within the foregoing range, the wide beam characteristic of the antenna 200 is well improved. The distance between the first radiator 231 and the first parasitic stub 241 may be understood as a distance between a center (geometric center) of the first radiator 231 and a center of the first parasitic stub 241.

In an embodiment, a length L2 of the first parasitic stub 241 (a length of the first side frame 210 between the third position 213 and the fourth position 214) and a length L1 of the first radiator 231 (the length of the first side frame 210 between the first position 211 and the second position 212) satisfy: $L1 \times 40\% \leq L2 \leq L1 \times 90\%$.

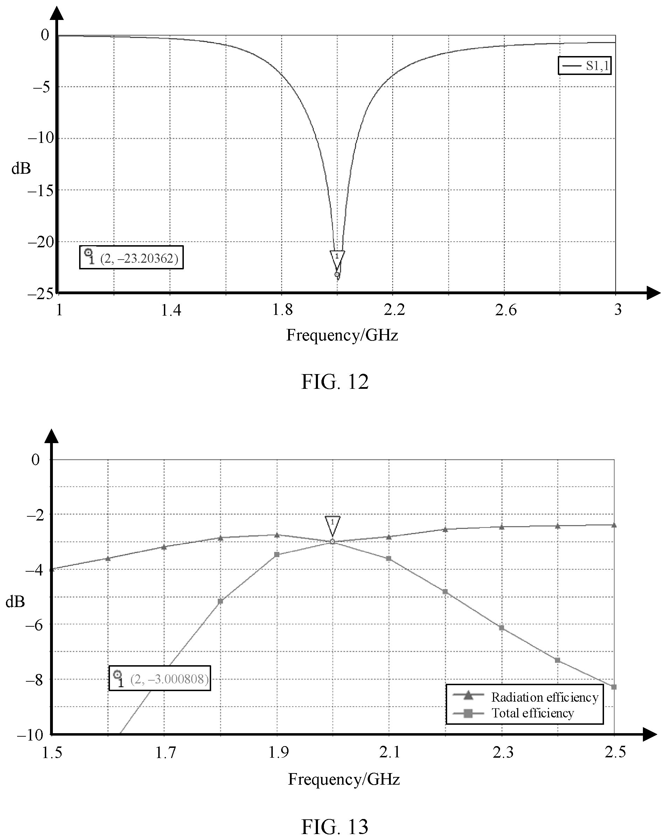

FIG. 12 and FIG. 13 show simulation results of the foldable electronic device 100 shown in FIG. 9 in an unfolded state. FIG. 12 shows a simulation result of an S parameter of the antenna 200 in the foldable electronic device 100 shown in FIG. 9. FIG. 13 shows a simulation result of total efficiency of the antenna 200 in the foldable electronic device 100 shown in FIG. 9.

As shown in FIG. 12, the antenna may generate a resonance near 2 GHz, which may correspond to the first resonance described in the foregoing embodiment.

As shown in FIG. 13, the antenna has relatively good radiation efficiency and total efficiency near 2 GHz. In addition, a dip generated near 2 GHz may correspond to the first parasitic resonance in the foregoing embodiment.

It should be understood that, if the antenna generates a main resonance near 2 GHz through only the first radiator, a radiation efficiency curve is a smooth curve. However, a dip is generated near 2 GHz on a radiation efficiency curve shown in FIG. 13, it indicates that there is the first parasitic resonance near 2 GHz, and the resonance causes the radiation efficiency dip.

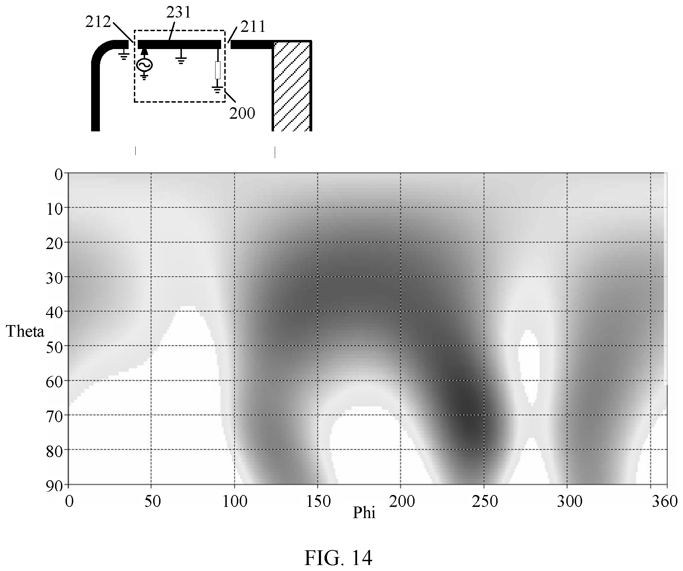

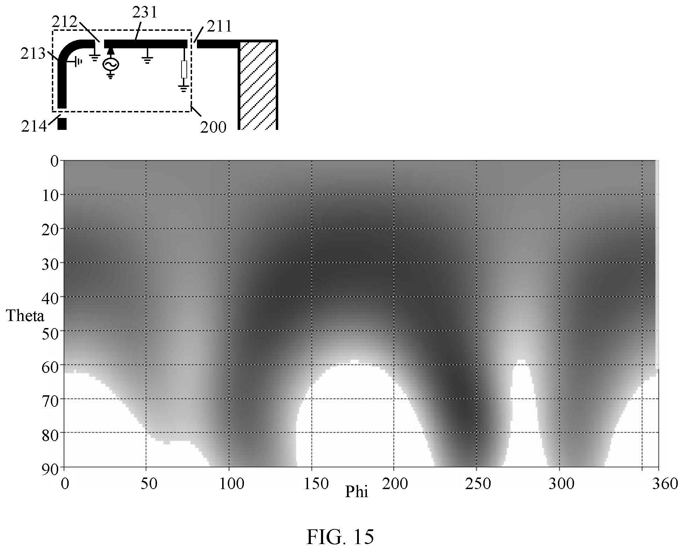

FIG. 14 and FIG. 15 are radiation patterns of the antenna 200 in the foldable electronic device 100 shown in FIG. 9 at 2 GHz. FIG. 14 is a radiation pattern of the antenna 200 when no first parasitic stub is disposed and the foldable electronic device 100 is in an unfolded state. FIG. 15 is a radiation pattern of an antenna 200 when a first parasitic stub is disposed and a foldable electronic device 100 is in an unfolded state.

It should be understood that, in the radiation pattern shown in embodiments of this application, a vertical axis represents an angle Theta ($\theta$) formed with the z direction (a direction pointing to the top of the foldable electronic device 100) (an angle formed with the z axis), and a horizontal axis represents an angle Phi ($\varphi$) formed with the x direction (an extension direction of the first edge) (an angle formed with the x axis on an xoy plane).

The z direction (Theta=0°, Phi=180°) is the first direction pointing from the bottom of the foldable electronic device 100 to the top of the foldable electronic device 100, and faces the satellite during satellite communication. When the radiation pattern of the antenna satisfies a gain requirement (for example, -5.5 dBic), a larger angle formed with the z direction indicates a better wide beam characteristic of the antenna. When the satellite moves within the angle range, there may still be a good communication characteristic when the foldable electronic device 100 does not move.

As shown in FIG. 14, no first parasitic stub is disposed. When the foldable electronic device is in the unfolded state, a current on the ground affects a maximum radiation direction of the radiation pattern generated by the antenna 200, so that the maximum radiation direction deviates from the top direction. For example, the maximum radiation direction deviates toward a right side (Phi≤180°) of the first direction. A dip is generated near Theta=75°/275° in the radiation pattern generated by the antenna. With a gain being greater than or equal to -5.5 dBic as a limit, the antenna 200 satisfies a communication requirement only when Theta is within 38°.

As shown in FIG. 15, the first parasitic stub is disposed. When the foldable electronic device is in the unfolded state, the first parasitic resonance generated by the first parasitic stub 241 may generate radiation toward the left side (Phi≥180°) of the first direction, which may be combined with radiation that is generated by the first radiator 231 and that is toward the right side (Phi≤180°) of the first direction due to impact of the current on the ground, so that the radiation pattern no longer has a dip. With a gain being greater than or equal to -5.5 dBic as a limit, the antenna 200 satisfies a communication requirement when Theta is within 60°, and the antenna 200 has a wide beam characteristic.

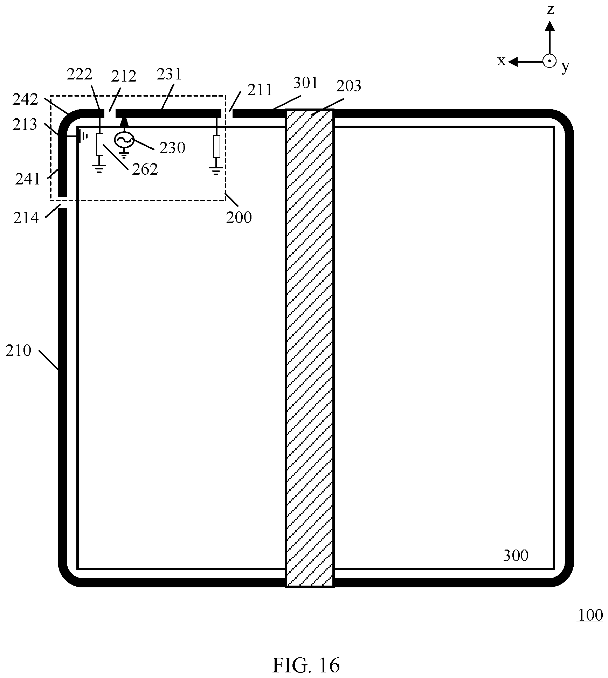

FIG. 16 is a diagram of a foldable electronic device 100 according to an embodiment of this application.

As shown in FIG. 16, the antenna 200 may further include a second parasitic stub 242. The second parasitic stub 242 is a conductive part of the first side frame 210 between the second position 212 and the third position 213. At least a part of the second parasitic stub 242 is spaced from the ground 300. In an embodiment, a first end of the second parasitic stub 242 is an open end, and a second end is a grounding end.

It should be understood that a difference between the antenna 200 shown in FIG. 16 and the antenna 200 shown in FIG. 9 lies in only the second parasitic stub 242. In the antenna 200 shown in FIG. 9, both ends of the conductive part between the second position 212 and the third position 213 are grounding ends, and a resonance cannot be generated by coupling energy of the first radiator 231. In the antenna 200 shown in FIG. 16, an end that is of the conductive part of the first side frame 210 between the second position 212 and the third position 213 and that is close to the first radiator 231 is an open end, and may be used as the second parasitic stub 242. When the foldable electronic device 100 is in the unfolded state, the second parasitic stub 242 may be configured to pull a current flowing to the first parasitic stub 241, to enhance a radiation characteristic of the first parasitic stub 241, and adjust strength of radiation generated by the first parasitic stub 241 that deviates toward the left side of the first direction, so as to adjust a wide beam characteristic of the antenna 200.

In an embodiment, a first end of the second parasitic stub 242 and a first end of the first radiator 231 are opposite to each other through the second insulation gap and are not in contact with each other. The first end of the second parasitic stub 242 may further include a second connection point 222. The antenna 200 may further include a second electronic element 262. The second electronic element 262 is coupled between the second connection point 222 and the ground 300.

It should be understood that the second electronic element 262 may be configured to adjust a coupling amount between the second parasitic stub 242 and the first radiator 231, and adjust a current flowing to the first parasitic stub 241, so as to adjust strength of radiation generated by the first parasitic stub 241 that deviates toward the left side of the first direction (the side that is of the first direction and that faces the first parasitic stub 241).

In an embodiment, the second parasitic stub 242 may be configured to generate a second parasitic resonance. A resonance point frequency of the second parasitic resonance is greater than the resonance point frequency of the first resonance. In an embodiment, a frequency difference between the resonance point frequency of the second parasitic resonance and the resonance point frequency of the first resonance is greater than or equal to 200 MHz.

It should be understood that when a resonance point of the second parasitic resonance is in the resonance frequency band of the first resonance, a dip appears in radiation efficiency within the resonance frequency band of the first resonance, and a radiation characteristic of the antenna 200 is reduced.

In an embodiment, a length L3 of the second parasitic stub 242 (a length of the first side frame 210 between the second position 212 and the third position 213) and the length L1 of the first radiator 231 (the length of the first side frame 210 between the first position 211 and the second position 212) satisfy: $L1 \times 40\% \leq L3 \leq L1 \times 90\%$.

For brevity of description, parts of the antenna 200 shown in FIG. 16 similar to those of the antenna 200 shown in FIG. 9 are not described one by one again. For example, the similar parts include: a position of the first radiator 231, a position of the first parasitic stub 241, and a relative position between the first radiator 231 and the first parasitic stub 241; the satellite communication frequency band; the first resonance jointly generated by the first radiator 231 and the first parasitic stub 241; a position of the first feed point 251 and a position of the first connection point 221; and the like.

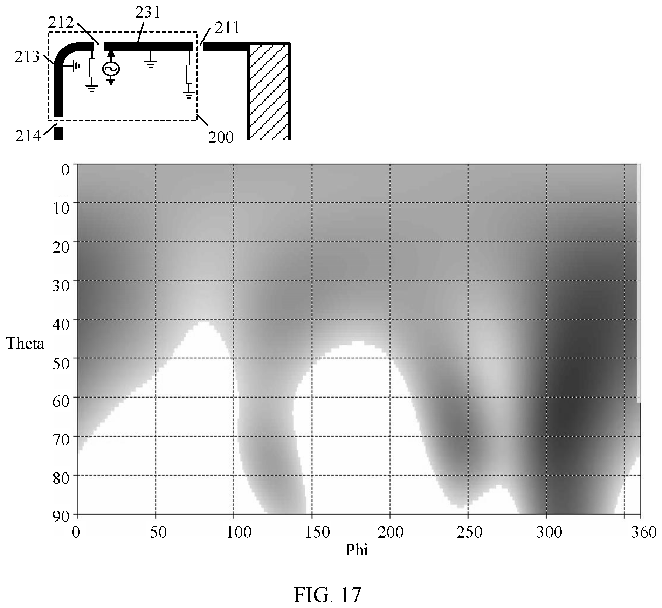

FIG. 17 is a radiation pattern of the antenna 200 in the foldable electronic device 100 shown in FIG. 16 at 2 GHz.

The z direction (Theta=0°, Phi=180°) is the first direction pointing from the bottom of the foldable electronic device 100 to the top of the foldable electronic device 100.

As shown in FIG. 17, in comparison with the simulation result shown in FIG. 15 obtained when no second parasitic stub is disposed, if the second parasitic stub is disposed, when the foldable electronic device is in the unfolded state, the second parasitic stub 242 enhances a radiation characteristic of the first parasitic stub 241, so that strength of radiation generated by the first parasitic stub 241 that deviates toward the left side of the first direction (for example, an area of 180°≤Phi≤360° in the radiation pattern shown in FIG. 17) increases.

It should be understood that, the second electronic element may be configured to adjust a coupling amount between the second parasitic stub and the first radiator, and adjust a current flowing to the first parasitic stub, so as to change the strength of the radiation generated by the first parasitic stub that deviates toward the left side of the first direction, thereby determining a wide beam characteristic of the antenna 200.

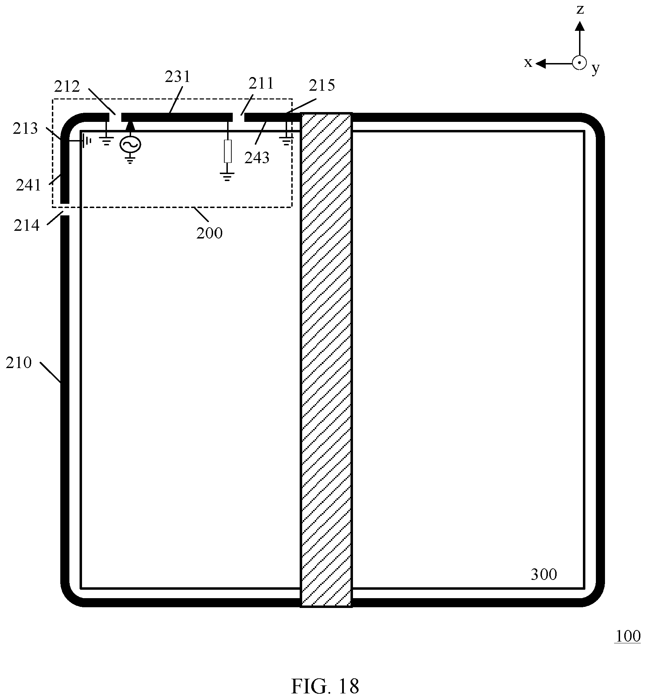

FIG. 18 is a diagram of a foldable electronic device 100 according to an embodiment of this application.

As shown in FIG. 18, the first side frame 210 further includes a fifth position 215. The first position 211 is located between the second position 212 and the fifth position 215. The first side frame 210 is coupled to the ground 300 at the fifth position 215.

The antenna 200 may further include a third parasitic stub 243. The third parasitic stub 243 is a conductive part of the first side frame 210 between the first position 211 and the fifth position 215. At least a part of the third parasitic stub 243 is spaced from the ground 300. In an embodiment, a first end of the third parasitic stub 243 is a grounding end, and a second end is an open end.

The third parasitic stub 243 is configured to generate a third parasitic resonance, and the first resonance and the third parasitic resonance jointly support the satellite communication frequency band. In an embodiment, the resonance frequency band of the first resonance may include a transmit frequency band in satellite communication, and a resonance frequency band of the third parasitic resonance may include a receive frequency band in satellite communication.

It should be understood that a difference between the antenna 200 shown in FIG. 18 and the antenna 200 shown in FIG. 9 lies in only the third parasitic stub 243. In the antenna 200 shown in FIG. 9, no third parasitic stub 243 is disposed, and only the first radiator 231 and the first parasitic stub jointly generate the first resonance. In the antenna 200 shown in FIG. 18, the conductive part of the first side frame 210 between the first position 211 and the fifth position 215 is used as the third parasitic stub 243. The third parasitic stub 243 may be configured to generate the third parasitic resonance, to expand an operating frequency band of the antenna 200.

In an embodiment, a length L4 of the third parasitic stub 243 (a length of the first side frame 210 between the first position 211 and the fifth position 215) and the length L1 of the first radiator 231 (the length of the first side frame 210 between the first position 211 and the second position 212) satisfy: $L1 \times 40\% \leq L4 \leq L1 \times 90\%$.

For brevity of description, parts of the antenna 200 shown in FIG. 18 similar to those of the antennas 200 shown in FIG. 9 and FIG. 16 are not described one by one again. For example, the similar parts include: a position of the first radiator 231, a position of the first parasitic stub 241, and a relative position between the first radiator 231 and the first parasitic stub 241; the satellite communication frequency band; the first resonance jointly generated by the first radiator 231 and the first parasitic stub 241; a position of the first feed point 251 and a position of the first connection point 221; and the like.

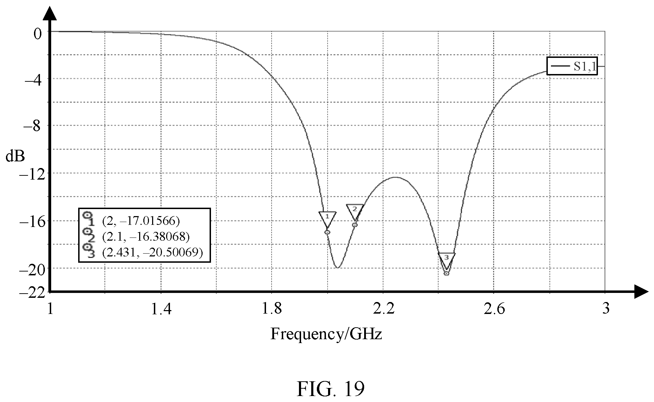

FIG. 19 shows a simulation result of an S parameter of the antenna 200 when the foldable electronic device 100 shown in FIG. 18 is in an unfolded state.

As shown in FIG. 19, the antenna may generate resonances near 2 GHz and near 2.4 GHz.

The resonance generated near 2 GHz may correspond to the first resonance in the foregoing embodiments, and the resonance generated near 2.4 GHz may correspond to the third parasitic resonance in the foregoing embodiments.

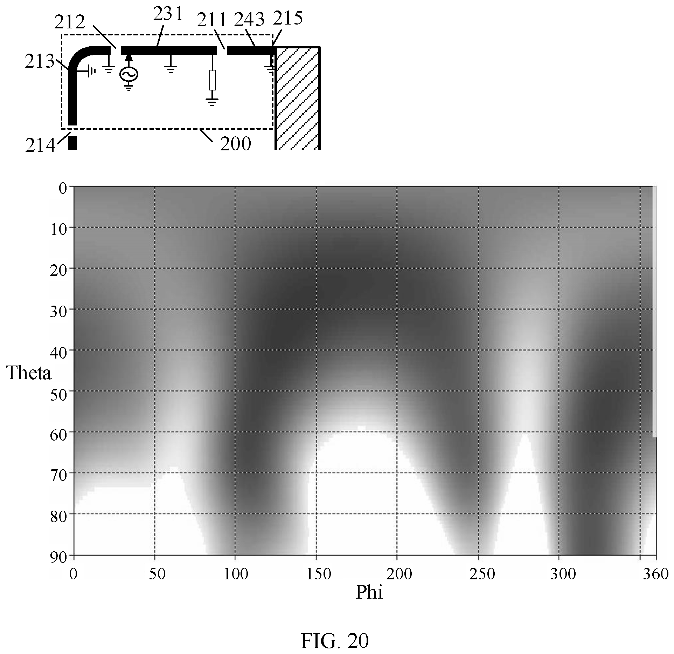

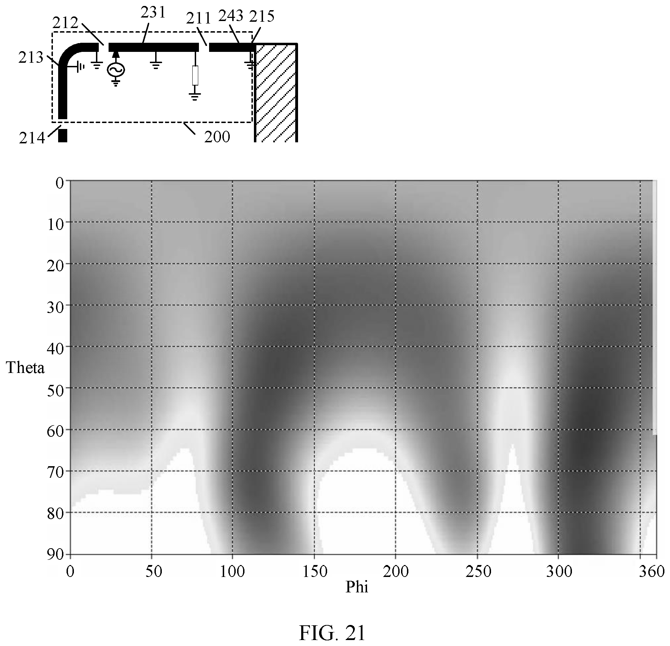

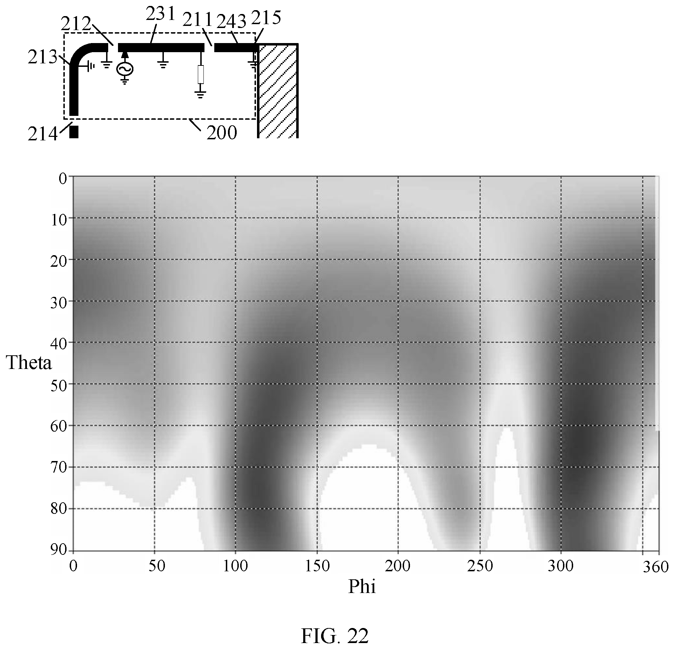

FIG. 20 to FIG. 22 are radiation patterns of the antenna 200 when the foldable electronic device 100 shown in FIG. 18 is in an unfolded state. FIG. 20 is a radiation pattern of the antenna 200 in the foldable electronic device 100 shown in FIG. 18 at 2 GHz. FIG. 21 is a radiation pattern of the antenna 200 in the foldable electronic device 100 shown in FIG. 18 at 2.1 GHz. FIG. 22 is a radiation pattern of the antenna 200 in the foldable electronic device 100 shown in FIG. 18 at 2.2 GHz.

The z direction (Theta=0°, Phi=180°) is the first direction pointing from the bottom of the foldable electronic device 100 to the top of the foldable electronic device 100.

As shown in FIG. 20 to FIG. 22, when the foldable electronic device is in the unfolded state, with a gain being greater than or equal to -6 dBic as a limit, the antenna 200 satisfies a communication requirement when Theta is within 60°, and the antenna 200 has a wide beam characteristic.

It should be understood that the first parasitic resonance generated by the first parasitic stub 241 is near the first resonance (near 2 GHz), but radiation toward the left side (Phi≥180°) of the first direction may also be generated at 2.1 GHz and 2.2 GHz, so that the radiation pattern does not have a dip, and the antenna 200 has a wide beam characteristic in a relatively wide frequency band.

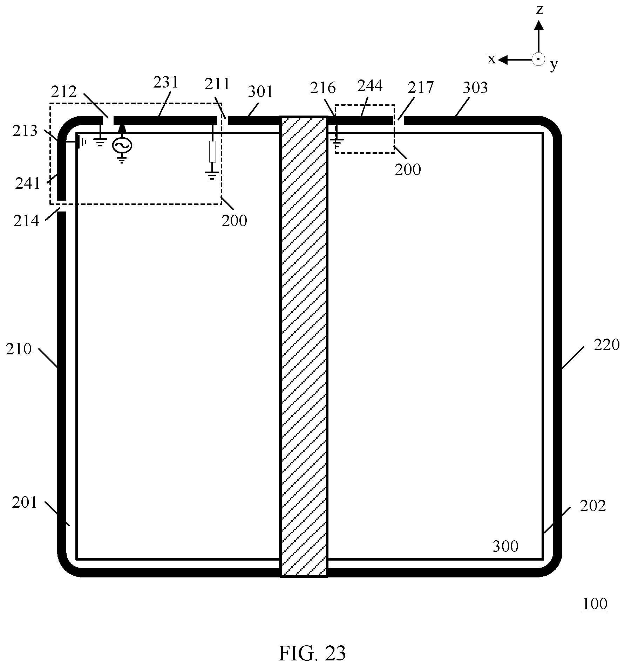

FIG. 23 is a diagram of a foldable electronic device 100 according to an embodiment of this application.

As shown in FIG. 23, a third edge 303 of the second side frame 220 includes a sixth position 216 and a seventh position 217. The second side frame 220 is coupled to the ground 300 at the sixth position 216.

The second side frame 220 is provided with a fourth insulation gap at the seventh position 217. When the foldable electronic device 100 is in the unfolded state, the first edge 301 and the third edge 303 are a top edge or a bottom edge of the foldable electronic device 100.

It should be understood that, for brevity of description, in this embodiment of this application, only an example in which the first edge 301 and the third edge 303 are the top edge of the foldable electronic device 100 is used for description.

In an embodiment, the foldable electronic device 100 is in the unfolded state, and the sixth position 216 is located between the first position 211 and the seventh position 217.

It should be understood that, for brevity of description, in this embodiment of this application, only an example in which the sixth position 216 is located between the first position 211 and the seventh position 217 is used for description. In actual production or design, the seventh position 217 may be located between the first position 211 and the sixth position 216.

The antenna 200 may further include a fourth parasitic stub 244. The fourth parasitic stub 244 is a conductive part of the second side frame 220 between the sixth position 216 and the seventh position 217. At least a part of the fourth parasitic stub 244 is spaced from the ground 300. In an embodiment, a first end of the fourth parasitic stub 244 is a grounding end, and a second end is an open end.

It should be understood that a difference between the antenna 200 shown in FIG. 23 and the antenna 200 shown in FIG. 9 lies in only the fourth parasitic stub 244. In the antenna 200 shown in FIG. 9, no parasitic stub is disposed on the second side frame 220 of the second housing 202. In the antenna 200 shown in FIG. 23, the conductive part of the second side frame 220 between the sixth position 216 and the seventh position 217 is used as the fourth parasitic stub 244. When the foldable electronic device 100 is in the unfolded state, the fourth parasitic stub 244 is configured to reduce impact of the current on the ground 300 on the main resonance of the first radiator 231, so as to adjust strength of radiation generated by the main resonance that deviates toward the right side of the first direction (a side that is of the first direction and that faces the hinge 203).

In an embodiment, the fourth parasitic stub 244 may be configured to generate a fourth parasitic resonance.

It should be understood that, when the fourth parasitic resonance approaches the first resonance, the strength of the radiation generated by the main resonance that deviates toward the right side of the first direction (the side that is of the first direction and that faces the hinge 203) decreases. Through adjustment of a frequency difference between the fourth parasitic resonance and the first resonance, a radiation pattern generated by the antenna 200 on the right side of the first direction (the side that is of the first direction and that faces the hinge 203) may have different characteristics, so that strength of the radiation pattern on the right side of the first direction (the side that is of the first direction and that faces the hinge 203) is flexibly adjusted, thereby implementing a wide beam characteristic of the antenna 200.

For brevity of description, parts of the antenna 200 shown in FIG. 23 similar to those of the antennas 200 shown in FIG. 9, FIG. 16, and FIG. 18 are not described one by one again. For example, the similar parts include: a position of the first radiator 231, a position of the first parasitic stub 241, and a relative position between the first radiator 231 and the first parasitic stub 241; the satellite communication frequency band; the first resonance jointly generated by the first radiator 231 and the first parasitic stub 241; a position of the first feed point 251 and a position of the first connection point 221; and the like.

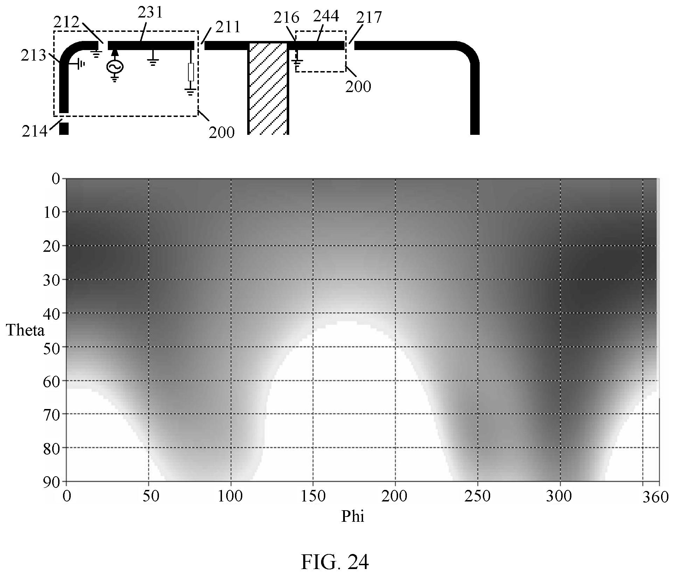

FIG. 24 is a radiation pattern of the antenna 200 in the foldable electronic device 100 shown in FIG. 23 at 2 GHz.

The z direction (Theta=0°, Phi=180°) is the first direction pointing from the bottom of the foldable electronic device 100 to the top of the foldable electronic device 100.

As shown in FIG. 24, the fourth parasitic stub 244 is disposed. When the foldable electronic device is in the unfolded state, the fourth parasitic stub 244 may suppress a current (a transverse traveling wave) on the ground on a side of the second housing, and reduce impact of the current on the ground on the main resonance of the first radiator 231, so that radiation generated by the main resonance does not greatly deviate toward the right side of the first direction (for example, an area of 0°≤Phi≤180° in the radiation pattern shown in FIG. 24).

Because the radiation generated by the main resonance does not greatly deviate toward the right side of the first direction, when the foldable electronic device is in the unfolded state, radiation strength of the antenna 200 on the right side of the first direction (for example, an area of 180°≤Phi≤360° in the radiation pattern shown in FIG. 24) increases. Therefore, a radiation characteristic of the antenna 200 on the right side of the first direction (the side that is of the first direction and that faces the hinge 203) may be adjusted by using the fourth parasitic stub 244, so that the antenna 200 has a wide beam characteristic.

The second parasitic stub 242 enhances a radiation characteristic of the first parasitic stub 241, so that strength of radiation generated by the first parasitic stub 241 that deviates toward the left side of the first direction (for example, an area of 180°≤Phi≤360° in the radiation pattern shown in FIG. 24) increases.

It should be understood that, the second electronic element may be configured to adjust a coupling amount between the second parasitic stub and the first radiator, and adjust a current flowing to the first parasitic stub, so as to change the strength of the radiation generated by the first parasitic stub that deviates toward the left side of the first direction, thereby determining a wide beam characteristic of the antenna 200.

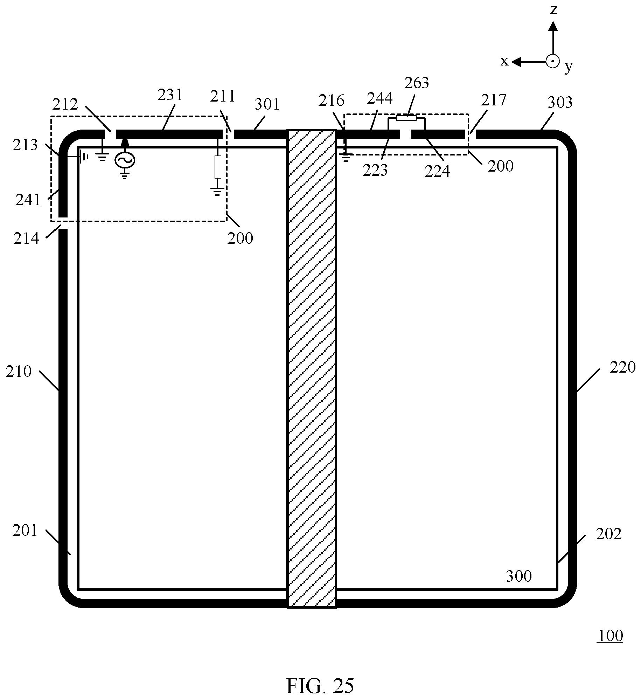

FIG. 25 is a diagram of a foldable electronic device 100 according to an embodiment of this application.

As shown in FIG. 25, the antenna 200 further includes a third electronic element 263. The fourth parasitic stub 244 includes a third connection point 223 and a fourth connection point 224. The third electronic element 263 is coupled between the third connection point 223 and the fourth connection point 224. The fourth parasitic stub 244 is provided with a fifth insulation gap between the third connection point 223 and the fourth connection point 224.

It should be understood that the fourth parasitic stub 244 is provided with the fifth insulation gap. The fifth insulation gap may be considered as an equivalent capacitor (for example, a distributed capacitor) disposed on the fourth parasitic stub 244. The equivalent capacitor may enable the fourth parasitic stub 244 to form a metamaterial structure. A radiation aperture of the fourth parasitic stub 244 having the metamaterial structure may be increased, and after the fifth insulation gap is provided, an electric field is more dispersive, and a dielectric loss near a conductor is reduced. Therefore, total efficiency and radiation efficiency of the antenna 200 can be effectively improved. Through the third electronic element 263 that is coupled between the third connection point 223 and the fourth connection point 224, an equivalent capacitance of the fifth insulation gap can be adjusted, to adjust a radiation characteristic (for example, a resonance point frequency of the fourth parasitic resonance generated by the fourth parasitic stub 244) of the antenna 200.

It should be understood that, a difference between the antenna 200 shown in FIG. 25 and the antenna 200 shown in FIG. 23 lies only in that the fifth insulation gap is provided between the third connection point 223 and the fourth connection point 224 and the third electronic element 263 is connected in series. In the antenna 200 shown in FIG. 23, each fourth parasitic stub 244 is in a structure similar to an IFA in which one end is a grounding end and the other end is an open end, and each fourth parasitic stub 244 operates in a quarter wavelength mode. In the antenna 200 shown in FIG. 25, the fourth parasitic stub 244 forms a metamaterial structure, and a length of the fourth parasitic stub 244 is greater than a length of the fourth parasitic stub 244 shown in FIG. 23.

In an embodiment, the fourth parasitic stub 244 includes a fifth connection point. The antenna 200 further includes a fourth electronic element, and the fourth electronic element is coupled between the fifth connection point and the ground 300.

It should be understood that the fourth parasitic stub 244 is electrically connected to the ground 300 at the fifth connection point through the fourth electronic element, so that when the fourth parasitic stub 244 generates the fourth parasitic resonance, a current on the fourth parasitic stub 244 is shunted in an area near the fifth connection point. Because the current is shunted in the area near the fifth connection point, current density on the fourth parasitic stub 244 may be dispersed. In an embodiment, current distribution on the fourth parasitic stub 244 is more dispersed, thereby reducing a conductor loss of the fourth parasitic stub 244. In an embodiment, current distribution on the fourth parasitic stub 244 is more dispersed, so that a radiation aperture of the fourth parasitic stub 244 may be increased. Because the conductor loss of the fourth parasitic stub 244 is reduced, and a radiation aperture of the antenna 200 is increased, total efficiency and radiation efficiency of the antenna can be improved.

In an embodiment, in the antenna 200 shown in FIG. 23, an electrical length of the fourth parasitic stub 244 is a quarter of a first wavelength, and the first wavelength may be a wavelength corresponding to the fourth parasitic resonance generated by the fourth parasitic stub 244. In an embodiment, in the antenna 200 shown in FIG. 25, an electrical length of the fourth parasitic stub 244 is greater than three eighths of the first wavelength. In the antenna 200 shown in FIG. 25, a parasitic resonance of the fourth parasitic stub 244 may correspond to a quarter wavelength mode. Through the fifth insulation gap, the electrical length of the fourth parasitic stub 244 may be greater than three eighths of the first wavelength, the current on the fourth parasitic stub 244 is in a same direction (for example, is not reversed), and an electric field between the fourth parasitic stub 244 and the ground is not reversed. The electrical length of the fourth parasitic stub 244 increases from a quarter of the first wavelength to more than three eighths of the first wavelength, but the fourth parasitic stub 244 still operates in the quarter wavelength mode. In this case, current density on the fourth parasitic stub 244 is dispersed, and electric field density between the fourth parasitic stub 244 and the ground 300 is reduced, thereby reducing a conductor loss and a dielectric loss caused by the fourth parasitic stub 244 and a conductor and a medium disposed around the fourth parasitic stub 244, and improving a radiation characteristic of the antenna 200. The fourth parasitic stub 244 increases a radiation aperture, thereby effectively improving total efficiency and radiation efficiency of the antenna 200.

The first wavelength may be understood as a vacuum wavelength corresponding to a resonance point of the parasitic resonance, or may be understood as a vacuum wavelength corresponding to a center frequency of a resonance frequency band of the parasitic resonance. Because there is a specific correspondence between a vacuum wavelength and a medium wavelength, the foregoing proportion may be converted into the medium wavelength. Details are not described in this application.

In an embodiment, the third electronic element 263 may include an inductor or an electronic element equivalent to a capacitor.

In an embodiment, an equivalent inductance of the third electronic element 263 may be less than or equal to 10 nH.

In an embodiment, the fourth electronic element may include a capacitor or an electronic element equivalent to a capacitor.

In an embodiment, an equivalent capacitance of the fourth electronic element may be less than or equal to a first threshold. The first threshold may be designed based on a resonance point frequency of the parasitic resonance generated by the fourth parasitic stub 244. When the resonance point frequency of the parasitic resonance is less than or equal to 1 GHz, the first threshold is 10 pF. When the resonance point frequency of the parasitic resonance is greater than 1 GHz, the first threshold is 2 pF.

It should be understood that, an equivalent inductance of the third electronic element 263 and an equivalent capacitance of the fourth electronic element are designed based on frequencies of resonance points of different parasitic resonances, so that current distribution on the fourth parasitic stub 244 can be more dispersed, a conductor loss can be reduced, and a radiation aperture of the fourth parasitic stub 244 can be increased, thereby improving a radiation characteristic (for example, radiation efficiency and total efficiency) of the antenna.

In an embodiment, a distance between the third connection point 223 and/or the fourth connection point 224 and the fifth insulation gap is less than or equal to 5 mm.

The distance between the third connection point 223 and the fifth insulation gap and/or the distance between the fourth connection point 224 and the fifth insulation gap may be understood as a minimum distance between the third connection point 223 and conductors on two sides of the fifth insulation gap and/or a minimum distance between the fourth connection point 224 and the conductors on the two sides of the fifth insulation gap (a length of the fourth parasitic stub 244 between the third connection point 223 and the fifth insulation gap and/or a length of the fourth parasitic stub 244 between the fourth connection point 224 and the fifth insulation gap). When the third electronic element 263 is electrically connected to the third connection point 223 and/or the fourth connection point 224 through a connection member (for example, a metal spring), the distance to the fifth insulation gap may be understood as a minimum distance between a center of a part that is of the connection member and that is in contact with the connection point and the conductors on the two sides of the fifth insulation gap.

In an embodiment, the fifth connection point coincides with the third connection point 223 and/or the fourth connection point 224.

In an embodiment, when a length of the fourth parasitic stub 244 between the fifth connection point and the third connection point 223 and/or the fourth connection point 224 is less than or equal to 5 mm, a radiation aperture of the fourth parasitic stub 244 may be better adjusted, to improve a radiation characteristic of the antenna 200.

For brevity of description, parts of the antenna 200 shown in FIG. 25 similar to those of the antenna 200 shown in FIG. 23 are not described one by one again. For example, the similar parts include: a position of the fourth parasitic stub 244, a position of the first radiator 231, a position of the first parasitic stub 241, and a relative position between the first radiator 231 and the first parasitic stub 241; the satellite communication frequency band; the first resonance jointly generated by the first radiator 231 and the first parasitic stub 241; a position of the first feed point 251 and a position of the first connection point 221; and the like.

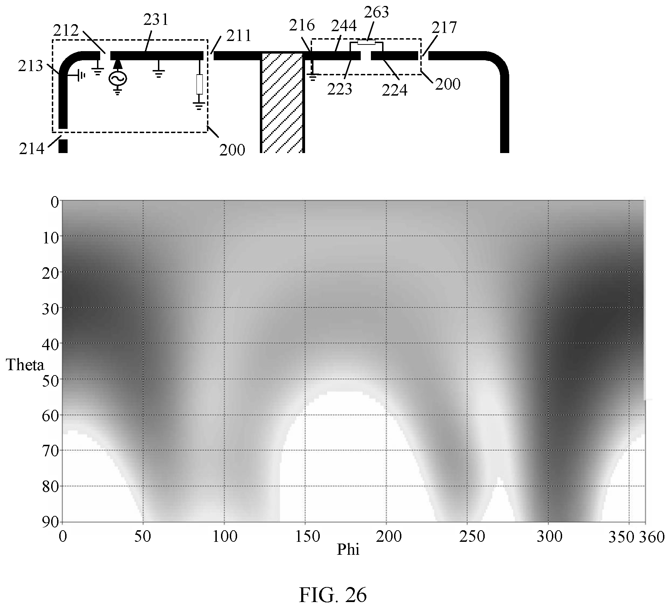

FIG. 26 is a radiation pattern of the antenna 200 in the foldable electronic device 100 shown in FIG. 25 at 2 GHz.

As shown in FIG. 26, the fourth parasitic stub 244 is of a metamaterial structure, and can still suppress a current (a transverse traveling wave) on the ground on a side of the second housing, and reduce impact of the current on the ground on the main resonance of the first radiator 231, so that radiation generated by the main resonance does not greatly deviate toward the right side of the first direction (for example, an area of 0°≤Phi≤180° in the radiation pattern shown in FIG. 26).

Because the radiation generated by the main resonance does not greatly deviate toward the right side of the first direction, when the foldable electronic device is in the unfolded state, radiation strength of the antenna 200 on the left side of the first direction (for example, an area of 180°≤Phi≤360° in the radiation pattern shown in FIG. 24) increases. Therefore, a radiation characteristic of the antenna 200 on the right side of the first direction may be adjusted by using the fourth parasitic stub 244, so that the antenna 200 has a wide beam characteristic.

The second parasitic stub 242 enhances a radiation characteristic of the first parasitic stub 241, so that strength of radiation generated by the first parasitic stub 241 that deviates toward the left side of the first direction (for example, an area of 180°≤Phi≤360° in the radiation pattern shown in FIG. 24) increases.

It should be understood that, the second electronic element may be configured to adjust a coupling amount between the second parasitic stub and the first radiator, and adjust a current flowing to the first parasitic stub, so as to change the strength of the radiation generated by the first parasitic stub that deviates toward the left side of the first direction, thereby determining a wide beam characteristic of the antenna 200.

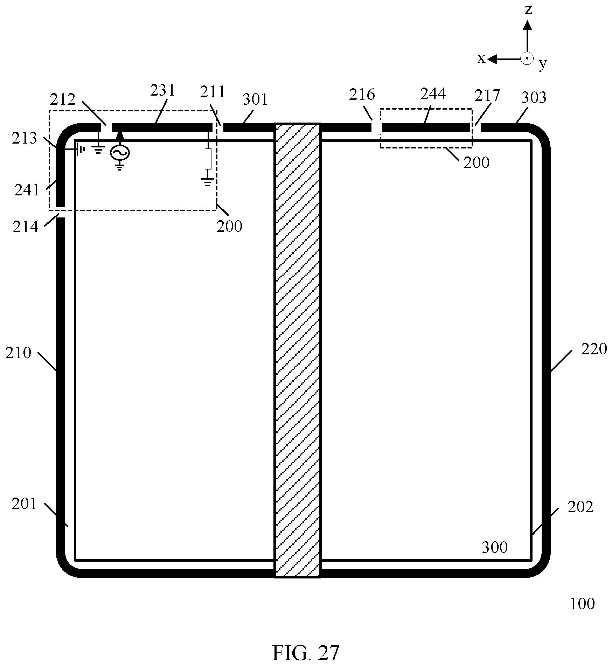

FIG. 27 is a diagram of a foldable electronic device 100 according to an embodiment of this application.

As shown in FIG. 27, the second side frame 220 is provided with a fifth insulation gap and a fourth insulation gap at the sixth position 216 and the seventh position 217. When the foldable electronic device 100 is in the unfolded state, the first edge 301 and the third edge 303 are a top edge or a bottom edge of the foldable electronic device 100.

The antenna 200 may further include a fourth parasitic stub 244. The fourth parasitic stub 244 is a conductive part of the second side frame 220 between the sixth position 216 and the seventh position 217. At least a part of the fourth parasitic stub 244 is spaced from the ground 300. In an embodiment, a first end and a second end of the fourth parasitic stub 244 are open ends.

In an embodiment, the fourth parasitic stub 244 may be configured to generate a fourth parasitic resonance.

It should be understood that, when the fourth parasitic resonance approaches the first resonance, the strength of the radiation generated by the main resonance that deviates toward the right side of the first direction (the side that is of the first direction and that faces the hinge 203) decreases. Through adjustment of a frequency difference between the fourth parasitic resonance and the first resonance, a radiation pattern generated by the antenna 200 on the right side of the first direction (the side that is of the first direction and that faces the hinge 203) may have different characteristics, so that strength of the radiation pattern on the right side of the first direction (the side that is of the first direction and that faces the hinge 203) is flexibly adjusted, thereby implementing a wide beam characteristic of the antenna 200.

It should be understood that a difference between the antenna 200 shown in FIG. 27 and the antennas 200 shown in FIG. 23 and FIG. 25 lies only in that the second side frame 220 is provided with the fifth insulation gap at the sixth position 216. In the antennas 200 shown in FIG. 23 and FIG. 25, each fourth parasitic stub 244 is in a structure in which one end is a grounding end and the other end is an open end, and each fourth parasitic stub 244 operates in a quarter wavelength mode. In the antenna 200 shown in FIG. 27, the first end and the second end of the fourth parasitic stub 244 are open ends, and a structure similar to a dipole (dipole) antenna may be formed. The fourth parasitic stub 244 operates in a half wavelength mode.

For brevity of description, parts of the antenna 200 shown in FIG. 27 similar to those of the antennas 200 shown in FIG. 23 and FIG. 25 are not described one by one again. For example, the similar parts include: a position of the fourth parasitic stub 244, a position of the first radiator 231, a position of the first parasitic stub 241, and a relative position between the first radiator 231 and the first parasitic stub 241; the satellite communication frequency band; the first resonance jointly generated by the first radiator 231 and the first parasitic stub 241; a position of the first feed point 251 and a position of the first connection point 221; and the like.

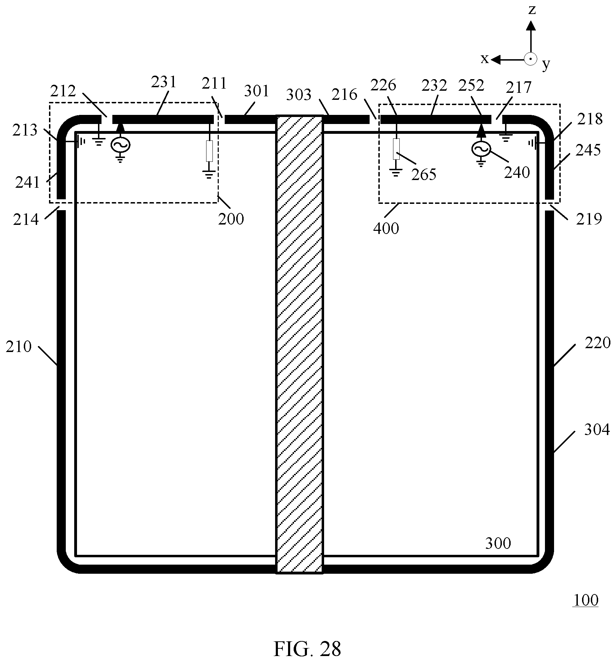

FIG. 28 is a diagram of a foldable electronic device 100 according to an embodiment of this application.

As shown in FIG. 28, the second side frame 220 includes a sixth position 216, a seventh position 217, an eighth position 218, and a ninth position 219 that are sequentially provided. The second side frame 220 is provided with a fourth insulation gap, a fifth insulation gap, and a sixth insulation gap at the sixth position 216, the seventh position 217, and the ninth position 219 respectively. The second side frame 220 is coupled to the ground 300 at the eighth position 218.

The sixth position 216 and the seventh position 217 are located on a third edge 303 of the second side frame 220, and the eighth position 218 and the ninth position 219 are located on a fourth edge 304. The third edge 303 and the fourth edge 304 intersect at a corner. In an embodiment, a length of the third edge 303 is less than a length of the fourth edge 304.

In an embodiment, when the foldable electronic device 100 is in the unfolded state, the first edge 301 and the third edge 303 are a top edge or a bottom edge of the foldable electronic device 100.

It should be understood that, for brevity of description, in this embodiment of this application, only an example in which the first edge 301 and the third edge 303 are the top edge of the foldable electronic device 100 is used for description.

The foldable electronic device 100 may further include an antenna 400. The antenna 400 includes a second radiator 232, a fifth parasitic stub 245, a second feed circuit 240, and a fifth electronic element 265.

The second radiator 232 is a conductive part of the second side frame 220 between the sixth position 216 and the seventh position 217. The fifth parasitic stub 245 is a conductive part of the second side frame 220 between the eighth position 218 and the ninth position 219. In an embodiment, a first end and a second end of the second radiator 232 are open ends. A first end of the fifth parasitic stub 245 is a grounding end, and a second end is an open end.

The second radiator 232 includes a second feed point 252 and a sixth connection point 226. The second feed circuit 240 is coupled to the second feed point 252. The fifth electronic element 265 is coupled between the sixth connection point 226 and the ground 300. The second feed point 252 and the sixth connection point 226 are respectively located on two sides of a virtual axis of the second radiator 232, and the second radiator 232 has a same length on the two sides of the virtual axis.

An operating frequency band of the antenna 400 may include a satellite communication frequency band. When the foldable electronic device 100 is in the unfolded state, the second radiator 232 and the fifth parasitic stub 245 are configured to jointly generate a second resonance, and a resonance frequency band of the second resonance includes the satellite communication frequency band.

It should be understood that a difference between the antenna 200 shown in FIG. 28 and the antennas 200 shown in FIG. 9, FIG. 16, and FIG. 18 lies only in the antenna 400. In the foldable electronic device 100 shown in FIG. 28, the antenna 400 may be any one of the antennas 200 shown in FIG. 9, FIG. 16, and FIG. 18.

In addition, the antenna 200 and the antenna 400 shown in FIG. 28 may have a same antenna structure, or may have different antenna structures. This is not limited in embodiments of this application, and may be determined based on actual production or design. For brevity of description, in the foldable electronic device 100 shown in FIG. 28, only an example in which the antenna 200 and the antenna 400 are the antenna 200 shown in FIG. 9 is used for description.

According to embodiments of this application, both the antenna 200 and the antenna 400 may operate in the satellite communication frequency band. According to the foregoing embodiments, both the antenna 200 and the antenna 400 have a wide beam characteristic, and therefore, a radiation pattern generated by the antenna 200 and a radiation pattern generated by the antenna 400 may be superimposed, so that the foldable electronic device 100 has better satellite communication performance.

In an embodiment, when the foldable electronic device 100 is in a folded state, the first insulation gap provided on the first side frame 210 is aligned with the fourth insulation gap provided on the second side frame 220, and/or the second insulation gap provided on the first side frame 210 is aligned with the fifth gap provided on the second side frame 220, and/or the third insulation gap provided on the first side frame 210 is aligned with the sixth insulation gap provided on the second side frame 220, to improve aesthetic appeal of the foldable electronic device 100.

It should be understood that, in embodiments of this application, alignment may be understood as that two gaps at least partially overlap in a thickness direction of the foldable electronic device 100.

In an embodiment, when the foldable electronic device 100 is in a folded state, the first radiator 231 and the second radiator 232 at least partially overlap in a thickness direction of the foldable electronic device, and/or the first parasitic stub 241 and the fifth parasitic stub 245 at least partially overlap in the thickness direction of the foldable electronic device, to improve aesthetic appeal of the foldable electronic device 100.

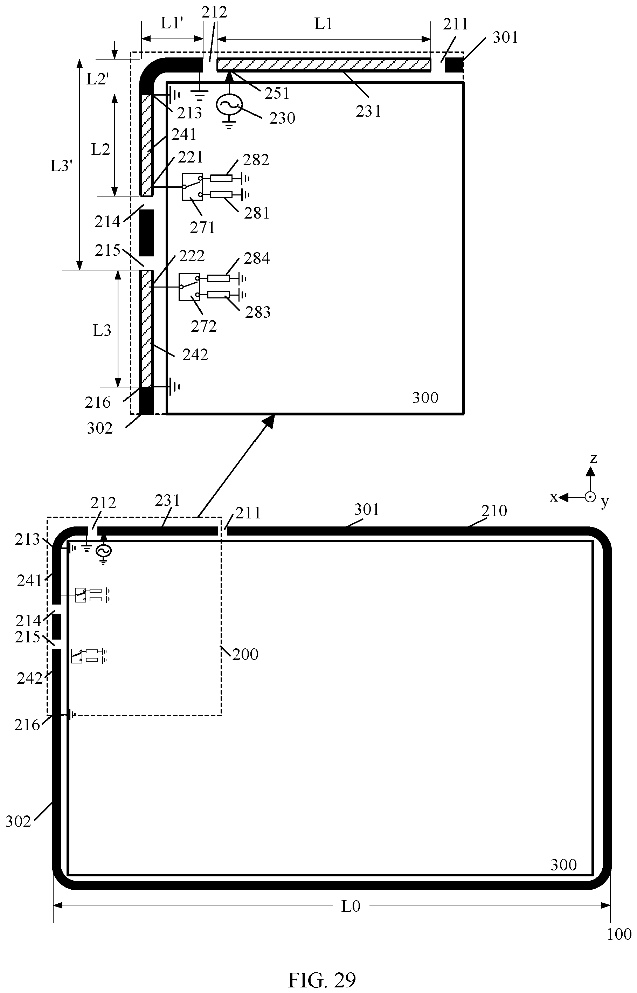

FIG. 29 is a diagram of an electronic device 100 according to an embodiment of this application.

It should be understood that, in the foregoing embodiments, an example in which the electronic device 100 is a foldable electronic device is used for description. In actual production or design, the technical solutions in embodiments of this application may also be applied to another type of electronic device 100 that includes a large-sized ground. A difference between the electronic device 100 shown in FIG. 29 and subsequent embodiments and the electronic device 100 shown in FIG. 9 to FIG. 28 lies only in a form of the electronic device. Similar parts are not described one by one again. For example, the similar parts include: a related parameter of an insulation gap provided on a side frame; a satellite communication frequency band; and an efficiency dip generated in an operating frequency band by a parasitic resonance generated by a parasitic stub.

As shown in FIG. 29, the electronic device 100 may include a first side frame 210, and at least a part of the first side frame 210 is spaced from a ground 300.

The first side frame 210 includes a first edge 301 and a second edge 302 that intersect at a corner.

The first edge 301 includes a first position 211 and a second position 212. The first side frame 210 has a first insulation gap and a second insulation gap at the first position 211 and the second position 212 respectively.

The second edge 302 includes a third position 213 and a fourth position 214. The first side frame 210 is coupled to the ground 300 at the third position 213. The first side frame 210 has a third insulation gap at the fourth position 214.

The electronic device 100 may further include an antenna 200. The antenna 200 includes a first radiator 231, a first parasitic stub 241, a second parasitic stub 242, a first feed circuit 230, a first switch 271, a second switch 272, a first switch branch 281, a second switch branch 282, a third switch branch 283, and a fourth switch branch 284.

The first radiator 231 is a conductive part of the first side frame 210 between the first position 211 and the second position 212. In an embodiment, at least a part of the first radiator 231 is spaced from the ground 300. In an embodiment, a first end and a second end of the first radiator 231 are open ends.

The first parasitic stub 241 is a conductive part of the first side frame 210 between the third position 213 and the fourth position 214. In an embodiment, at least a part of the first parasitic stub 241 is spaced from the ground 300. In an embodiment, a first end of the first parasitic stub 241 is a grounding end, and a second end is an open end.

The antenna 200 further includes the first feed circuit 230. The first radiator 231 includes a first feed point 251. The first feed circuit 230 is coupled to the first feed point 251.

In an embodiment, a length L0 of the first edge 301 and a length L1 of the first radiator 231 satisfy: $2 \times L1 \leq L0$. In an embodiment, a length L0 of the first edge 301 and a length L1 of the first radiator 231 satisfy: $2.5 \times L1 \leq L0$. In an embodiment, a length L0 of the first edge 301 and a length L1 of the first radiator 231 satisfy: $3 \times L1 \leq L0$.

It should be understood that the length L0 of the first edge 301 may be understood as a dimension of the electronic device 100 in an extension direction (for example, an x direction) of the first edge 301. A proportional relationship between the length L0 of the first edge 201 and the length L1 of the first radiator 231 may also be understood as a proportional relationship between a dimension L0' of the ground 300 in the extension direction (for example, the x direction) of the first edge 301 and the length L1 of the first radiator 231. For example, $2 \times L1 \leq L0'$, $2.5 \times L1 \leq L0'$, or $3 \times L1 \leq L0'$.

In an embodiment, a distance L1' between the second position 212 and the second edge 302 and the length L1 of the first radiator 231 satisfy: $L1' \leq L1 \times 0.5$.

It should be understood that the distance L1' between the second position 212 and the second edge 302 may be understood as a distance between the second position 212 and the second edge 302 in the extension direction (for example, the x direction) of the first edge 301. For brevity of description, a distance from an edge described in embodiments of this application may be accordingly understood.

The first radiator 231 is configured to generate a first resonance. A resonance frequency band of the first resonance includes a satellite communication frequency band.

In an embodiment, the resonance frequency band of the first resonance may include a transmit frequency band in the satellite communication frequency band, for example, one of a transmit frequency band (1980 MHz to 2010 MHz) in a Tiantong satellite system, a transmit frequency band (1610 MHz to 1626.5 MHz) in a BeiDou satellite system, and a transmit frequency band (2500 MHz to 2520 MHz) in a low-earth-orbit satellite system. In an embodiment, the resonance frequency band of the first resonance may include a receive frequency band in the satellite communication frequency band, for example, one of a receive frequency band (2170 MHz to 2200 MHz) in a Tiantong satellite system, a receive frequency band (2483.5 MHz to 2500 MHz) in a BeiDou satellite system, and a receive frequency band (2670 MHz to 2690 MHz) in a low-earth-orbit satellite system.

The first radiator 231 and the first parasitic stub 241 are configured to generate a radiation pattern of the antenna 200.

According to embodiments of this application, when a length of the first edge 301 is relatively long ($2 \times L1 \leq L0$), and the first radiator 231 is disposed close to the second edge 302 ($L1' \leq L1 \times 0.5$), the first parasitic stub 241 enables the radiation pattern generated by the antenna 200 to deflect toward a side of the first parasitic stub 241, so that the radiation pattern generated by the antenna 200 is not affected by the ground 300. Because the radiation pattern generated by the antenna 200 is not affected by the ground 300, a maximum radiation direction of the radiation pattern generated by the antenna 200 and a top direction (a direction perpendicular to the extension direction of the first edge 301, for example, a z direction) of the electronic device 100 do not have a large angle difference (for example, the angle difference is less than or equal to 30°). Therefore, a communication satellite may always be located in an area in which the antenna 200 has a good radiation characteristic (for example, the maximum radiation direction of the radiation pattern generated by the antenna at least partially overlaps a target radiation direction), to maintain a satellite-aligned state with the communication satellite, thereby effectively improving user experience.

In an embodiment, the second edge 302 further includes a fifth position 215 and a sixth position 216. The first side frame 210 is coupled to the ground 300 at the sixth position 216. The first side frame 210 has a fourth insulation gap at the fifth position 215.

In an embodiment, the antenna 200 further includes a second parasitic stub 242. The first radiator 241, the first parasitic stub 241, and the second parasitic stub 242 may be configured to generate a radiation pattern of the antenna 200.

The second parasitic stub 241 is a conductive part of the first side frame 210 between the fifth position 215 and the sixth position 216. At least a part of the second parasitic stub 242 is spaced from the ground 300. In an embodiment, a first end of the second parasitic stub 242 is a grounding end, and a second end is an open end.

It should be understood that, the first parasitic stub 241 and the second parasitic stub 242 may adjust the radiation pattern generated by the antenna 200, so that the radiation pattern of the antenna 200 has a more flexible adjustment range.

In an embodiment, the antenna 200 further includes the first switch 271, the second switch 272, the first switch branch 281, the second switch branch 282, the third switch branch 283, and the fourth switch branch 284.

The first parasitic stub 241 includes a first connection point 221. The first switch branch 281 and the second switch branch 282 are coupled between the ground 300 and the first connection point 211 through the first switch 271.

It should be understood that, that the first switch branch 281 and the second switch branch 282 are coupled between the ground 300 and the first connection point 221 through the first switch 271 may be understood as that the first switch branch 281 and the second switch branch 282 are coupled between the first switch 271 and the first connection point 221, or the first switch branch 281 and the second switch branch 282 are coupled between the first switch 271 and the ground 300. For brevity of description, that a switch branch is coupled between a connection point and the ground 300 through a switch in embodiments of this application may be accordingly understood, and details are not described one by one.

The "switch" in this application may include one or more switch components, and the "first connection point", the "second connection point", the "third connection point", and the like in this application each may include one or more connection points. In an embodiment, one switch branch may be coupled between the ground 300 and a parasitic stub through one switch component in a switch and one connection point in connection points, and another switch branch may be coupled between the ground 300 and the parasitic stub through another switch component in the switch and another connection point in the connection points. In embodiments of this application, a switch is used only for switching to different switch branches coupled to a radiator, and a specific position and a specific form of the switch are not limited.

In embodiments of this application, a switch branch may be understood as a circuit between a switch and a connection point (for example, the first connection point 211) or the ground 300, and the switch can be used for switching to different switch branches, so that different equivalent capacitors, equivalent resistors, or equivalent inductors are coupled to the connection point.

In an embodiment, the switch branch may include one or more electronic elements, and a plurality of electronic elements may be connected in series or in parallel to implement different equivalent capacitances and/or equivalent inductances and/or equivalent resistances. In an embodiment, the switch branch may also include a switch, and equivalent capacitances and/or equivalent inductances and/or equivalent resistances in different states of the switch branch are switched by using the switch.

In an embodiment, the switch branch may not include an electronic element. The switch branch may be configured to determine a boundary condition at the first connection point. For example, the switch branch is in an open-circuit state. When a common port of the switch is connected to the switch branch, the first connection point 221 is in an open-circuit state (not coupled to the ground 300 through a component). Alternatively, the switch branch is in a short-circuited state. When a common port of the switch is connected to the switch branch, the first connection point 221 is in a short-circuited state (electrically connected to a stub on the ground 300, where no other electronic element is disposed). For brevity of description, in the electronic device 100 shown in FIG. 29, only an example in which the switch branch includes an equivalent electronic element is used for description, and details are not described one by one.

It should be understood that, for brevity of description, the switch branch described in embodiments of this application may be accordingly understood, and details are not described again.

The second parasitic stub 242 includes a second connection point 222. The third switch branch 283 and the fourth switch branch 284 are coupled between the ground 300 and the second connection point 200 through the second switch 272.

The first radiator 231, the first parasitic stub 241, the second parasitic stub 242, the first switch branch 281, and the third switch branch 283 are configured to generate a first resonance. A resonance frequency band of the first resonance includes a satellite communication frequency band.

The first radiator 231, the first parasitic stub 241, the second parasitic stub 242, the second switch branch 282, and the fourth switch branch 284 are configured to generate a second resonance. A resonance frequency band of the second resonance includes the satellite communication frequency band.

In an embodiment, both the resonance frequency band of the first resonance and the resonance frequency band of the second resonance may include a transmit frequency band in the satellite communication frequency band, for example, one of a transmit frequency band (1980 MHz to 2010 MHz) in a Tiantong satellite system, a transmit frequency band (1610 MHz to 1626.5 MHz) in a BeiDou satellite system, and a transmit frequency band (2500 MHz to 2520 MHz) in a low-earth-orbit satellite system. In an embodiment, both the resonance frequency band of the first resonance and the resonance frequency band of the second resonance may include a receive frequency band in the satellite communication frequency band, for example, one of a receive frequency band (2170 MHz to 2200 MHz) in a Tiantong satellite system, a receive frequency band (2483.5 MHz to 2500 MHz) in a BeiDou satellite system, and a receive frequency band (2670 MHz to 2690 MHz) in a low-earth-orbit satellite system.

In an embodiment, the first radiator 231, the first parasitic stub 241, the second parasitic stub 242, the first switch branch 281, and the third switch branch 283 are configured to generate a first radiation pattern. The first radiator 231, the first parasitic stub 241, the second parasitic stub 242, the second switch branch 282, and the fourth switch branch 284 are configured to generate a second radiation pattern. The first radiation pattern is different from the second radiation pattern.

That the first radiation pattern is different from the second radiation pattern may be understood as that a maximum radiation direction of the first radiation pattern is different from a maximum radiation direction of the second radiation pattern.

It should be understood that, in embodiments of this application, the maximum radiation direction may be understood as a direction toward which a maximum gain in the radiation pattern generated by the antenna faces in an embodiment, or may be understood as a direction toward which a maximum gain in a continuous radiation area (a gain is greater than or equal to a threshold in this area) in the radiation pattern generated by the antenna faces in another embodiment, or may be understood as a direction toward which a maximum gain in a preset radiation area (for example, a top area of the electronic device) in the radiation pattern generated by the antenna faces (for example, the antenna has a plurality of maximum radiation directions, one direction is toward the top, and one direction is toward a rear cover; and assuming that the top is a main radiation area, a gain at a single angle in the direction toward the rear cover may exceed a maximum gain in the main radiation area, but for the maximum radiation direction described in embodiments of this application, only a direction toward which the maximum gain in the main radiation area in the radiation pattern faces is considered). Related descriptions in embodiments of this application may be accordingly understood. For brevity of description, details are not described again.

It should be understood that, when the first radiator 231 is disposed close to the second edge 302 (L1'≤L1×0.5), the first parasitic stub 241 and the second parasitic stub 242 are coupled to different switch branches, so that the antenna 200 has different radiation patterns in the satellite communication frequency band. The electronic device 100 may switch, based on a relative position between the communication satellite and the electronic device 100, a switch branch coupled to a parasitic stub, so that the communication satellite is always located in an area in which the antenna 200 has a good radiation characteristic (for example, the maximum radiation direction of the radiation pattern generated by the antenna at least partially overlaps a target radiation direction), to maintain a satellite-aligned state with the communication satellite, thereby effectively improving user experience.

In an embodiment, when the first switch branch 281 is coupled to the first connection point 221, and the third switch branch 283 is coupled to the second connection point 222, the first feed circuit 230 feeds an electrical signal, the first radiator 231 is configured to generate a first main resonance, the first parasitic stub 241 is configured to generate a first parasitic resonance, and the second parasitic stub 242 does not generate a parasitic resonance. The first main resonance and the first parasitic resonance jointly form the foregoing first resonance (because a frequency difference between a resonance point of the first parasitic resonance and a resonance point of the first main resonance is relatively small, in the S parameter diagram, the first main resonance and the first parasitic resonance are merged into one resonance).

It should be understood that, that the second parasitic stub 242 does not generate a parasitic resonance may be understood as that the third switch branch 283 is configured to enable the parasitic resonance generated by the second parasitic stub 242 to be outside a resonance frequency band of the first main resonance. For example, a resonance point frequency of the parasitic resonance generated by the second parasitic stub 242 and a resonance point frequency of the first main resonance are greater than or equal to 300 MHz. For brevity of description, in embodiments of this application, that no parasitic resonance is generated may be accordingly understood, and details are not described again.

In an embodiment, when the second switch branch 282 is coupled to the first connection point 221, and the fourth switch branch 284 is coupled to the second connection point 222, the first feed circuit 230 feeds an electrical signal, the first radiator 231 is configured to generate a second main resonance, the first parasitic stub 241 does not generate a parasitic resonance, and the second parasitic stub 242 is configured to generate a second parasitic resonance. The second main resonance and the second parasitic resonance jointly form the foregoing second resonance (because a frequency difference between a resonance point of the second parasitic resonance and a resonance point of the second main resonance is relatively small, in the S parameter diagram, the second main resonance and the second parasitic resonance are merged into one resonance).

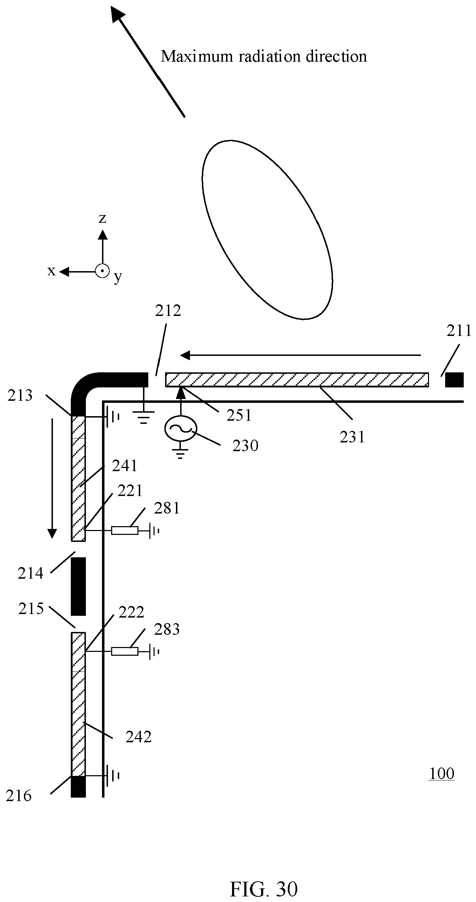

In an embodiment, for a resonance point of the first resonance, a current on the first radiator 231 and a current on the first parasitic stub 241 are in a same direction, as shown in FIG. 30.

It should be understood that, when the current on the first radiator 231 and the current on the first parasitic stub 241 are in the same direction, the first parasitic stub 241 may enable the radiation pattern generated by the antenna 200 to deflect toward a side close to the first parasitic stub 241.

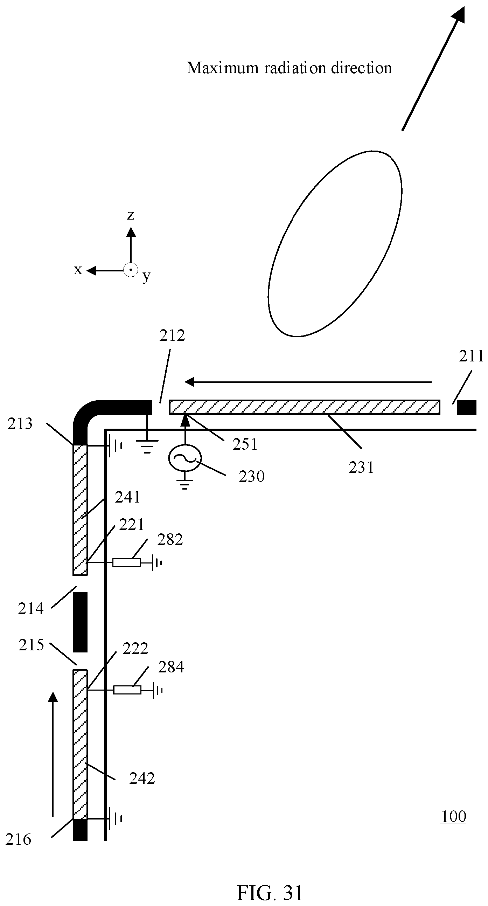

In an embodiment, for a resonance point of the second resonance, a current on the first radiator 231 and a current on the second parasitic stub 242 are in opposite directions, as shown in FIG. 31.

It should be understood that, when the current on the first radiator 231 and the current on the second parasitic stub 242 are in the opposite directions, the second parasitic stub 242 may enable the radiation pattern generated by the antenna 200 to deflect toward a side away from the second parasitic stub 242.

In an embodiment, a distance between the third position 213 and the first edge 301 is less than a distance between the fourth position 214 and the first edge 301. The grounding end of the first parasitic stub 241 is close to the first edge 301. The distance L2' between the third position 213 and the first edge 301 and a length L2 of the first parasitic stub 241 satisfy: 0≤L2'≤L2×2.5.

In an embodiment, a distance between the fifth position 215 and the first edge 301 is less than a distance between the sixth position 216 and the first edge 301. The open end of the open end of the second parasitic stub 242 is close to the first edge 301. The distance L3' between the fifth position 215 and the first edge 301 and a length L3 of the second parasitic stub 242 satisfy: L3≤L3'≤L3×5.

It should be understood that, in embodiments of this application, only an example in which the grounding end of the first parasitic stub 241 is close to the first edge 301 and the open end of the open end of the second parasitic stub 242 is close to the first edge 301 is used for description. In actual production or application, both the grounding end of the first parasitic stub 241 and the grounding end of the second parasitic stub 242 may be close to the first edge 301, or both the open end of the first parasitic stub 241 and the open end of the second parasitic stub 242 may be close to the first edge 301. In this case, refer to the foregoing embodiment in which a grounding end or an open end is close to a parasitic stub on the first edge for corresponding understanding. For brevity of description, details are not described again.

In an embodiment, a length L2 of the first parasitic stub 241 and a length L1 of the first radiator 231 satisfy: L1×0.3≤L2≤L1×0.6. In an embodiment, a length L3 of the second parasitic stub 242 and a length L1 of the first radiator 231 satisfy: L1×0.3≤L3≤L1×0.6.

It should be understood that a first end and a second end of the first radiator 231 are open ends. The first radiator 231 may operate in a half wavelength mode. A first end of the first parasitic stub 241 is a grounding end, and a second end is an open end. A first end of the second parasitic stub 242 is a grounding end, and a second end is an open end. The first parasitic stub 241 and the second parasitic stub 242 may operate in a quarter wavelength mode.

In an embodiment, a length L2 of the first parasitic stub 241 and a length L3 of the second parasitic stub 242 satisfy: L2×0.9≤L3≤L2×1.1.

It should be understood that, when the length L2 of the first parasitic stub 241 is approximately the same as the length L3 of the second parasitic stub 242, the antenna 200 has better symmetry, and a radiation characteristic of the antenna 200 is better.

In an embodiment, the first switch branch 281, the second switch branch 282, the third switch branch 283, and the fourth switch branch 284 may be capacitors or elements equivalent to capacitors.

In an embodiment, when the length L2 of the first parasitic stub 241 is approximately the same as the length L3 of the second parasitic stub 242 (L2×0.9≤L3≤L2×1.1), an equivalent capacitance of the first switch branch 281 is greater than an equivalent capacitance of the fourth switch branch 284.

It should be understood that when the first switch branch 281 is coupled to the first connection point 221, a resonance point of the first parasitic resonance generated by the first parasitic stub 241 is higher than the resonance point of the first resonance, so that a current on the first radiator 231 and a current on the first parasitic stub 241 are in a same direction. In an embodiment, a frequency difference between a resonance point frequency of the first parasitic resonance and a resonance point frequency of the first resonance is less than or equal to 100 MHz. Because excitation of the first parasitic resonance is relatively weak, for the frequency difference between the resonance point frequency of the first parasitic resonance and the resonance point frequency of the first resonance, refer to a dip of radiation efficiency in the foregoing embodiment for corresponding understanding.

When the fourth switch branch 284 is coupled to the second connection point 222, a resonance point of the second parasitic resonance generated by the second parasitic stub 242 is lower than the resonance point of the second resonance, to excite the ground 300 to generate a standing wave, so that a current on the first radiator 231 and a current on the second parasitic stub 242 are in opposite directions. In an embodiment, a frequency difference between a resonance point frequency of the second parasitic resonance and a resonance point frequency of the second resonance is less than or equal to 200 MHz. Because excitation of the second parasitic resonance is relatively weak, for the frequency difference between the resonance point frequency of the second parasitic resonance and the resonance point frequency of the second resonance, refer to a dip of radiation efficiency in the foregoing embodiment for corresponding understanding.

Correspondingly, to implement the foregoing technical effect, when the length L2 of the first parasitic stub 241 is approximately the same as the length L3 of the second parasitic stub 242, an equivalent capacitance of the first switch branch 281 is greater than an equivalent capacitance of the fourth switch branch 284.

In an embodiment, a length of the first parasitic stub 241 between the first connection point 221 and the fourth position 214 is less than or equal to one third of the length of the first parasitic stub 241. In an embodiment, the length of the first parasitic stub 241 between the first connection point 221 and the fourth position 214 is less than or equal to 5 mm.

In an embodiment, a length of the second parasitic stub 242 between the second connection point 222 and the fifth position 215 is less than or equal to one third of the length of the second parasitic stub 242. In an embodiment, the length of the second parasitic stub 242 between the second connection point 222 and the fifth position 215 is less than or equal to 5 mm.

It should be understood that an open end of a radiator (a parasitic stub) has a relatively strong electric field. When a connection point is located in an area near the open end, a radiation characteristic of the antenna 200 has a larger adjustment range.

In an embodiment, the antenna 200 further includes a first electronic element. The first parasitic stub 241 includes a third connection point and a fourth connection point, and the first parasitic stub 241 has a fifth insulation gap between the third connection point and the fourth connection point. The first electronic element is coupled between the third connection point and the fourth connection point.

In an embodiment, the antenna 200 further includes a second electronic element. The second parasitic stub 242 includes a fifth connection point and a sixth connection point, and the second parasitic stub 242 has a sixth insulation gap between the fifth connection point and the sixth connection point. The second electronic element is coupled between the fifth connection point and the sixth connection point.

It should be understood that the first parasitic stub 241 and/or the second parasitic stub 242 may form a metamaterial structure, to extend a radiation aperture of the antenna 200, so that the antenna 200 has a better radiation characteristic. Similarly, the metamaterial structure is similar to the metamaterial structure in the foregoing embodiment. For brevity of description, details are not described again.

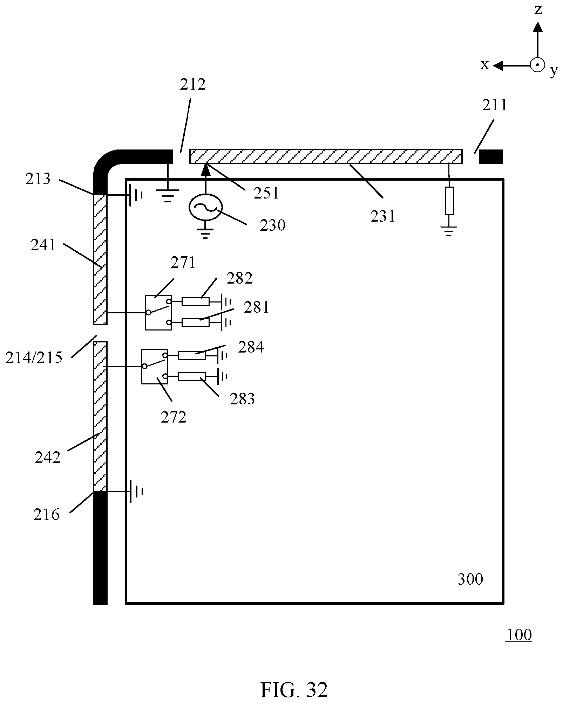

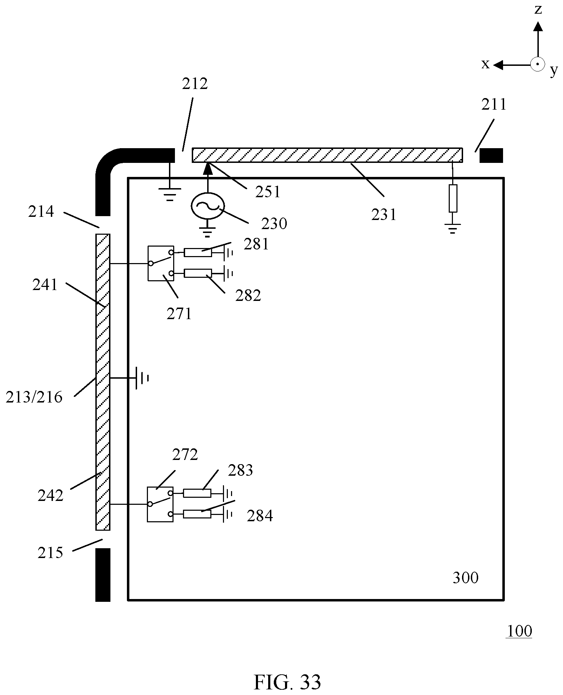

In an embodiment, an electronic element is coupled between the first radiator 231 and the ground 300, as shown in FIG. 32 and FIG. 33.

It should be understood that a connection manner of the electronic element is similar to the connection manner of the first electronic element 261 in the electronic device 100 shown in FIG. 9 to FIG. 28. For brevity of description, details are not described again.

In an embodiment, the third position 213, the fourth position 214, the fifth position 215, and the sixth position 216 are sequentially arranged on the second edge 302. In an embodiment, the open end of the first parasitic stub 241 and the open end of the second parasitic stub 242 are close to each other.

In an embodiment, the fourth position 214 coincides with the fifth position 215, as shown in FIG. 32. The third insulation gap coincides with the fourth insulation gap. One end of the first parasitic stub 241 and one end of the second parasitic stub 242 are opposite to each other and are not in contact with each other. The first parasitic stub 241 and the second parasitic stub 242 may jointly form a structure similar to a slot antenna.

In an embodiment, the fourth position 214, the third position 213, the sixth position 216, and the fifth position 215 are sequentially arranged on the second edge 302, as shown in FIG. 33. In an embodiment, the grounding end of the first parasitic stub 241 and the grounding end of the second parasitic stub 242 are close to each other.

In an embodiment, the third position 213 coincides with the sixth position 215, as shown in FIG. 33. The first parasitic stub 241 and the second parasitic stub 242 may jointly form a structure similar to a T antenna.

It should be understood that, in embodiments of this application, only an example in which the grounding end of the first parasitic stub 241 and the grounding end of the second parasitic stub 242 are close to each other, or the open end of the first parasitic stub 241 and the open end of the second parasitic stub 242 are close to each other is used for description. In actual production or design, the open end of the first parasitic stub 241 may alternatively be close to the grounding end of the second parasitic stub 242. This is not limited in embodiments of this application.

In addition, in embodiments of this application, only an example in which the first parasitic stub 241 is closer to the first edge 301 than the second parasitic stub 242 is used for description. In actual production or design, the first parasitic stub 241 may alternatively be farther away from the first edge 301 than the second parasitic stub 242. This is not limited in embodiments of this application.

It should be understood that, in the foregoing embodiments (the electronic device 100 shown in FIG. 29 to FIG. 33), when the first radiator 231 generates a resonance, one of the first parasitic stub 241 and the second parasitic stub 242 generates a parasitic resonance, and the electronic device 100 switches the parasitic stub that generates the parasitic resonance, so that the antenna 200 generates different radiation patterns. In actual production or design, when the first radiator 231 generates a resonance, the first parasitic stub 241 and the second parasitic stub 242 may jointly generate parasitic resonances. Directions of currents on the first parasitic stub 241 and the second parasitic stub 242 are switched, so that the antenna 200 generates different radiation patterns.

In an embodiment, when the first switch branch 281 is coupled to the first connection point 221, and the third switch branch 283 is coupled to the second connection point 222, the first feed circuit 230 feeds an electrical signal, the first radiator 231 is configured to generate a first main resonance, and the first parasitic stub 241 and the second parasitic stub 242 jointly generate a first parasitic resonance. The first main resonance and the first parasitic resonance jointly form the foregoing first resonance.

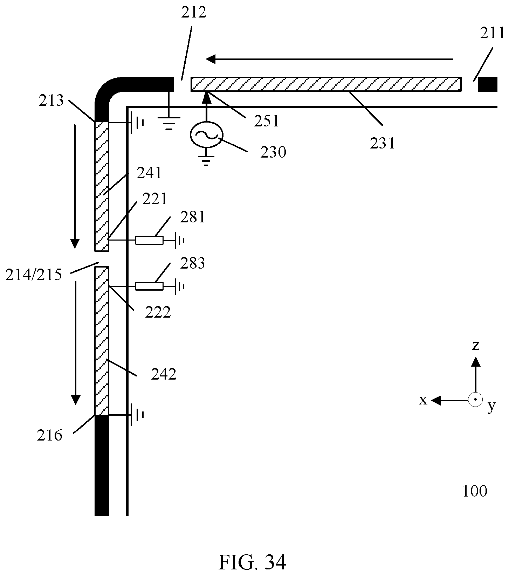

In an embodiment, for a resonance point of the first resonance, a current on the first radiator 231 is in a same direction as a current on the first parasitic stub 241 and a current on the second parasitic stub 242, as shown in FIG. 34.

It should be understood that, when the current on the first radiator 231 is in the same direction as the current on the first parasitic stub 241 and the current on the second parasitic stub 242, the first parasitic stub 241 and the second parasitic stub 242 may enable the radiation pattern generated by the antenna 200 to deflect toward a side close to the first parasitic stub 241 (the second parasitic stub 242).

In an embodiment, when the second switch branch 282 is coupled to the first connection point 221, and the fourth switch branch 284 is coupled to the second connection point 222, the first feed circuit 230 feeds an electrical signal, the first radiator 231 is configured to generate a second main resonance, and the first parasitic stub 241 and the second parasitic stub 242 jointly generate a second parasitic resonance. The second main resonance and the second parasitic resonance jointly form the foregoing second resonance.

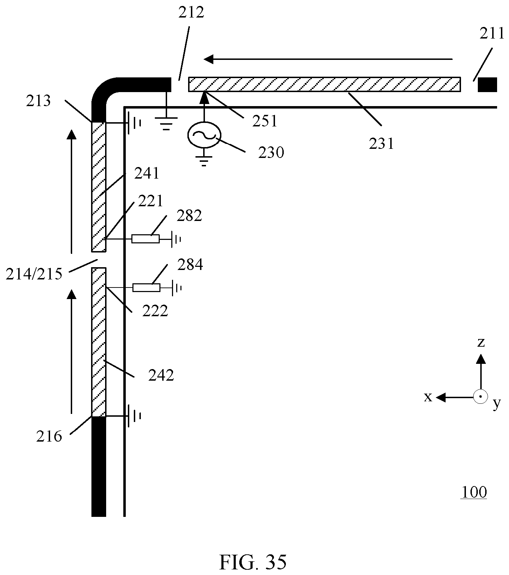

In an embodiment, for a resonance point of the second resonance, a current on the first radiator 231 is in an opposite direction to a current on the first parasitic stub 241 and a current on the second parasitic stub 242, as shown in FIG. 35.

It should be understood that, when the current on the first radiator 231 is in the opposite direction to the current on the first parasitic stub 241 and the current on the second parasitic stub 242, the first parasitic stub 241 and the second parasitic stub 242 may enable the radiation pattern generated by the antenna 200 to deflect toward a side away from the first parasitic stub 241 (the second parasitic stub 242).

It should be understood that, for brevity of description, in the electronic device 100 shown in FIG. 34 and FIG. 35, only an example in which the fourth position 214 coincides with the fifth position 215 is used for description. In actual production or design, another conductor part may be further disposed between the first parasitic stub 241 and the second parasitic stub 242, and details are not described again.

In addition, in the electronic device 100 shown in FIG. 34 and FIG. 35, only an example in which the antenna 200 includes the first parasitic stub 241 and the second parasitic stub 242 is used for description. In actual production or design, the antenna 200 may include a plurality of parasitic stubs, for example, further include a third parasitic stub, and the first parasitic stub 241, the second parasitic stub 242, and the third parasitic stub jointly generate a parasitic resonance. For brevity of description, details are not described again.

The foregoing descriptions are merely specific implementations of this application. However, the protection scope of this application is not limited thereto. Any change or replacement readily figured out by a person skilled in the art within the technical scope disclosed in this application shall fall within the protection scope of this application. Therefore, the protection scope of this application shall be subject to the protection scope of the claims.

**Claims**

1. A foldable electronic device, comprising:

    a first housing and a ground, wherein
    the first housing comprises a first side frame, the first side frame comprises a first edge and a second edge that intersect at a corner, the first side frame comprises a first position, a second position, a third position, and a fourth position that are sequentially provided, the first position and the second position are located on the first edge, the third position and the fourth position are located on the second edge, the first side frame respectively has a first insulation gap, a second insulation gap, and a third insulation gap at the first position, the second position, and the fourth position, and the first side frame is coupled to the ground at the third position;
    a second housing and a first hinge, wherein the first hinge is located between the first housing and the second housing, and the first hinge is rotatably connected to the first housing and the second housing; and
    a first antenna, wherein the first antenna comprises:

        a first radiator and a first parasitic stub, wherein the first radiator is a conductive part of the first side frame between the first position and the second position, the first parasitic stub is a conductive part of the first side frame between the third position and the fourth position, at least a part of the first radiator is spaced from the ground, and at least a part of the first parasitic stub is spaced from the ground; and
a first feed circuit and a first electronic element, wherein the first radiator comprises a first feed point and a first connection point, the first feed circuit is coupled to the first feed point, the first electronic element is coupled between the ground and the first connection point, the first feed point and the first connection point are respectively located on two sides of a virtual axis of the first radiator, and first radiator has a same length on the two sides of the virtual axis, wherein
the first radiator is configured to generate a first resonance based on the foldable electronic device being in an unfolded state, a resonance frequency band of the first resonance comprises a satellite communication frequency band, and the first radiator, the first parasitic stub, and the first electronic element are configured to generate a radiation pattern of the antenna.

2. The foldable electronic device according to claim 1, wherein
when the foldable electronic device is in the unfolded state, and the first antenna operates in the satellite communication frequency band, a current on the ground on a first side of the virtual axis is greater than a current on the ground on a second side of the virtual axis, wherein the first parasitic stub is located on the first side, and the first hinge is located on the second side.

3. The foldable electronic device according to claim 1 or 2, wherein a beam width of the first antenna is related to the first parasitic stub based on the foldable electronic device being in the unfolded state.

4. The foldable electronic device according to any one of claims 1 to 3, wherein

    the first electronic element has an open-circuit characteristic based on the first feed point being located on the first side of the virtual axis and the first connection point being located on the second side of the virtual axis;
    an equivalent inductance of the first electronic element is greater than or equal to 20 nH based on a resonance point frequency of the first resonance being greater than or equal to 3 GHz;
    an equivalent inductance of the first electronic element is greater than or equal to 10 nH based on a resonance point frequency of the first resonance being greater than or equal to 2 GHz and less than 3 GHz; or

an equivalent inductance of the first electronic element is greater than or equal to 5 nH based on a resonance point frequency of the first resonance being greater than or equal to 1 GHz and less than 2 GHz.

5. The foldable electronic device according to any one of claims 1 to 3, wherein

the first electronic element has a short-circuit characteristic based on the first connection point being located on the first side of the virtual axis and the first feed point being located on the second side of the virtual axis;
an equivalent capacitance of the first electronic element is greater than or equal to 0.5 pF based on a resonance point frequency of the first resonance being greater than or equal to 3 GHz;
an equivalent capacitance of the first electronic element is greater than or equal to 2 pF based on a resonance point frequency of the first resonance being greater than or equal to 2 GHz and less than 3 GHz; or
an equivalent capacitance of the first electronic element is greater than or equal to 3 pF based on a resonance point frequency of the first resonance being greater than or equal to 1 GHz and less than 2 GHz.

6. The foldable electronic device according to any one of claims 1 to 5, wherein

a distance between the first feed point and the first position or the second position is less than or equal to one third of a length of the first radiator; and/or
a distance between the first connection point and the first position or the second position is less than or equal to one third of the length of the first radiator.

7. The foldable electronic device according to any one of claims 1 to 6, wherein
the first radiator is configured to generate a main resonance, and the first parasitic stub is configured to generate a first parasitic resonance, wherein the first parasitic resonance is in a resonance frequency band of the main resonance, and the main resonance and the first parasitic resonance jointly form the first resonance.

8. The foldable electronic device according to any one of claims 1 to 7, wherein
the antenna generates an efficiency dip at a first frequency point, wherein a frequency difference between the resonance point frequency of the first resonance and a frequency of the first frequency point is less than or equal to 50 MHz.

9. The foldable electronic device according to any one of claims 1 to 8, wherein
a gain, of a radiation pattern generated by the first antenna, in a range in which an angle formed with a first direction is within 60° is greater than or equal to -6 dBic based on the foldable electronic device performing satellite communication through the first antenna, and the first direction is a direction pointing from the bottom of the foldable electronic device to the top of the foldable electronic device.

10. The foldable electronic device according to any one of claims 1 to 9, wherein
the first antenna further comprises a second parasitic stub, the second parasitic stub is a conductive part of the first side frame between the second position and the third position, and at least a part of the second parasitic stub is spaced from the ground.

11. The foldable electronic device according to claim 10, wherein

a first end of the second parasitic stub and a first end of the first radiator are opposite to each other through the second insulation gap and are not in contact with each other; and
the first antenna further comprises a second electronic element, the first end of the second parasitic stub comprises a second connection point, and the second electronic element is coupled between the ground and the second connection point.

12. The foldable electronic device according to any one of claims 1 to 11, wherein

the first side frame further comprises a fifth position, the first position is located between the fifth position and the second position, and the first side frame is coupled to the ground at the fifth position; and
the first antenna further comprises a third parasitic stub, the third parasitic stub is a conductive part of the first side frame between the first position and the fifth position, and at least a part of the third parasitic stub is spaced from the ground.

13. The foldable electronic device according to any one of claims 1 to 12, wherein

the second housing comprises a second side frame, a third edge of the second side frame comprises a sixth position and a seventh position, the second side frame is coupled to the ground at the sixth position, and the second side frame is provided with a fourth insulation gap at the seventh position;

the first antenna further comprises a fourth parasitic stub, the fourth parasitic stub is a conductive part of the second side frame between the sixth position and the seventh position, and at least a part of the fourth parasitic stub is spaced from the ground; and

the first edge and the third edge are a top edge or a bottom edge of the foldable electronic device based on the foldable electronic device being in the unfolded state.

14. The foldable electronic device according to claim 13, wherein

the first antenna further comprises a third electronic element; and

the fourth parasitic stub comprises a third connection point and a fourth connection point, the fourth parasitic stub is provided with a fifth insulation gap between the third connection point and the fourth connection point, and the third electronic element is coupled between the third connection point and the fourth connection point.

15. The foldable electronic device according to claim 14, wherein

a distance between the third connection point and the fifth insulation gap is less than or equal to 5 mm; and/or

a distance between the fourth connection point and the fifth insulation gap is less than or equal to 5 mm.

16. The foldable electronic device according to any one of claims 13 to 15, wherein the sixth position is located between the first position and the seventh position based on the foldable electronic device being in the unfolded state.

17. The electronic device according to any one of claims 1 to 12, wherein

the second housing comprises a second side frame, a third edge of the second side frame comprises a sixth position and a seventh position, and the second side frame is provided with a fourth insulation gap and a fifth insulation gap at the sixth position and the seventh position;

the first antenna further comprises a fourth parasitic stub, the fourth parasitic stub is a conductive part of the second side frame between the sixth position and the seventh position, and at least a part of the fourth parasitic stub is spaced from the ground; and

the first edge and the third edge are a top edge or a bottom edge of the foldable electronic device based on the foldable electronic device being in the unfolded state.

18. The foldable electronic device according to any one of claims 1 to 12, wherein

the second housing comprises a second side frame, the second side frame comprises a third edge and a fourth edge that intersect at a corner, the second side frame comprises a sixth position, a seventh position, an eighth position, and a ninth position that are sequentially provided, the sixth position and the seventh position are located on the third edge, the eighth position and the ninth position are located on the fourth edge, the second side frame respectively has a fourth insulation gap, a fifth insulation gap, and a sixth insulation gap at the sixth position, the seventh position, and the ninth position, and the second side frame is coupled to the ground at the eighth position; and

the foldable electronic device further comprises a second antenna, and the second antenna comprises:

a second radiator and a fifth parasitic stub, wherein the second radiator is a conductive part of the second side frame between the sixth position and the seventh position, the fifth parasitic stub is a conductive part of the second side frame between the eighth position and the ninth position, at least a part of the second radiator is spaced from the ground, and at least a part of the fifth parasitic stub is spaced from the ground; and

a second feed circuit and a fourth electronic element, wherein the second radiator comprises a second feed point and a fifth connection point, the second feed circuit is coupled to the second feed point, and the fourth electronic element is coupled between the ground and the fifth connection point, wherein the first edge and the third edge are a top edge or a bottom edge of the foldable electronic device based on the foldable electronic device being in the unfolded state; and the second radiator and the fourth parasitic stub are configured to generate a second resonance based on the foldable electronic device being in the unfolded state, and a resonance frequency band of the second resonance comprises the satellite communication frequency band.

**19.** The foldable electronic device according to claim 18, wherein
based on the foldable electronic device being in a folded state, the first radiator and the second radiator at least partially overlap in a second direction, and/or the first parasitic stub and the fifth parasitic stub at least partially overlap in the second direction, wherein the second direction is a thickness direction of the foldable electronic device.

**20.** The foldable electronic device according to claim 18 or 19, wherein
based on the foldable electronic device being in the folded state, the first insulation gap is aligned with the fourth insulation gap, and/or the second insulation gap is aligned with the fifth gap, and/or the third insulation gap is aligned with the sixth insulation gap.

**21.** The foldable electronic device according to any one of claims 1 to 20, wherein
a ratio of a dimension of the ground in an extension direction of the first edge when the foldable electronic device is in the unfolded state to a dimension of the ground in the extension direction of the first edge when the foldable electronic device is in the folded state is greater than or equal to 1.8 and less than or equal to 2.2.

**22.** The foldable electronic device according to any one of claims 1 to 21, wherein
the foldable electronic device performs at least one of the following services in the satellite communication frequency band: receiving and/or sending an SMS message through a satellite, making and/or answering a call through a satellite, or satellite data.

**23.** An electronic device, comprising:

a ground;
a side frame, wherein the side frame comprises a first edge and a second edge that intersect at a corner;
the first edge comprises a first position and a second position, and the side frame respectively has a first insulation gap and a second insulation gap at the first position and the second position; and
the second edge comprises a third position and a fourth position, the side frame is coupled to the ground at the third position, and the side frame has a third insulation gap at the fourth position; and
an antenna, wherein the antenna comprises:

a radiator and a first parasitic stub, wherein the radiator is a conductive part of the side frame between the first position and the second position, the first parasitic stub is a conductive part of the side frame between the third position and the fourth position, at least a part of the radiator is spaced from the ground, and at least a part of the first parasitic stub is spaced from the ground; and
a feed circuit, wherein the radiator comprises a feed point, and the feed circuit is coupled to the feed point, wherein
a length L0 of the first edge and a length L1 of the radiator satisfy: $2 \times L1 \leq L0$;
a distance L1' between the second position and the second edge and the length L1 of the radiator satisfy: $L1' \leq L1 \times 0.5$; and
the radiator is configured to generate a first resonance, a resonance frequency band of the first resonance comprises a satellite communication frequency band, and the radiator and the first parasitic stub are configured to generate a radiation pattern of the antenna.

**24.** The electronic device according to claim 23, wherein the electronic device further comprises:

an electronic element, wherein the radiator comprises a first connection point, the electronic element is coupled between the ground and the first connection point, the feed point and the first connection point are respectively located on two sides of a virtual axis of the radiator, and the radiator has a same length on the two sides of the virtual axis, wherein
the radiator, the first parasitic stub, and the electronic element are configured to generate the radiation pattern of the antenna.

**25.** The electronic device according to claim 23 or 24, wherein

the second edge further comprises a fifth position and a sixth position, the side frame has a fourth insulation gap at the fifth position, and the side frame is coupled to the ground at the sixth position; and
the antenna further comprises:

a second parasitic stub, wherein the second parasitic stub is a conductive part of the side frame between the fifth position and the sixth position, and at least a part of the second parasitic stub is spaced from the ground, wherein
the radiator, the first parasitic stub, and the second parasitic stub are configured to generate the radiation pattern of the antenna.

**26.** The electronic device according to claim 25, wherein the antenna further comprises:

a first switch, a first switch branch, and a second switch branch, wherein the first parasitic stub comprises a second connection point, and the first switch branch and the second switch branch are coupled between the ground and the second connection point through the first switch; and

a second switch, a third switch branch, and a fourth switch branch, wherein the second parasitic stub comprises a third connection point, and the third switch branch and the fourth switch branch are coupled between the ground and the third connection point through the second switch, wherein

the radiator, the first parasitic stub, the second parasitic stub, the first switch branch, and the third switch branch are configured to generate the first resonance, and the resonance frequency band of the first resonance comprises the satellite communication frequency band; and

the radiator, the first parasitic stub, the second parasitic stub, the second switch branch, and the fourth switch branch are configured to generate a second resonance, and a resonance frequency band of the second resonance comprises the satellite communication frequency band.

27. The electronic device according to claim 26, wherein

the radiator, the first parasitic stub, the second parasitic stub, the first switch branch, and the third switch branch are configured to generate a first radiation pattern; and

the radiator, the first parasitic stub, the second parasitic stub, the second switch branch, and the fourth switch branch are configured to generate a second radiation pattern, and the first radiation pattern is different from the second radiation pattern.

28. The electronic device according to any one of claims 25 to 27, wherein

a distance between the third position and the first edge is less than a distance between the fourth position and the first edge, and the distance $L2'$ between the third position and the first edge and a length L2 of the first parasitic stub satisfy: $0 \leq L2' \leq L2 \times 2.5$; and/or

a distance between the fifth position and the first edge is less than a distance between the sixth position and the first edge, and the distance $L3'$ between the fifth position and the first edge and a length L3 of the second parasitic stub satisfy: $L3 \leq L3' \leq L3 \times 5$.

29. The electronic device according to any one of claims 25 to 28, wherein
the length L2 of the first parasitic stub and the length L3 of the second parasitic stub satisfy: $L2 \times 0.9 \leq L3 \leq L2 \times 1.1$.

30. The electronic device according to any one of claims 25 to 29, wherein

the length L2 of the first parasitic stub and the length L1 of the radiator satisfy: $L1 \times 0.3 \leq L2 \leq L1 \times 0.6$; and/or

the length L3 of the second parasitic stub and the length L1 of the radiator satisfy: $L1 \times 0.3 \leq L3 \leq L1 \times 0.6$.

31. The electronic device according to any one of claims 25 to 30, wherein

the antenna further comprises a first electronic element and/or a second electronic element; and

the first parasitic stub comprises a fourth connection point and a fifth connection point, the first parasitic stub has a fifth insulation gap between the fourth connection point and the fifth connection point, and the first electronic element is coupled between the fourth connection point and the fifth connection point; and/or

the second parasitic stub comprises a sixth connection point and a seventh connection point, the second parasitic stub has a sixth insulation gap between the sixth connection point and the seventh connection point, and the second electronic element is coupled between the sixth connection point and the seventh connection point.

32. The electronic device according to any one of claims 25 to 31, wherein
the third position, the fourth position, the fifth position, and the sixth position are sequentially arranged on the second edge.

33. The electronic device according to claim 32, wherein
the fourth position coincides with the fifth position.

34. The electronic device according to any one of claims 25 to 31, wherein
the fourth position, the third position, the sixth position, and the fifth position are sequentially arranged on the second edge.

35. The electronic device according to claim 34, wherein
the third position coincides with the sixth position.

36. The electronic device according to any one of claims 26 to 35, wherein

at a resonance point of the first resonance, a current on the radiator and a current on the first parasitic stub are in a same direction; and/or at a resonance point of the second resonance, a current on the radiator and a current on the second parasitic stub are in opposite directions.

FIG. 1

100

111

122/124

123

112

125

121

FIG. 2

100

110

126    125    127    129    128

FIG. 3

100

110

128

125    127    126    129

FIG. 4

FIG. 5

41  40

42

PCB

(a)

Electric field node
(current strong point)

41  40

42

PCB

← Current   ← – Electric field

(b)

FIG. 6

(a)

(b)

FIG. 7

FIG. 8

FIG. 9

(a)

(b)

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

**FIG. 29**

FIG. 30

Maximum radiation direction

z

x · y

212

211

213

251

230

231

241

221

282

214

215

222

284

242

216

100

FIG. 31

FIG. 32

FIG. 33

FIG. 34

FIG. 35

## INTERNATIONAL SEARCH REPORT

| | International application No. |
|---|---|
| | **PCT/CN2024/140186** |

**A.     CLASSIFICATION OF SUBJECT MATTER**

H01Q1/24(2006.01)i

According to International Patent Classification (IPC) or to both national classification and IPC

**B.     FIELDS SEARCHED**

Minimum documentation searched (classification system followed by classification symbols)

IPC:H01Q

Documentation searched other than minimum documentation to the extent that such documents are included in the fields searched

Electronic data base consulted during the international search (name of data base and, where practicable, search terms used)

CNTXT: WPABS; WPABSC; ENTXT; ENTXTC; DWPI; VEN; CJFD; CNKI; IEEE: 折叠, 天线, 边框, 寄生, 缝隙, 馈电, 谐振, 卫星; fold, antenna, frame, parasite, slot, feed, resonance, satellite

**C.     DOCUMENTS CONSIDERED TO BE RELEVANT**

| Category* | Citation of document, with indication, where appropriate, of the relevant passages | Relevant to claim No. |
|---|---|---|
| Y | CN 113748663 A (SAMSUNG ELECTRONICS CO., LTD.) 03 December 2021 (2021-12-03) description, paragraphs 75-213, and figures 1-8 | 1-36 |
| Y | US 2023275345 A1 (HUAWEI TECHNOLOGIES CO., LTD.) 31 August 2023 (2023-08-31) description, paragraphs 49-73, and figures 1-9 | 1-36 |
| A | CN 215911582 U (HUAWEI TECHNOLOGIES CO., LTD.) 25 February 2022 (2022-02-25) entire document | 1-36 |
| A | US 2023006345 A1 (GUANGDONG OPPO MOBILE TELECOMMUNICATIONS CORP., LTD.) 05 January 2023 (2023-01-05) entire document | 1-36 |
| A | WO 2023071817 A1 (GUANGDONG OPPO MOBILE TELECOMMUNICATIONS CORP., LTD.) 04 May 2023 (2023-05-04) entire document | 1-36 |
| A | WO 2023246690 A1 (HUAWEI TECHNOLOGIES CO., LTD.) 28 December 2023 (2023-12-28) entire document | 1-36 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **13 March 2025** | **17 March 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

| INTERNATIONAL SEARCH REPORT Information on patent family members | | | | International application No. PCT/CN2024/140186 | | | |
|---|---|---|---|---|---|---|---|

| Patent document cited in search report | | | Publication date (day/month/year) | Patent family member(s) | | | Publication date (day/month/year) |
|---|---|---|---|---|---|---|---|
| CN | 113748663 | A | 03 December 2021 | US | 2022115768 | A1 | 14 April 2022 |
| | | | | US | 11962068 | B2 | 16 April 2024 |
| | | | | EP | 3926935 | A1 | 22 December 2021 |
| | | | | EP | 3926935 | A4 | 06 April 2022 |
| | | | | US | 2024222850 | A1 | 04 July 2024 |
| | | | | KR | 20200100986 | A | 27 August 2020 |
| | | | | KR | 102618860 | B1 | 28 December 2023 |
| | | | | WO | 2020171580 | A1 | 27 August 2020 |
| US | 2023275345 | A1 | 31 August 2023 | EP | 4148905 | A1 | 15 March 2023 |
| | | | | EP | 4148905 | A4 | 25 October 2023 |
| | | | | WO | 2021244282 | A1 | 09 December 2021 |
| CN | 215911582 | U | 25 February 2022 | None | | | |
| US | 2023006345 | A1 | 05 January 2023 | WO | 2021179825 | A1 | 16 September 2021 |
| | | | | EP | 4106102 | A1 | 21 December 2022 |
| | | | | EP | 4106102 | A4 | 13 September 2023 |
| WO | 2023071817 | A1 | 04 May 2023 | None | | | |
| WO | 2023246690 | A1 | 28 December 2023 | None | | | |

Form PCT/ISA/210 (patent family annex) (July 2022)

**REFERENCES CITED IN THE DESCRIPTION**

**Patent documents cited in the description**

- CN 202311868099

- CN 202411648910